# EUROPEAN PATENT SPECIFICATION

(11) **EP 3 907 772 B1**
(45) Date of publication and mention of the grant of the patent: **11.11.2026**
(21) Application number: 21157322.5
(22) Date of filing: 16.02.2021
(51) Int. Cl.: H10K 50/13, H10K 85/30, H10K 85/60

(54) **ORGANIC LIGHT-EMITTING DEVICE AND ELECTRONIC APPARATUS INCLUDING SAME**
ORGANISCHE LICHTEMITTIERENDE VORRICHTUNG UND ELEKTRONISCHE VORRICHTUNG DAMIT
DISPOSITIF ÉLECTROLUMINESCENT ORGANIQUE ET APPAREIL ÉLECTRONIQUE LE COMPRENANT

(30) Priority: 07.05.2020 KR 20200054777
(43) Date of publication of application: 10.11.2021
(73) Proprietor: Samsung Display Co., Ltd., Yongin-si, Gyeonggi-do 17113 (KR)
(72) Inventor: KO, Heejoo, Yongin-si, Gyeonggi-do 17113 (KR); SONG, Eunhye, Yongin-si, Gyeonggi-do 17113 (KR)
(74) Representative: Marks & Clerk LLP

(56) References cited:
- US-A1- 2015 295 184
- US-A1- 2017 338 432
- US-B1- 10 199 583

## Description

### BACKGROUND

### 1. Field

One or more embodiments of the present disclosure relate to an organic light-emitting device and an electronic apparatus including the organic light-emitting device.

### 2. Description of Related Art

Organic light-emitting devices (OLEDs) are self-emissive devices that, as compared with other devices of the related art, have wide viewing angles, high contrast ratios, short response times, and excellent characteristics in terms of brightness, driving voltage, and response speed, and produce full-color images.

OLEDs may include a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit (e.g., transition or relax) from an excited state to a ground state to thereby generate light.

US 2015/295184 A1 relates to an organic electroluminescent device having at least two emitting layers, where the emitting layers each comprise a phosphorescent dopant.

US 2017/338432 A1 relates to novel OLED device structures.

### SUMMARY

One or more embodiments relate to an organic light-emitting device having high color purity, high efficiency, and long lifespan and an electronic apparatus including the organic light-emitting device.

Additional aspects of embodiments will be set forth in part in the description which follows and, in part, will be apparent from the description, or may be learned by practice of the presented embodiments of the disclosure.

The organic light-emitting device according to the invention is defined in claim 1 and includes:
a first electrode,
a second electrode facing the first electrode, and
an organic layer between the first electrode and the second electrode and including an emission layer,
wherein the emission layer includes a host and a dopant,
the host includes a first compound and a second compound different from the first compound,
the dopant includes a third compound and a fourth compound different from the third compound, and
the third compound is a platinum-containing organometallic compound.

According to one or more embodiments, an electronic apparatus includes a thin-film transistor including a source electrode, a drain electrode, and an active layer; and the organic light-emitting device, wherein the first electrode of the organic light-emitting device is electrically coupled to any one selected from the source electrode and the drain electrode of the thin-film transistor.

At least some of the above and other features of the invention are set out in the claims.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic cross-sectional view of an embodiment of an organic light-emitting device;
FIG. 2 is a schematic cross-sectional view of an embodiment of an organic light-emitting device;
FIG. 3 is a schematic cross-sectional view of an embodiment of an organic light-emitting device; and
FIG. 4 is a schematic cross-sectional view of an embodiment of an organic light-emitting device.

### DETAILED DESCRIPTION

Reference will now be made in more detail to embodiments of the present disclosure, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present disclosure allows for various changes and numerous embodiments, particular embodiments will be illustrated in the drawings and described in more detail in the written description. Effects, features, and a method of providing the subject matter of the present disclosure will be readily apparent to those of ordinary skill in the art by referring to example embodiments of the present disclosure with reference to the attached drawings. The subject matter of the present disclosure may, however, be embodied in many different forms and should not be construed as being limited to the embodiments set forth herein.

Hereinafter, the subject matter of the present disclosure will be described in more detail by explaining example embodiments of the present disclosure with reference to the attached drawings. Like reference numerals in the drawings denote like elements, and thus, duplicative description thereof will not be repeated.

In the embodiments described in the present specification, an expression used in the singular encompasses the expression of the plural, unless it has a clearly different meaning in the context.

In the present specification, it is to be understood that the terms such as "including," "having," and "comprising" are intended to indicate the existence of the features or components disclosed in the specification, and are not intended to preclude the possibility that one or more other features or components may exist or may be added.

It will be understood that when a layer, region, or component is referred to as being "on" or "onto" another layer, region, or component, it may be directly or indirectly formed over the other layer, region, or component. That is, for example, intervening layers, regions, or components may be present.

Sizes of components in the drawings may be exaggerated for convenience of explanation. In other words, because sizes and thicknesses of components in the drawings may be arbitrarily illustrated for convenience of explanation, the following embodiments are not limited thereto.

The term "organic layer," as used herein, refers to a single and/or a plurality of layers between an anode and a cathode in an organic light-emitting device. A material included in the "organic layer" is not limited to an organic material. For example, the organic layer may include an inorganic material.

As used herein, the expression the "(organic layer) includes a compound represented by Formula N' (wherein N indicates an arbitrary integer) may be construed as meaning the "(organic layer) may include one compound that is represented by Formula *N* or two different compounds that are represented by Formula N."

The subject matter of the present disclosure will now be described more fully with reference to the accompanying drawings, in which embodiments of the present disclosure are shown.

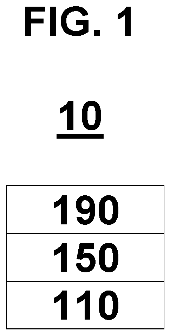

### Description of FIG. 1

FIG. 1 is a schematic view of an organic light-emitting device 10 according to an embodiment. An organic light-emitting device 10 includes a first electrode 110; a second electrode 190 facing the first electrode 110; and an organic layer 150 between the first electrode 110 and the second electrode 190 and including an emission layer 150.

The emission layer includes a host and a dopant, the host includes a first compound and a second compound different from the first compound, the dopant includes a third compound and a fourth compound different from the third compound, and the third compound is a platinum-containing organometallic compound.

As the organic light-emitting device 10 includes two different types of hosts as co-hosts in the emission layer thereof, balance between holes and electrons in the emission layer may be improved. In addition, the third compound may improve the color purity of light emitted from the organic light-emitting device 10 and luminescence efficiency of the organic light-emitting device 10, and the fourth compound may improve lifespan of the organic light-emitting device 10. Accordingly, as the organic light-emitting device 10 includes the third compound and the fourth compound as co-dopants, the color purity, efficiency, and lifespan characteristics may be improved.

### First electrode 110

In FIG. 1, a substrate may be additionally located under the first electrode 110 or above the second electrode 190. The substrate may be a glass substrate and/or a plastic substrate, each having excellent mechanical strength, thermal stability, transparency, surface smoothness, ease of handling, and water resistance.

The first electrode 110 may be formed by depositing and/or sputtering, onto the substrate, a material for forming the first electrode 110. When the first electrode 110 is an anode, the material for forming the first electrode 110 may be selected from materials having a high work function that facilitate hole injection.

The first electrode 110 may be a reflective electrode, a semi-transmissive electrode, or a transmissive electrode. When the first electrode 110 is a transmissive electrode, a material for forming the first electrode 110 may be selected from indium tin oxide (ITO), indium zinc oxide (IZO), tin oxide (SnO₂), zinc oxide (ZnO), and any combination thereof, but the present disclosure is not limited thereto. In some embodiments, when the first electrode 110 is a semi-transmissive electrode or a reflective electrode, as a material for forming the first electrode 110, at least one selected from magnesium (Mg), silver (Ag), aluminium (Al), aluminium-lithium (Al-Li), calcium (Ca), magnesium-indium (Mg-In), magnesium-silver (Mg-Ag), and any combination thereof may be used, but the present disclosure is not limited thereto.

The first electrode 110 may have a single-layered structure, or a multilayered structure including two or more layers. In some embodiments, the first electrode 110 may have a triple-layered structure of ITO/Ag/ITO, but the present disclosure is not limited thereto.

### Emission layer in organic layer 150

The emission layer includes a host and a dopant, the host includes a first compound and a second compound different from the first compound, and the dopant includes a third compound and a fourth compound different from the third compound.

According to one or more embodiments, the first compound and the second compound may be hosts that each transport different types of charge (holes or electrons).

In some embodiments, the first compound may be a hole-transporting host, and the second compound may be an electron-transporting host.

### First compound

In some embodiments, the first compound may be a compound including at least one hole-transporting moiety. In some embodiments, the hole-transporting moiety may include a carbazole group, a dibenzofuran group, a dibenzothiophene group, a dibenzosilole group, and/or an amine group, but the present disclosure is not limited thereto.

According to one or more embodiments, the first compound may include at least one moiety represented by any one selected from Formulae 3-1 to 3-3: 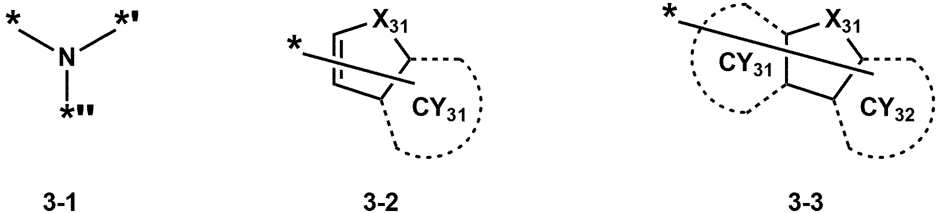
wherein, in Formulae 3-1 to 3-3,
X₃₁ is selected from O, S, N-(L₃₃)ₐ₃₃-(R₃₃)_{b33}, C(R₃₃)(R₃₄), and Si(R₃₃)(R₃₄),
CY₃₁ and CY₃₂ are each independently a π-electron rich cyclic group,
L₃₃ is selected from a single bond, a substituted or unsubstituted C₅-C₃₀ (*e.g*. C₅-C₂₀) carbocyclic group, and a substituted or unsubstituted C₁-C₃₀ (*e.g.* C₁-C₂₀) heterocyclic group,
a33 is an integer from 1 to 10,
R₃₃ and R₃₄ are each independently selected from hydrogen, deuterium, -F, - Cl, -Br, -I, a hydroxyl group, a cyano group, a nitro group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ (*e.g*. C₁-C₂₀) alkyl group, a substituted or unsubstituted C₂-C₆₀ (*e.g*. C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g*. C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
b33 is an integer from 1 to 10, and
*, *', and *" each indicate a binding site to an adjacent atom.

The term "π-electron rich cyclic group," as used herein, refers to a carbocyclic or heterocyclic group not including *=N-*' as a ring-forming moiety.

In some embodiments, the "π-electron rich cyclic group" may be a benzene group, a heptalene group, an indene group, a naphthalene group, an azulene group, a heptalene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, a benzonaphthofuran group, a benzonapthothiophene group, an indolophenanthrene group, a benzofuranophenanthrene group, or a benzothienophenanthrene group, but the present disclosure is not limited thereto.

According to one or more embodiments, CY₃₁ and CY₃₂ in Formulae 3-1 to 3-3 may each independently be a benzene group, a naphthalene group, a phenanthrene group, a fluorene group, a carbazole group, a dibenzofuran group, a dibenzothiophene group, or a dibenzosilole group.

According to one or more embodiments, the first compound may be a hole-transporting host including at least one moiety represented by any one selected from Formulae 3-1 to 3-3, as shown herein above.

According to one or more embodiments, the first compound may be selected from compounds represented by Formulae 3-11 to 3-14: 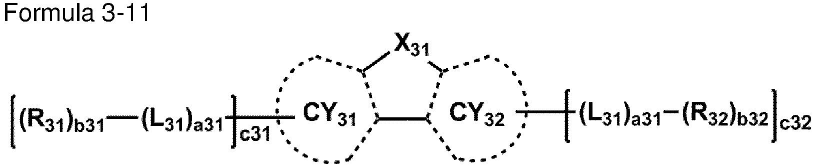 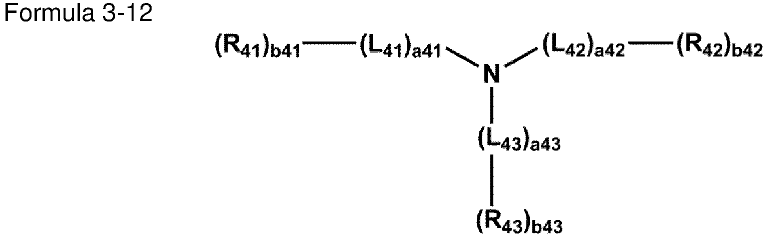 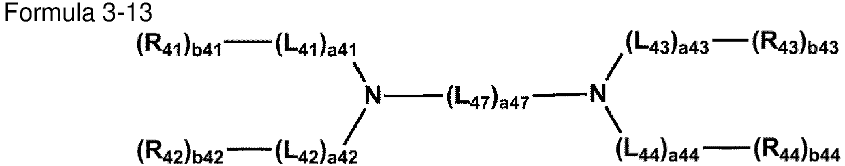 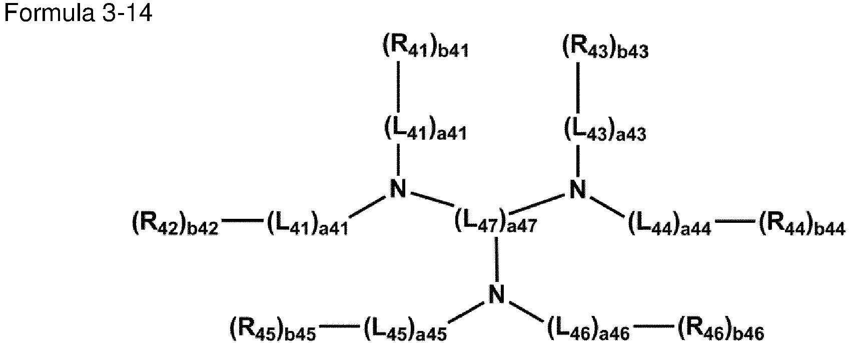
wherein, in Formula 3-11,
CY₃₁ and CY₃₂ are each independently a π-electron rich cyclic group having 3 to 30 carbon atoms,
X₃₁ is selected from O, S, N-(L₃₃)ₐ₃₃-(R₃₃)_{b33}, C(R₃₃)(R₃₄), and Si(R₃₃)(R₃₄),
c31 and c32 are each independently an integer from 0 to 3,
wherein, in Formulae 3-11 to 3-14,
L₃₁ to L₃₃ and L₄₁ to L₄₇ are each independently selected from a single bond, a substituted or unsubstituted C₅-C₃₀ (*e.g*. C₅-C₂₀) carbocyclic group (or a substituted or unsubstituted C₄-C₃₀ carbocyclic group), and a substituted or unsubstituted C₁-C₃₀ (*e.g.* C₁-C₂₀) heterocyclic group,
a31 to a33 and a41 to a47 are each independently an integer from 1 to 10,
R₃₁ to R₃₄ and R₄₁ to R₄₆ are each independently selected from hydrogen, deuterium, -F, -Cl, -Br, -I, a hydroxyl group, a cyano group, a nitro group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ (*e.g.* C₁-C₂₀) alkyl group, a substituted or unsubstituted C₂-C₆₀ (*e.g.* C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
b31 to b33 and b41 to b46 are each independently an integer from 1 to 10, and
at least one substituent of the substituted C₅-C₃₀ (*e.g*. C₅-C₂₀) carbocyclic group (or the substituted or unsubstituted C₄-C₃₀ carbocyclic group), the substituted C₁-C₃₀ (*e.g.* C₁-C₂₀) heterocyclic group, the substituted C₁-C₆₀ (*e.g.* C₁-C₂₀) alkyl group, the substituted C₂-C₆₀ (*e.g.* C₂-C₂₀) alkenyl group, the substituted C₂-C₆₀ (*e.g.* C₂-C₂₀) alkynyl group, the substituted C₁-C₆₀ (*e.g*. C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g.* C₆-C₃₀) arylthio group, the substituted C₁-C₆₀ (*e.g.* C₁-C₂₀) heteroaryl group, the substituted monovalent non-aromatic condensed polycyclic group, and the substituted monovalent non-aromatic condensed heteropolycyclic group is selected from:
   deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ *(e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group;
   a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), and -P(=O)(Q₂₁)(Q₂₂); and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
   wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amino group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryl group substituted with a C₁-C₆₀ (*e.g.* C₁-C₂₀) alkyl group, a C₆-C₆₀ (*e.g.* C₆-C₃₀) aryl group substituted with a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group.

According to one or more embodiments, in Formula 3-11, CY₃₁ and CY₃₂ may each independently be selected from a benzene group, a naphthalene group, an anthracene group, a phenanthrene group, a fluoranthene group, a triphenylene group, a pyrene group, a chrysene group, an indene group, a fluorene group, a spiro-bifluorene group, a benzofluorene group, a dibenzofluorene group, a carbazole group, a benzocarbazole group, a dibenzocarbazole group, a dibenzosilole group, a dibenzofuran group, and a dibenzothiophene group.

In some embodiments, CY₃₁ and CY₃₂ may each independently be selected from a benzene group, a naphthalene group, a phenanthrene group, a fluorene group, a carbazole group, a dibenzosilole group, a dibenzofuran group, and a dibenzothiophene group.

According to one or more embodiments, in Formulae 3-11 to 3-14,
L₃₁ to L₃₃ and L₄₁ to L₄₇ may each independently be a single bond or a substituted or unsubstituted π-electron rich cyclic group having 3 to 30 carbon atoms.

In some embodiments, L₃₁ to L₃₃ and L₄₁ to L₄₇ may each independently be selected from:
a single bond, a benzene group, a heptalene group, an indene group, a naphthalene group, an azulene group, a heptalene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, and a dihydroacridine group; and
a benzene group, a heptalene group, an indene group, a naphthalene group, an azulene group, a heptalene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, and a dihydroacridine group, each substituted with deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, and a terphenyl group.

In Formulae 3-11 to 3-14, a31 to a33 and a41 to a47 respectively indicate the number of L₃₁ to L₃₃ and L₄₁ to L₄₇, and a31 to a33 and a41 to a47 are each independently an integer from 1 to 10.

According to one or more embodiments, in Formulae 3-11 to 3-14, R₃₁ to R₃₄ and R₄₁ to R₄₆ may each independently be selected from:
hydrogen, deuterium, -F, -Cl, -Br, -I, a hydroxyl group, a cyano group, a nitro group, a C₁-C₂₀ (*e.g.* C₁-C₁₀) alkyl group, and a C₁-C₂₀ (*e.g.* C₁-C₁₀) alkoxy group;
a C₁-C₂₀ (*e.g.* C₁-C₁₀) alkyl group and a C₁-C₂₀ (*e.g.* C₁-C₁₀) alkoxy group, each substituted with at least one selected from deuterium, -F, -Cl, -Br, -I, a cyano group, a phenyl group, and a biphenyl group;
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₁)(Q₂)(Q₃), -N(Q₁)(Q₂), and -B(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ (*e.g.* C₁-C₁₀) alkyl group, a C₁-C₂₀ (e.g. C₁-C₁₀) alkoxy group, a cyclopentyl group, a cyclohexyl group, a cycloheptyl group, a cyclopentenyl group, a cyclohexenyl group, a phenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, a biphenyl group, and a terphenyl group,
wherein Q₁ to Q₃ may each independently be selected from hydrogen, deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, and a tetraphenyl group.

In some embodiments, in Formulae 3-11 to 3-14, R₃₃ and R₄₁ to R₄₆ may each independently be selected from hydrogen, a substituted or unsubstituted monovalent π-electron rich cyclic group, -Si(Q₁)(Q₂)(Q₃), and -N(Q₁)(Q₂),
wherein Q₁ to Q₃ may each independently be selected from hydrogen, deuterium, a C₁-C₁₀ alkyl group, a C₁-C₁₀ alkoxy group, a π-electron rich cyclic group, a biphenyl group, and a terphenyl group.

In some embodiments, R₃₃ and R₄₁ to R₄₆ may each independently be selected from:
a phenyl group, a biphenyl group, a terphenyl group, a tetraphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a pyrenyl group, a chrysenyl group, a pyrrolyl group, an isoindolyl group, an indolyl group, a furanyl group, a thiophenyl group, a benzofuranyl group, a benzothiophenyl group, a benzosilolyl group, a dibenzofuranyl group, a dibenzothiophenyl group, a carbazolyl group, a benzocarbazolyl group, a dibenzocarbazolyl group, a dibenzosilolyl group, an indenocarbazolyl group, an indolocarbazolyl group, a benzofurocarbazolyl group, a benzothienocarbazolyl group, a benzosilolocarbazolyl group, and a dihydroacridinyl group;
a phenyl group, a biphenyl group, a terphenyl group, a tetraphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a pyrenyl group, a chrysenyl group, a pyrrolyl group, an isoindolyl group, an indolyl group, a furanyl group, a thiophenyl group, a benzofuranyl group, a benzothiophenyl group, a benzosilolyl group, a dibenzofuranyl group, a dibenzothiophenyl group, a carbazolyl group, a benzocarbazolyl group, a dibenzocarbazolyl group, a dibenzosilolyl group, an indenocarbazolyl group, an indolocarbazolyl group, a benzofurocarbazolyl group, a benzothienocarbazolyl group, a benzosilolocarbazolyl group, and a dihydroacridinyl group, each substituted with at least one selected from deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, and a terphenyl group;
-Si(Q₁)(Q₂)(Q₃) and -N(Q₁)(Q₂),
wherein Q₁ to Q₃ may each independently be selected from hydrogen, deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, and a terphenyl group.
b31 to b33 and b41 to b46 respectively indicate the number of R₃₁(s) to R₃₃(s) and R₄₁(s) to R₄₆(s), and b31 to b33 and b41 to b46 are each independently an integer from 1 to 10.

According to one or more embodiments, the first compound may be selected from the following compounds, but the present disclosure is not limited thereto:

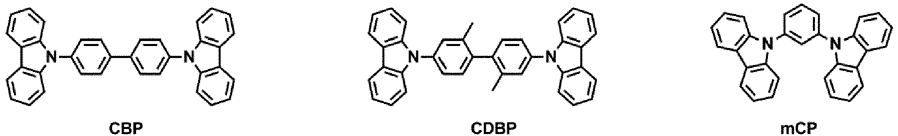

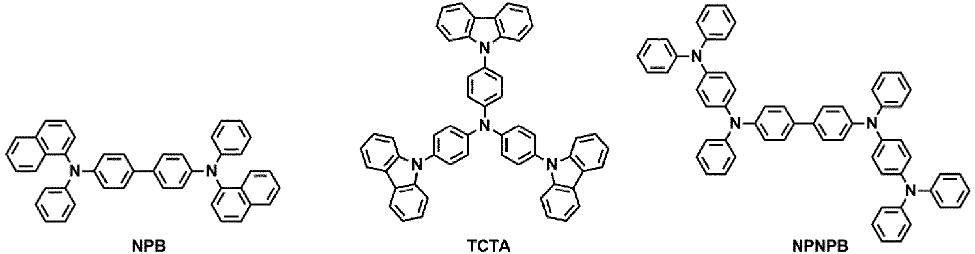

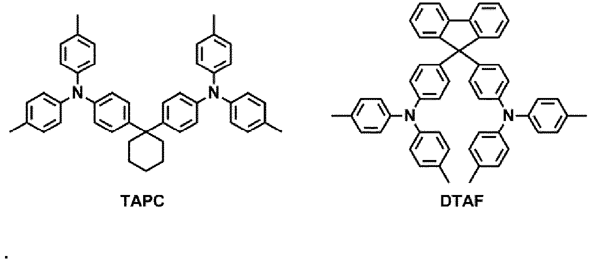

### Second compound

The second compound may include at least one electron-transporting moiety. In some embodiments, the second compound may include an electron-transporting moiety including at least one selected from -F, a cyano group, a C₁-C₆₀ (*e.g.* C₁-C₂₀) alkyl group substituted with -F or a cyano group, a C₆-C₆₀ (*e.g.* C₆-C₃₀) aryl group substituted with -F or a cyano group, and a π-electron-depleted nitrogen-containing cyclic group.

In some embodiments, the second compound may be represented by Formula 4-1: 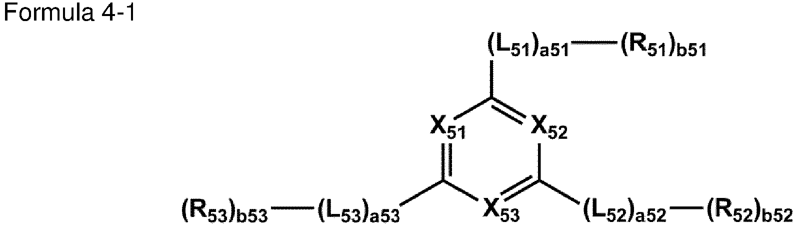
wherein, in Formula 4-1,
X₅₁ is N or C[(L₅₄)ₐ₅₄-(R₅₄)_{b54}], X₅₂ is N or C[(L₅₅)ₐ₅₅-(R₅₅)_{b55}], and X₅₃ is N or C[(L₅₆)ₐ₅₆-(R₅₆)_{b56}],
L₅₁ to L₅₆ are each independently selected from a single bond, a substituted or unsubstituted C₅-C₃₀ (*e.g*. C₅-C₂₀) carbocyclic group (or a substituted or unsubstituted C₄-C₃₀ carbocyclic group) and a substituted or unsubstituted C₁-C₃₀ (*e.g*. C₁-C₂₀) heterocyclic group,
a51 to a56 are each independently an integer from 1 to 10,
R₅₁ to R₅₆ are each independently selected from hydrogen, deuterium, -F, - Cl, -Br, -I, a hydroxyl group, a cyano group, a nitro group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ (*e.g.* C₁-C₂₀) alkyl group, a substituted or unsubstituted C₂-C₆₀ (*e.g.* C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
b51 to b56 are each independently an integer from 1 to 10, and
at least one substituent of the substituted C₅-C₃₀ (*e.g.* C₅-C₃₀) carbocyclic group (or the substituted or unsubstituted C₄-C₃₀ carbocyclic group), the substituted C₁-C₃₀ (*e.g.* C₁-C₂₀) heterocyclic group, the substituted C₁-C₆₀ (*e.g.* C₁-C₂₀) alkyl group, the substituted C₂-C₆₀ (*e.g.* C₂-C₂₀) alkenyl group, the substituted C₂-C₆₀ (*e.g.* C₂-C₂₀) alkynyl group, the substituted C₁-C₆₀ (*e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g*. C₆-C₃₀) arylthio group, the substituted C₁-C₆₀ heteroaryl group, the substituted monovalent non-aromatic condensed polycyclic group, and the substituted monovalent non-aromatic condensed heteropolycyclic group is selected from the aforementioned substituents.
According to one or more embodiments, in Formula 4-1, L₅₁ to L₅₆ may each independently be selected from: a single bond, a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azaindene group, an azaindole group, an azabenzofuran group, an azabenzothiophene group, an azabenzosilole group, an azafluorene group, an azacarbazole group, an azadibenzofuran group, an azadibenzothiophene group, and an azadibenzosilole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azaindene group, an azaindole group, an azabenzofuran group, an azabenzothiophene group, an azabenzosilole group, an azafluorene group, an azacarbazole group, an azadibenzofuran group, an azadibenzothiophene group, and an azadibenzosilole group, each substituted with at least one selected from deuterium, -F, -Cl, -Br, -I, a hydroxyl group, a cyano group, a nitro group, an amidino group, a hydrazino group, a hydrazono group, a C₁-C₂₀ (*e.g*. C₁-C₁₀) alkyl group, a C₁-C₂₀ (*e.g*. C₁-C₁₀) alkoxy group, a phenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a dibenzofuranyl group, a dibenzothiophenyl group, a carbazolyl group, an imidazolyl group, a pyrazolyl group, a thiazolyl group, an isothiazolyl group, an oxazolyl group, an isoxazolyl group, a pyridinyl group, a pyrazinyl group, a pyridazinyl group, a pyrimidinyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a phenanthridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an oxadiazolyl group, a triazinyl group, a thiadiazolyl group, an imidazopyridinyl group, an imidazopyrimidinyl group, an azaindenyl group, an azaindolyl group, an azabenzofuranyl group, an azabenzothiophenyl group, an azabenzosilolyl group, an azafluorenyl group, an azacarbazolyl group, an azadibenzofuranyl group, an azadibenzothiophenyl group, an azadibenzosilolyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein O₃₁ to Q₃₃ may each independently be selected from a C₁-C₁₀ alkyl group, a C₁-C₁₀ alkoxy group, a phenyl group, a phenyl group substituted with a C₁-C₁₀ alkyl group, a biphenyl group, a terphenyl group, and a naphthyl group.

In some embodiments, in Formula 4-1, R₅₁ to R₅₆ may each independently be selected from:
hydrogen, deuterium, -F, -Cl, -Br, -I, a hydroxyl group, a cyano group, a nitro group, a C₁-C₂₀ (*e.g.* C₁-C₁₀) alkyl group, and a C₁-C₂₀ (*e.g.* C₁-C₁₀) alkoxy group;
a C₁-C₂₀ (*e.g.* C₁-C₁₀) alkyl group and a C₁-C₂₀ (*e.g.* C₁-C₁₀) alkoxy group, each substituted with at least one selected from deuterium, -F, -Cl, -Br, -I, a cyano group, a phenyl group, and a biphenyl group;
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₁)(Q₂)(Q₃), -N(Q₁)(Q₂), and -B(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ (*e.g.* C₁-C₁₀) alkyl group, a C₁-C₂₀ (*e.g.* C₁-C₁₀) alkoxy group, a cyclopentyl group, a cyclohexyl group, a cycloheptyl group, a cyclopentenyl group, a cyclohexenyl group, a phenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, a biphenyl group, and a terphenyl group,
wherein Q₁ to Q₃ may each independently be selected from hydrogen, deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, and a tetraphenyl group.

According to one or more embodiments, the second compound may be selected from the following compounds, but the present disclosure is not limited thereto:

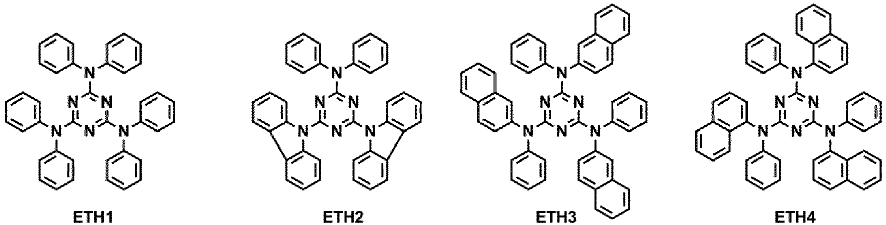

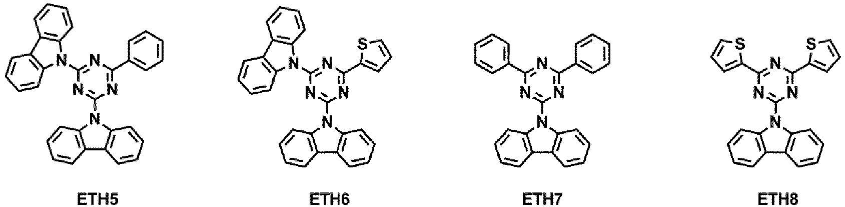

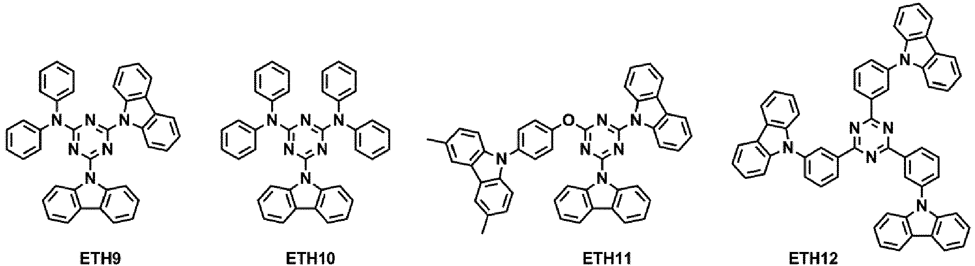

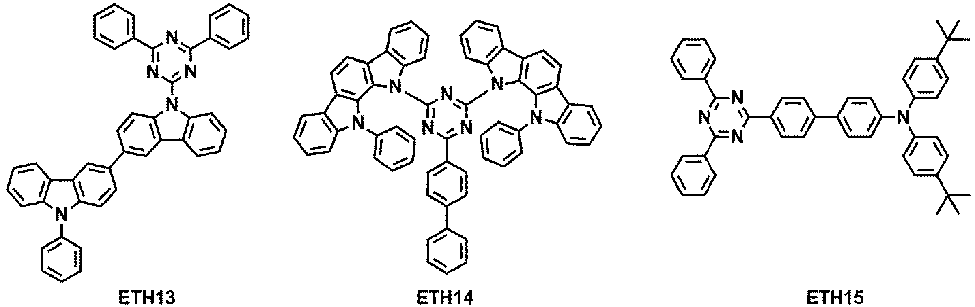

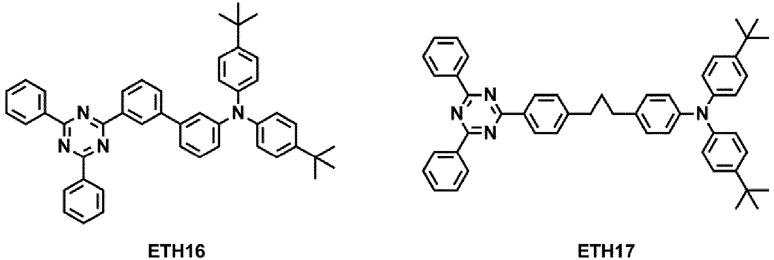

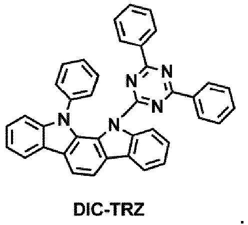

The organic light-emitting device includes mixed hosts of the first compound and the second compound. Accordingly, charge balance in an emission layer of the organic light-emitting device may be improved, as compared with an organic light-emitting device including a single host. In some embodiments, when the first compound and the second compound are hosts that may each transport different types of charge (holes or electrons), balance of holes and electrons in the emission layer may be suitably maintained, thus improving driving characteristics of the organic light-emitting device. For example, the exciton profile may be improved in the emission layer, thus improving efficiency of the organic light-emitting device.

In some embodiments, a host in the emission layer may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ may be selected from a substituted or unsubstituted C₅-C₆₀ carbocyclic group (or a substituted or unsubstituted C₄-C₃₀ carbocyclic group) and a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂), and
xb21 may be an integer from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but the present disclosure is not limited thereto.

For example, Ar₃₀₁ may be a substituted or unsubstituted C₅-C₃₀ carbocyclic group or a substituted or unsubstituted C₁-C₁₂ heterocyclic group, but embodiments are not limited thereto.

In some embodiments, in Formula 301, Ar₃₀₁ may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but the present disclosure is not limited thereto.
When xb11 in Formula 301 is 2 or greater, at least two Ar₃₀₁(s) may be bound via a single bond.

In one or more embodiments, the compound represented by Formula 301 may be represented by Formula 301-1 or 301-2: 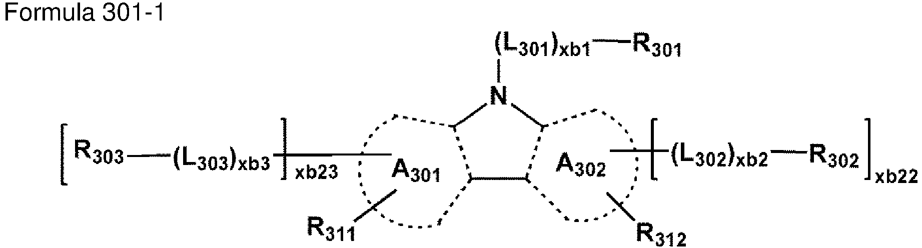 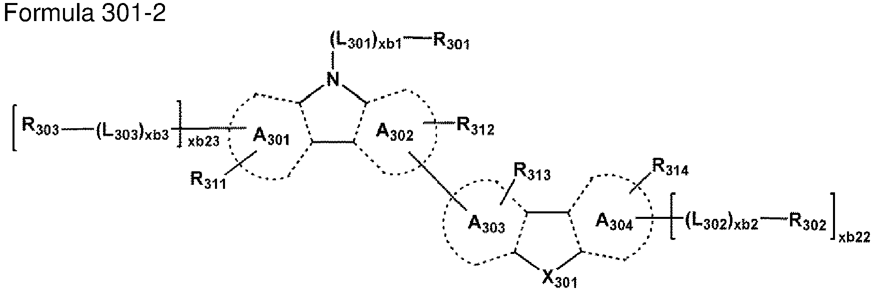
wherein, in Formulae 301-1 to 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonapthothiophene group, and a dinaphthothiophene group,
X₃₀₁ may be O, S, or N-[(L₃₀₄)_{xb4}-R₃₀₄],
R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁, and Q₃₁ to Q₃₃ may respectively be understood by referring to the descriptions of L₃₀₁, xb1, R₃₀₁, and Q₃₁ to Q₃₃ provided herein,
L₃₀₂ to L₃₀₄ may each be understood by referring to the description of L₃₀₁ provided herein,
xb2 to xb4 may each be understood by referring to the descriptions of xb1 provided herein, and
R₃₀₂ to R₃₀₄ may each be understood by referring to the description of R₃₀₁ provided herein.

In some embodiments, in Formulae 301, 301-1, and 301-2, L₃₀₁ to L₃₀₄ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may respectively be understood by referring to the descriptions of Q₃₁ to Q₃₃ provided herein.

As another example, R₃₀₁ to R₃₀₄ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted C₁-C₆₀ (*e.g*. C₁-C₁₀) alkyl group, a substituted or unsubstituted C₂-C₆₀ (*e.g*. C₂-C₁₀) alkenyl group, a substituted or unsubstituted C₂-C₆₀ *(e.g.* C₂-C₁₀) alkynyl group, a substituted or unsubstituted C₁-C₆₀ *(e.g.* C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

In some embodiments, in Formulae 301, 301-1, and 301-2, R₃₀₁ to R₃₀₄ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may respectively be understood by referring to the descriptions of Q₃₁ to Q₃₃ provided herein.

In some embodiments, the host may include an alkaline earth metal complex and/or a zinc (Zn) complex. For example, the host may include a beryllium (Be) complex, e.g., Compound H55, a magnesium (Mg) complex, and/or a zinc (Zn) complex.

In some embodiments, the host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but the present disclosure is not limited thereto:

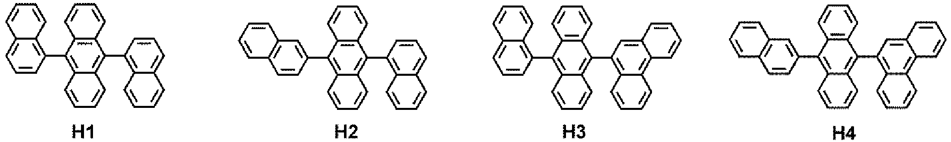

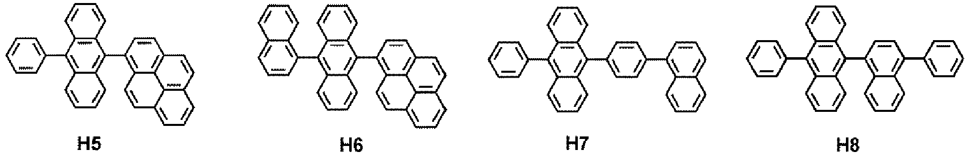

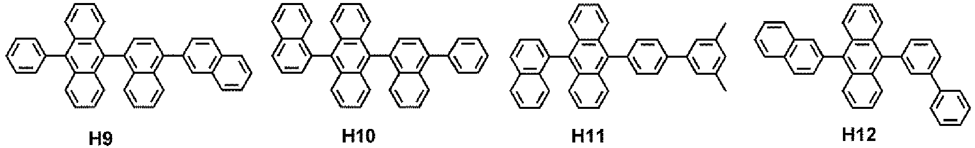

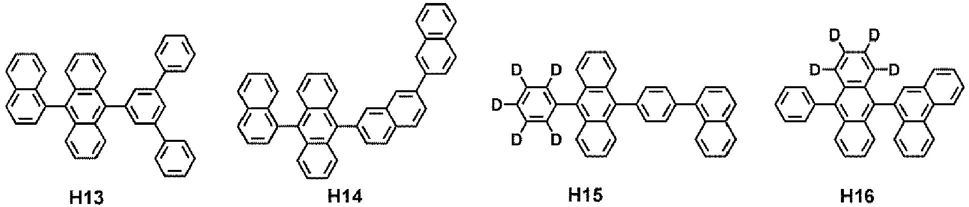

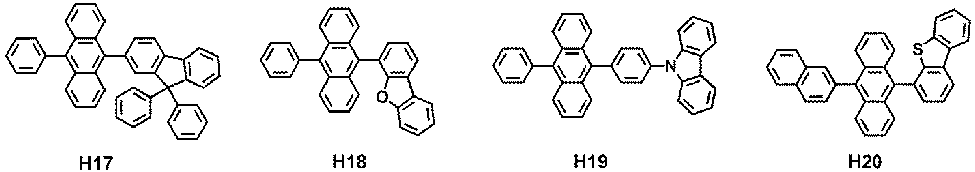

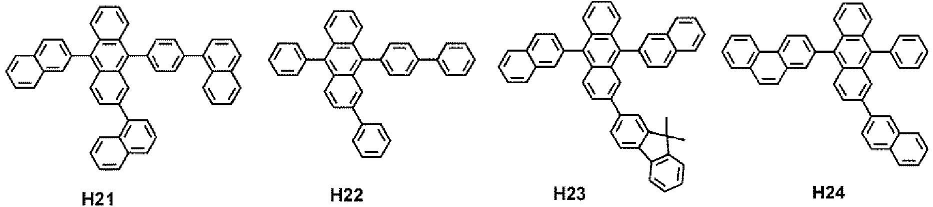

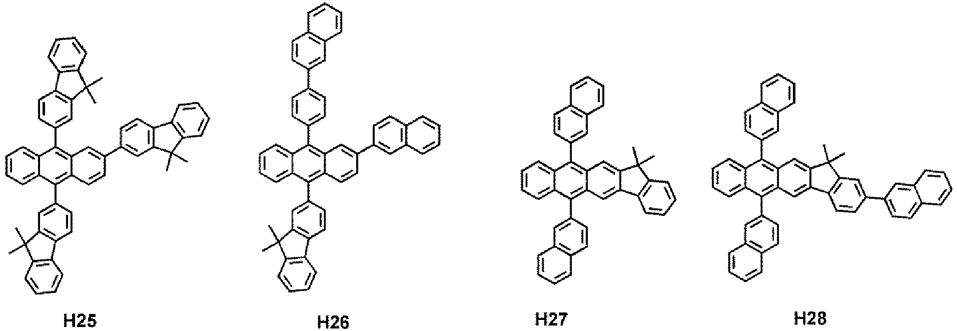

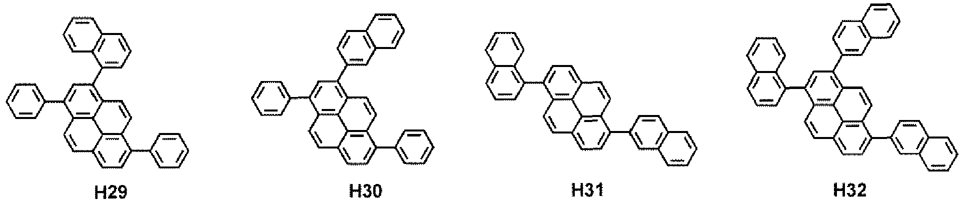

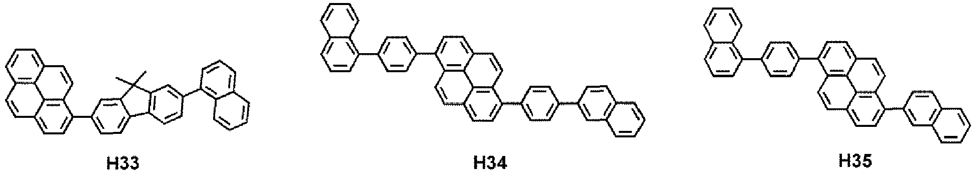

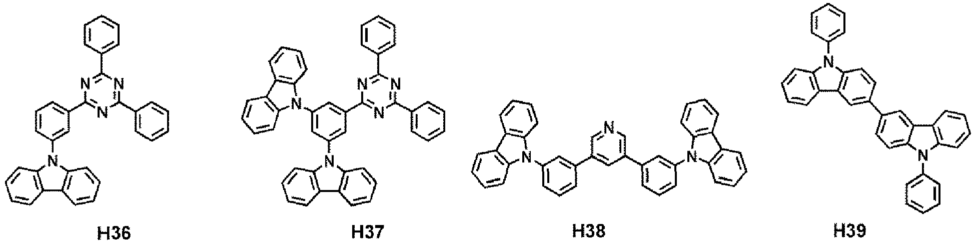

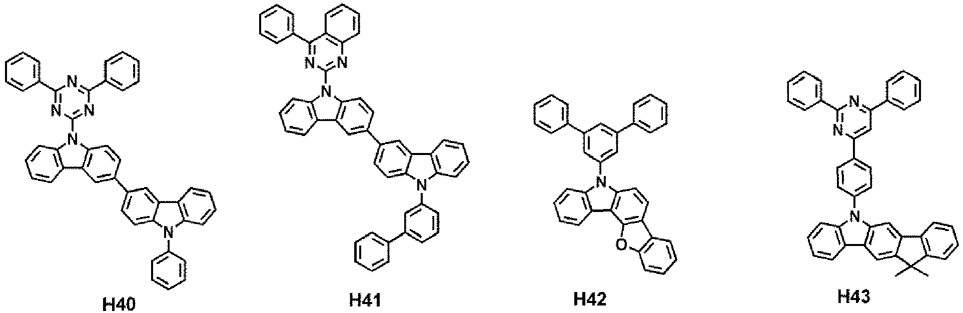

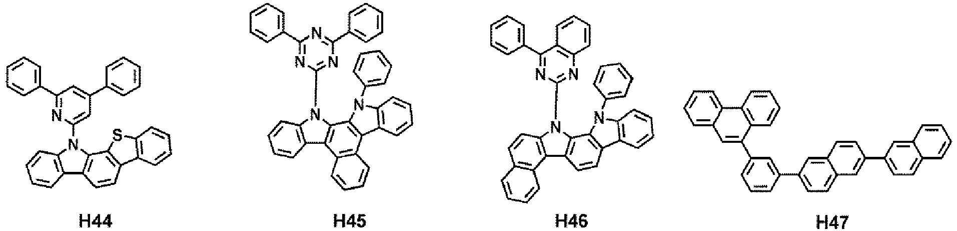

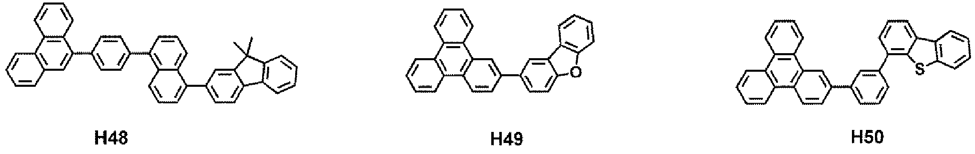

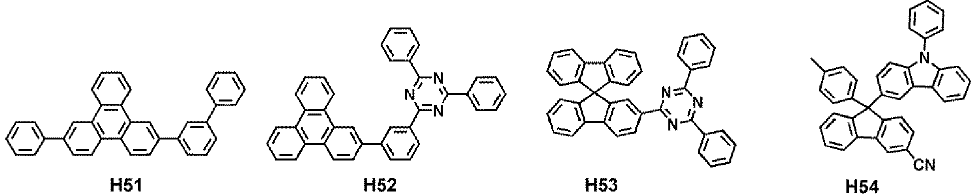

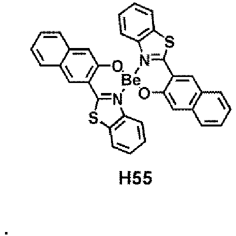

### Third compound and fourth compound

According to one or more embodiments, the third compound and the fourth compound may each independently be an organometallic compound represented by Formula 1:

Formula 1 M(L₁)ₙ₁(L₂)ₙ₂

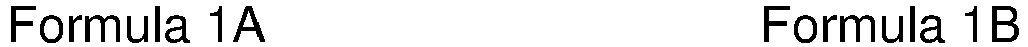

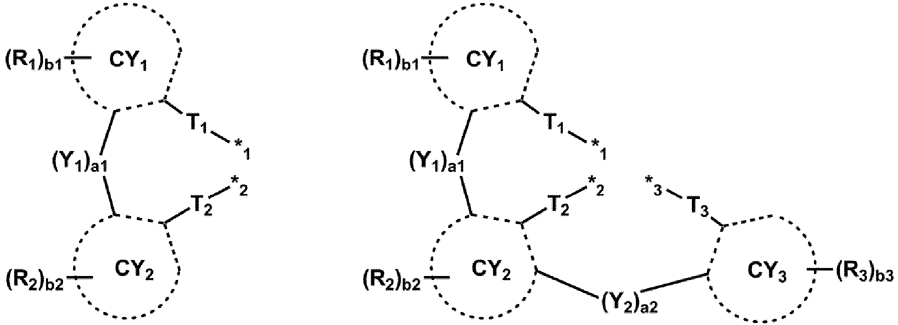

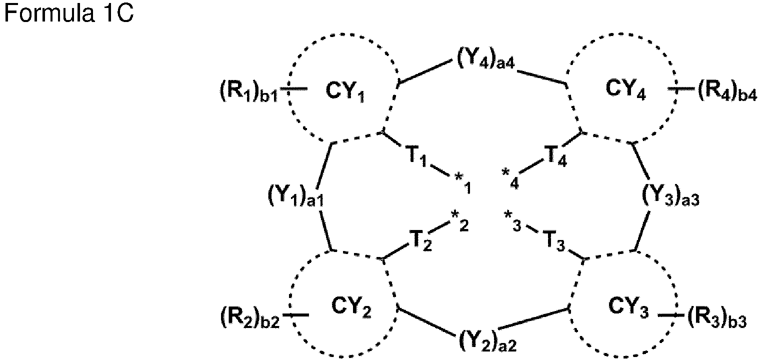

wherein, in Formulae 1 and 1A to 1C,
M is selected from a first-row transition metal, a second-row transition metal, and a third-row transition metal, wherein M in the third compound is platinum (Pt),
L₁ is selected from a ligand represented by Formula 1A, a ligand represented by Formula 1B, and a ligand represented by Formula 1C,
L₂ is selected from a monodentate ligand, a bidentate ligand, and a tridentate ligand,
n1 is selected from 1, 2, and 3,
n2 is selected from 0, 1, 2, 3, and 4,
CY₁ to CY₄ are each independently selected from a C₅-C₃₀ (*e.g.* C₅-C₂₀) carbocyclic group (or a substituted or unsubstituted C₄-C₃₀ carbocyclic group) and a C₁-C₃₀ (*e.g*. C₁-C₂₀) heterocyclic group,
Y₁ to Y₄ are each independently selected from a single bond, a double bond, a substituted or unsubstituted C₆-C₃₀ (*e.g.* C₆-C₂₀) arylene group, a substituted or unsubstituted C₁-C₃₀ (*e.g.* C₁-C₂₀) heteroarylene group, *-O-*', *-S-*', *-C(=O)-*', *-S(=O)-*', *-C(R₅)(R₆)-*', *-C(R₅)=C(R₆)-*', *-C(R₅)=*', *-Si(R₅)(R₆)-*', *-B(R₅)-*', *-N(R₅)-*', and *-P(R₅)-*',
a1 to a3 are each independently selected from 1, 2, and 3,
a4 is selected from 0, 1, 2, and 3, and when a4 is 0, CY₂ and CY₄ are not connected to each other,
T₁ to T₄ are each independently selected from a chemical bond (e.g., a single bond), *-O-*', *-S-*', *-B(R₇)-*', *-N(R₇)-*', *-P(R₇)-*', *-C(R₇)(R₈)-*', *-Si(R₇)(R₈)-*', *-Ge(R₇)(R₈)-*', *-C(=O)-*', and *-C(=S)-*',
*₁, *₂, *₃, and *₄ are each a binding site to M,
R₁ to R₈ are each independently selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ (*e.g*. C₁-C₂₀) alkyl group, a substituted or unsubstituted C₂-C₆₀ (*e.g*. C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), -Si(Q₁)(Q₂)(Q₃), -B(Q₁)(Q₂), -N(Q₁)(Q₂), - P(Q₁)(Q₂), -C(=O)(Q₁), -S(=O)(Q₁), -S(=O)₂(Q₁), -P(=O)(Q₁)(Q₂), and -P(=S)(Q₁)(Q₂), wherein adjacent groups from among R₁ to R₈ are optionally bound to form a substituted or unsubstituted C₅-C₆₀ (*e.g.* C₅-C₃₀) carbocyclic group (or a substituted or unsubstituted C₄-C₃₀ carbocyclic group) or a substituted or unsubstituted C₁-C₆₀ (*e.g.* C₁-C₂₀) heterocyclic group,
adjacent groups from among R₁ to R₈ and Y₁ to Y₄ are optionally bound to form a substituted or unsubstituted C₅-C₆₀ (*e.g.* C₅-C₃₀) carbocyclic group (or a substituted or unsubstituted C₄-C₃₀ carbocyclic group) or a substituted or unsubstituted C₁-C₆₀ (*e.g.* C₁-C₂₀) heterocyclic group,
b1 to b4 are each independently an integer from 0 to 10, and
at least one substituent of the substituted C₆-C₃₀ (*e.g.* C₆-C₂₀) arylene group, the substituted C₁-C₃₀ (*e.g.* C₁-C₂₀) heteroarylene group, the substituted C₁-C₆₀ (*e.g.* C₁-C₂₀) alkyl group, the substituted C₂-C₆₀ (*e.g.* C₂-C₂₀) alkenyl group, the substituted C₂-C₆₀ (*e.g.* C₂-C₂₀) alkynyl group, the substituted C₁-C₆₀ (*e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g.* C₆-C₃₀) arylthio group, the substituted C₁-C₆₀ (*e.g.* C₁-C₂₀) heteroaryl group, the substituted monovalent non-aromatic condensed polycyclic group, the substituted monovalent non-aromatic condensed heteropolycyclic group, the substituted C₅-C₆₀ (*e.g.* C₅-C₃₀) carbocyclic group (or the substituted C₄-C₃₀ carbocyclic group), and the substituted C₁-C₆₀ (*e.g.* C₁-C₂₀) heterocyclic group is selected from the aforementioned substituents.

In some embodiments, M in Formula 1 may be selected from iridium (Ir), platinum (Pt), osmium (Os), ruthenium (Ru), rhodium (Rh), palladium (Pd), copper (Cu), silver (Ag), gold (Au), titanium (Ti), zirconium (Zr), hafnium (Hf), europium (Eu), terbium (Tb), and thulium (Tm), but the present disclosure is not limited thereto.

In some embodiments, the fourth compound may be a compound where M is Ir or Pt, but the present disclosure is not limited thereto.

According to one or more embodiments, in Formulae 1A to 1C, CY₁ to CY₄ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a carbene moiety-containing group, a thiophene group, a furan group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group.

According to one or more embodiments, at least one selected from CY₁ and CY₂ in Formula 1A, at least one selected from CY₁ to CY₃ in Formula 1B, and at least one selected from CY₁ to CY₄ in Formula 1C may be a carbene moiety-containing group.

According to one or more embodiments, in Formulae 1A to 1C, Y₁ to Y₄ may each independently be selected from a single bond, a double bond, *-O-*', *-S-*', *-C(R₅)(R₆)-*', and *-N(R₅)-*'.

In some embodiments, in Formulae 1A to 1C, R₁ to R₈ may each independently be selected from:
hydrogen, deuterium, -F, -Cl, -Br, -I, a hydroxyl group, a cyano group, a nitro group, a C₁-C₂₀ (*e.g.* C₁-C₁₀) alkyl group, and a C₁-C₂₀ (*e.g.* C₁-C₁₀) alkoxy group;
a C₁-C₂₀ (*e.g.* C₁-C₁₀) alkyl group and a C₁-C₂₀ (*e.g.* C₁-C₁₀) alkoxy group, each substituted with at least one selected from deuterium, -F, -Cl, -Br, -I, a cyano group, a phenyl group, and a biphenyl group;
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₁)(Q₂)(Q₃), -N(Q₁)(Q₂), and -B(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ (*e.g.* C₁-C₁₀) alkyl group, a C₁-C₂₀ (*e.g.* C₁-C₁₀) alkoxy group, a cyclopentyl group, a cyclohexyl group, a cycloheptyl group, a cyclopentenyl group, a cyclohexenyl group, a phenyl group, a naphthyl group, a fluorenyl group, a spiro-bifluorenyl group, a spiro-fluorene-benzofluorenyl group, a benzofluorenyl group, a dibenzofluorenyl group, a pyrenyl group, a phenalenyl group, a phenanthrenyl group, an anthracenyl group, a fluoranthenyl group, a triphenylenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, a biphenyl group, and a terphenyl group,
wherein Q₁ to Q₃ may each independently be selected from hydrogen, deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, and a tetraphenyl group.

According to one or more embodiments, at least one selected from R₁ to R₂ in Formula 1A, at least one selected from R₁ to R₃ in Formula 1B, and at least one selected from R₁ to R₄ in Formula 1C may be an electron-donating group.

In some embodiments, the electron-donating group may be a substituent selected from an iso-propyl group, a tert-butyl group, and groups represented by Formulae 10-1 to 10-61: 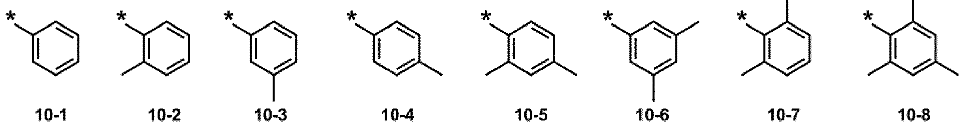 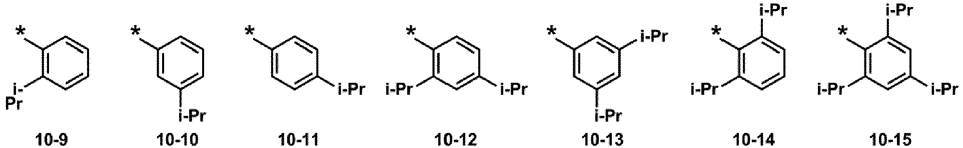 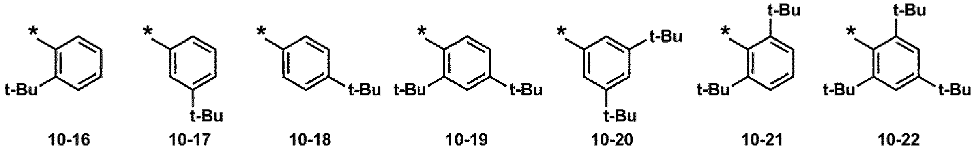 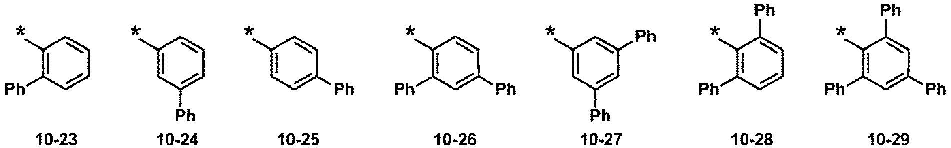 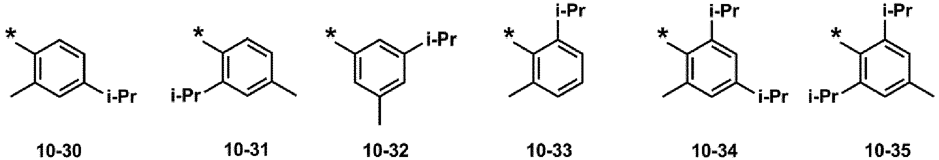 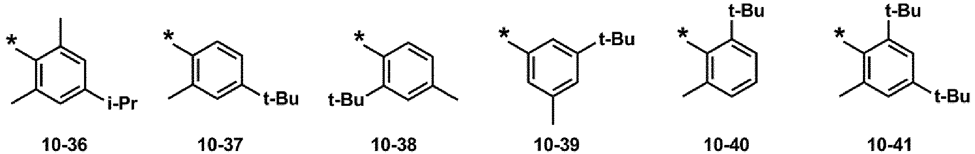 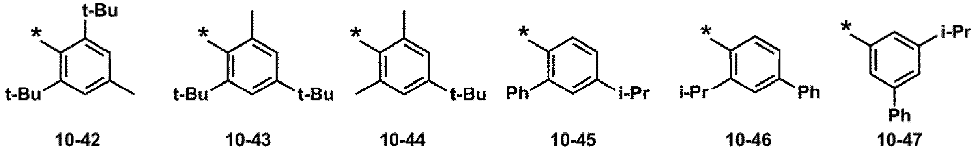 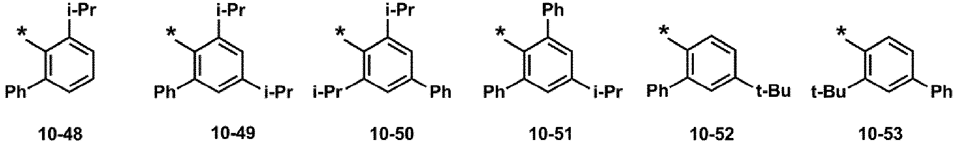 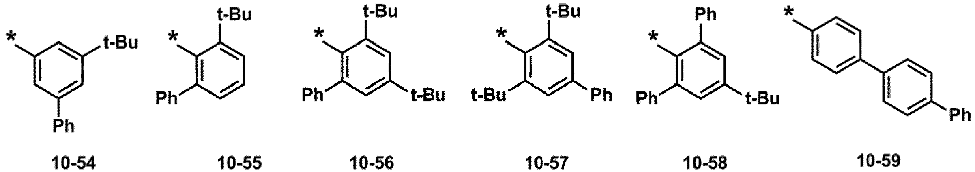 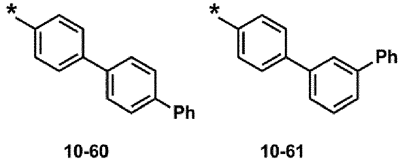
wherein, in Formulae 10-1 to 10-61,
"i-Pr" represents an iso-propyl group, "t-Bu" represents a t-butyl group,
"Ph" represents a phenyl group, and
* indicates a binding site to an adjacent atom.

In some embodiments, i) at least one selected from R₁ to R₂ in Formula 1A may be a substituent other than hydrogen, and/or Y₁ may be *-N(R₅)-*', and R₅ may be a substituted C₆-C₆₀ (*e.g.* C₆-C₃₀) aryl group, ii) at least one selected from R₁ to R₃ in Formula 1B may be a substituent other than hydrogen, and/or at least one selected from Y₁ and Y₂ may be *-N(R₅)-*', and R₅ may be a substituted C₆-C₆₀ (*e.g.* C₆-C₃₀) aryl group, and iii) at least one selected from R₁ to R₄ in Formula 1C may be a substituent other than hydrogen, and/or at least one selected from Y₁ to Y₄ may be *-N(R₅)-*', and R₅ may be a substituted C₆-C₆₀ (*e.g.* C₆-C₃₀) aryl group.

According to one or more embodiments, the third compound and the fourth compound may each independently be selected from compounds represented by Formulae 1-1 and 1-2: 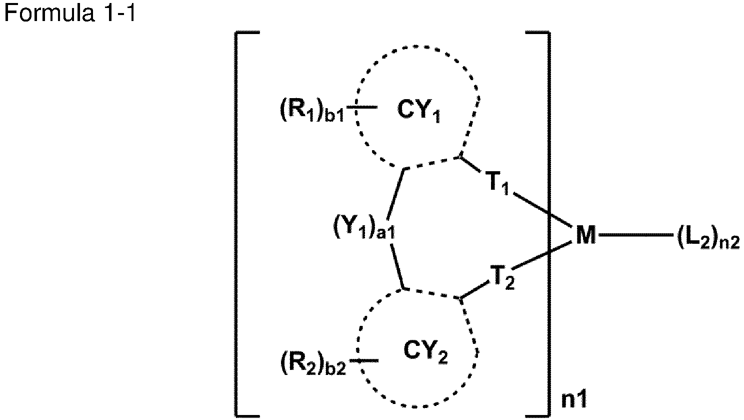 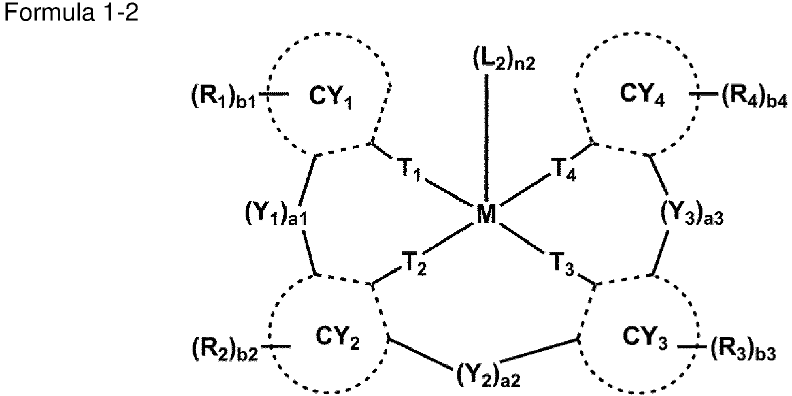
wherein, in Formulae 1-1 and 1-2,
M, L₂, n1, n2, CY₁ to CY₄, Y₁ to Y₃, a1 to a3, T₁ to T₄, R₁ to R₄, and b1 to b4 are respectively understood by referring to the descriptions of M, L₂, n1, n2, CY₁ to CY₄, Y₁ to Y₃, a1 to a3, T₁ to T₄, R₁ to R₄, and b1 to b4 provided herein.

According to one or more embodiments, at least one selected from CY₁ and CY₂ in Formula 1-1 and at least one selected from CY₁ to CY₄ in Formula 1-2 may each be a carbene moiety-containing group.

In some embodiments, at least one selected from CY₁ and CY₄ in Formula 1-2 may be a carbene moiety-containing group.

In some embodiments, the third compound may be a compound represented by Formula 2-1, and the fourth compound may be a compound represented by Formula 2-2: 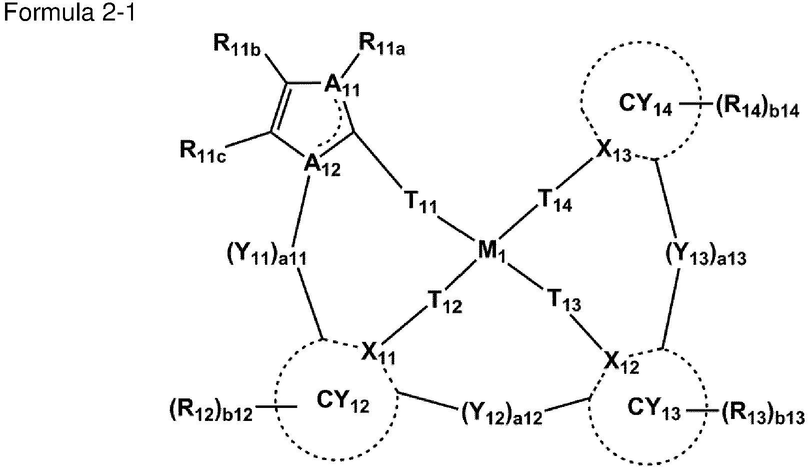 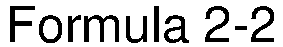 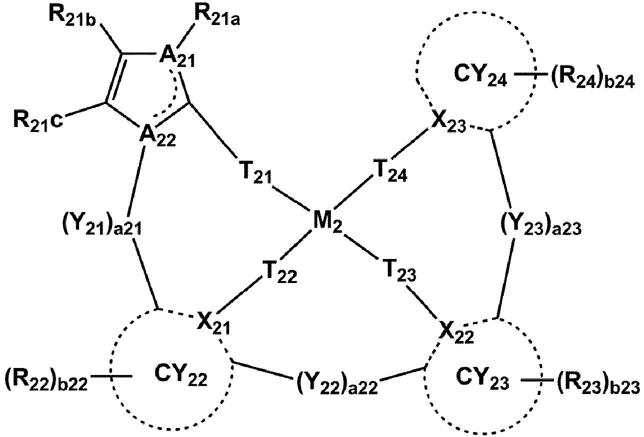
wherein, in Formulae 2-1 and 2-2,
M₁ is Pt,
M₂ is selected from a first-row transition metal, a second-row transition metal, and a third-row transition metal,
CY₁₂ to CY₁₄ and CY₂₂ to CY₂₄ are each independently selected from a C₅-C₃₀ (*e.g.* C₅-C₂₀) carbocyclic group (or a C₄-C₃₀ carbocyclic group) and a C₁-C₃₀ (*e.g.* C₁-C₂₀) heterocyclic group,
A₁₁, A₁₂, A₂₁, and A₂₂ are each independently N or P,
X₁₁ to X₁₃ and X₂₁ to X₂₃ are each independently N or C,
Y₁₁ to Y₁₃ are each independently selected from a single bond, a double bond, a substituted or unsubstituted C₆-C₃₀ (*e.g*. C₆-C₂₀) arylene group, a substituted or unsubstituted C₁-C₃₀ (*e.g*. C₁-C₂₀) heteroarylene group, *-O-*', *-S-*', *-C(=O)-*', *-S(=O)-*', *-C(R₁₅)(R₁₆)-*', *-C(R₁₅)=C(R₁₆)-*', *-C(R₁₅)=*', *-Si(R₁₅)(R₁₆)-*', *-B(R₁₅)-*', *-N(R₁₅)-*', and *-P(R₁₅)-*',
Y₂₁ to Y₂₃ are each independently selected from a single bond, a double bond, a substituted or unsubstituted C₆-C₃₀ (*e.g*. C₆-C₂₀) arylene group, a substituted or unsubstituted C₁-C₃₀ (*e.g*. C₁-C₂₀) heteroarylene group, *-O-*', *-S-*', *-C(=O)-*', *-S(=O)-*', *-C(R₂₅)(R₂₆)-*', *-C(R₂₅)=C(R₂₆)-*', *-C(R₂₅)=*', *-Si(R₂₅)(R₂₆)-*', *-B(R₂₅)-*', *-N(R₂₅)-*', and *-P(R₂₅)-*',
a11 to a13 are each independently selected from 1, 2, and 3,
a21 to a23 are each independently selected from 1, 2, and 3,
T₁₁ to T₁₄ are each independently selected from a chemical bond (e.g., a single bond), *-O-*', *-S-*', *-B(R₁₇)-*', *-N(R₁₇)-*', *-P(R₁₇)-*', *-C(R₁₇)(R₁₈)-*', *-Si(R₁₇)(R₁₈)-*', *-Ge(R₁₇)(R₁₈)-*', *-C(=O)-*', and *-C(=S)-*',
T₂₁ to T₂₄ are each independently selected from a chemical bond (e.g., a single bond), *-O-*', *-S-*', *-B(R₂₇)-*', *-N(R₂₇)-*', *-P(R₂₇)-*', *-C(R₂₇)(R₂₈)-*', *-Si(R₂₇)(R₂₈)-*', *-Ge(R₂₇)(R₂₈)-*', *-C(=O)-*', and *-C(=S)-*',
R₁₁ₐ to R_{11c}, R₁₂ to R₁₈, R₂₁ₐ to R_{21c}, and R₂₂ to R₂₈ are each independently selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ (*e.g*. C₁-C₂₀) alkyl group, a substituted or unsubstituted C₂-C₆₀ *(e.g.* C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), - Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), and -P(=S)(Q₁)(Q₂), wherein adjacent groups from among R₁₁ₐ to R_{11c} and R₁₂ to R₁₈ are optionally bound to form a substituted or unsubstituted C₅-C₆₀ (e.g. C₅-C₃₀) carbocyclic group (or a substituted or unsubstituted C₄-C₃₀ carbocyclic group) or a substituted or unsubstituted C₁-C₆₀ (*e.g*. C₁-C₂₀) heterocyclic group, and adjacent groups from among R₂₁ₐ to R_{21c} and R₂₂ to R₂₈ are optionally bound to form a substituted or unsubstituted C₅-C₆₀ (*e.g*. C₅-C₃₀) carbocyclic group (or a substituted or unsubstituted C₄-C₃₀ carbocyclic group) or a substituted or unsubstituted C₁-C₆₀ (*e.g*. C₁-C₂₀) heterocyclic group, and
b12 to b14 and b22 to b24 are each independently an integer from 0 to 10.

According to one or more embodiments, R_{11b} and R_{11c} in Formula 2-1 and/or R_{21b} and R_{21c} in Formula 2-2 may be bound to each other to form a benzene ring, a naphthalene ring, a pyridine ring, a pyrimidine ring, and a pyrazine ring, each unsubstituted or substituted with at least one Rₐ, and Rₐ may be understood by referring to the description of R₁₁ₐ provided herein.

According to one or more embodiments, at least one selected from R₁₁ₐ to R_{11c} and R₁₄ in Formula 2-1 may be an electron-donating group.

In some embodiments, at least one selected from R₁₁ₐ and R₁₄ in Formula 2-1 may be an electron-donating group. According to one or more embodiments, at least one selected from R₁₁ₐ and R₁₄ in Formula 2-1 may be an electron-donating group selected from an iso-propyl group, a tert-butyl group, and groups represented by Formulae 10-1 to 10-61: 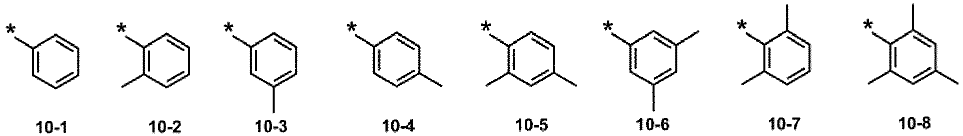 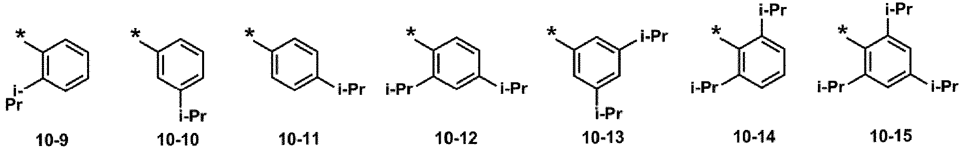 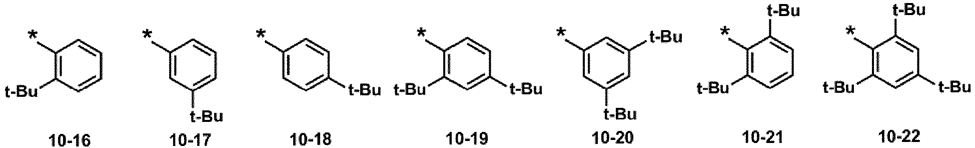 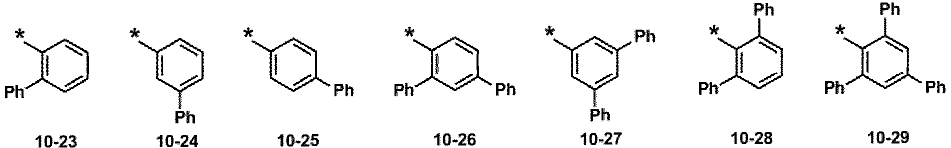 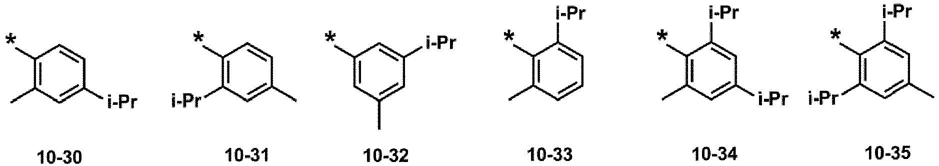 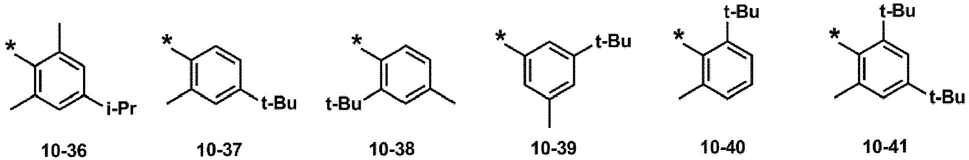 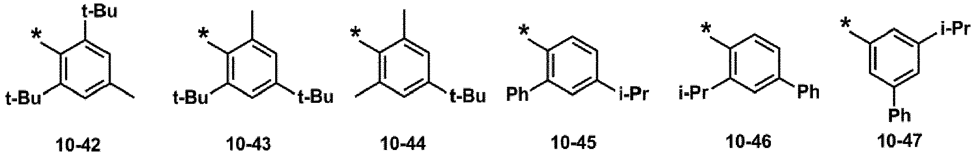 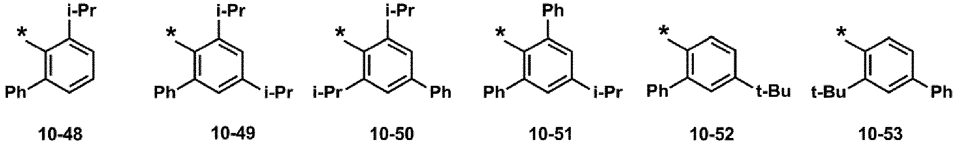 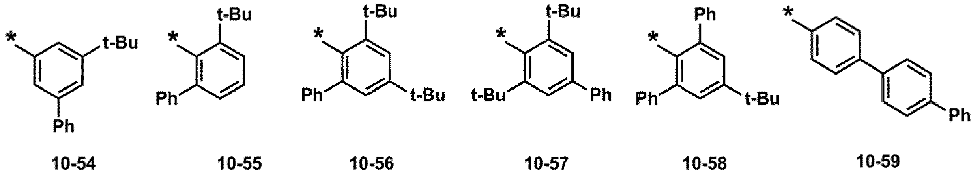 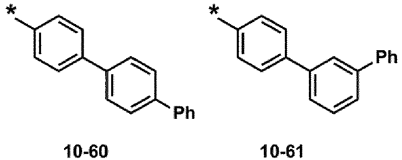
wherein, in Formulae 10-1 to 10-61,
"i-Pr" represents an iso-propyl group, "t-Bu" represents a t-butyl group,
"Ph" represents a phenyl group, and
* indicates a binding site to an adjacent atom.

According to one or more embodiments, at least one selected from R₂₂ and R₂₃ in Formula 2-2 may be a substituent other than hydrogen, and/or Y₂₃ may be *-N(R₂₅)-*', and R₂₅ may be a substituted C₆-C₆₀ (*e.g*. C₆-C₃₀) aryl group.

In some embodiments, at least one selected from R₂₂ and R₂₃ may be selected from a substituted or unsubstituted C₁-C₆₀ (*e.g*. C₁-C₂₀) alkyl group, a substituted or unsubstituted C₂-C₆₀ (*e.g*. C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, and/or Y₂₃ may be *-N(R₂₅)-*', and R₂₅ may be a substituted C₆-C₆₀ (*e.g*. C₆-C₃₀) aryl group.

In some embodiments, at least one selected from R₂₂ and R₂₃ may be a C₁-C₆₀ (*e.g.* C₁-C₂₀) alkyl group, a C₂-C₆₀ *(e.g.* C₂-C₂₀) alkenyl group, a C₂-C₆₀ (*e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ *(e.g.* C₆-C₃₀) aryloxy group, a C₆-C₆₀ *(e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one deuterium, and/or Y₂₃ may be *-N(R₂₅)-*', and R₂₅ may be a C₆-C₆₀ (*e.g*. C₆-C₃₀) aryl group substituted with at least one deuterium.

In some embodiments, at least one selected from R₂₂ and R₂₃ may be selected from an iso-propyl group, a tert-butyl group, and an electron-donating group selected from groups represented by Formulae 10-1 to 10-61, and/or Y₂₃ may be *-N(R₁₅)-*', and R₂₅ may be an iso-propyl group, a tert-butyl group, and an electron-donating group selected from groups represented by Formulae 10-1 to 10-61.

In some embodiments, at least one selected from R₁₁ₐ to R_{11c} and R₁₄ in Formula 2-1 may be an electron-donating group, and at least one selected from R₂₂ and R₂₃ in Formula 2-2 may be a substituent other than hydrogen, and/or Y₂₃ may be *-N(R₂₅)-*', and R₂₅ may be a substituted C₆-C₆₀ aryl group.

In some embodiments, the third compound may be a compound represented by Formula 2-1A or Formula 2-1B: 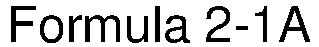 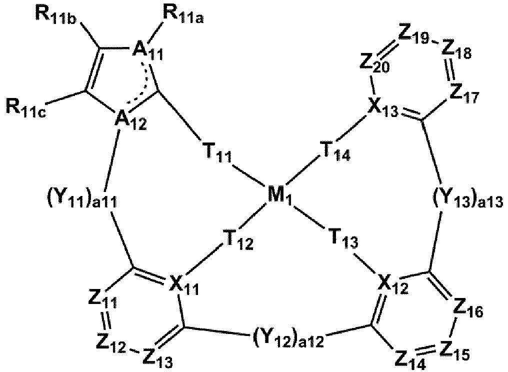 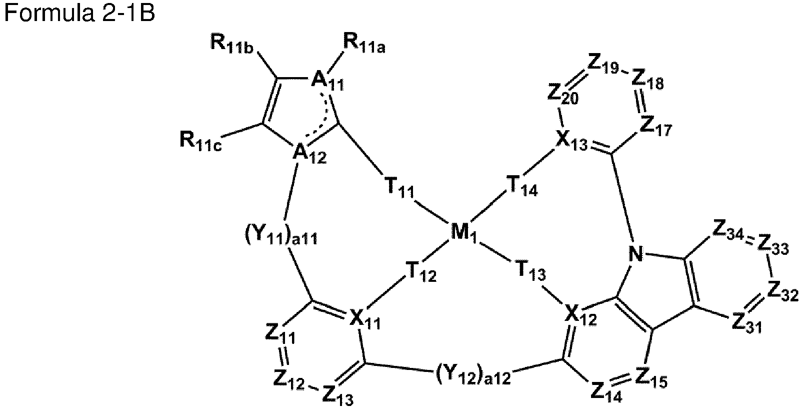
wherein, in Formulae 2-1A and 2-1B,
Z₁₁ is C(R₁₂ₐ) or N, Z₁₂ is C(R_{12b}) or N, Z₁₃ is C(R_{12c}) or N, Z₁₄ is C(R₁₃ₐ) or N, Z₁₅ is C(R_{13b}) or N, Z₁₆ is C(R_{13c}) or N, Z₁₇ is C(R₁₄ₐ) or N, Z₁₈ is C(R_{14b}) or N, Z₁₉ is C(R_{14c}) or N, and Z₂₀ is C(R_{14d}) or N,
Z₃₁ is C(R₁₅ₐ) or N, Z₃₂ is C(R_{15b}) or N, Z₃₃ is C(R_{15c}) or N, and Z₃₄ is C(R_{15d}) or N,
R₁₂ₐ to R_{12c} are each understood by referring to the description of R₁₂ provided herein,
R₁₃ₐ to R_{13c} are each understood by referring to the description of R₁₃ provided herein,
R₁₄ₐ to R_{14d} are each understood by referring to the description of R₁₄ provided herein,
R₁₅ₐ to R_{15d} are each understood by referring to the description of R₁₅ provided herein, and
M₁, A₁₁, A₁₂, X₁₁ to X₁₃, Y₁₁ to Y₁₃, a11 to a13, T₁₁ to T₁₄, and R₁₁ₐ to R_{11c} are respectively understood by referring to the descriptions of M₁, A₁₁, A₁₂, X₁₁ to X₁₃, Y₁₁ to Y₁₃, a11 to a13, T₁₁ to T₁₄, and R₁₁ₐ to R_{11c} provided herein.

According to one or more embodiments, in Formulae 2-1A and 2-1B, Z₁₈ may be C(R_{14b}), and at least one selected from R₁₁ₐ to R_{11c} and R_{14b} may be an electron-donating group. In some embodiments, in Formulae 2-1A and 2-1B, Z₁₈ may be C(R_{14b}), and at least one selected from R₁₁ₐ and R_{14b} may be an electron-donating group.

According to one or more embodiments, in Formulae 2-1A and 2-1B, Z₁₈ may be C(R_{14b}), and at least one selected from R₁₁ₐ and R_{14b} may be an electron-donating group selected from an iso-propyl group, a tert-butyl group, and groups represented by Formulae 10-1 to 10-61.

According to one or more embodiments, the fourth compound may be a compound represented by Formula 2-2A: 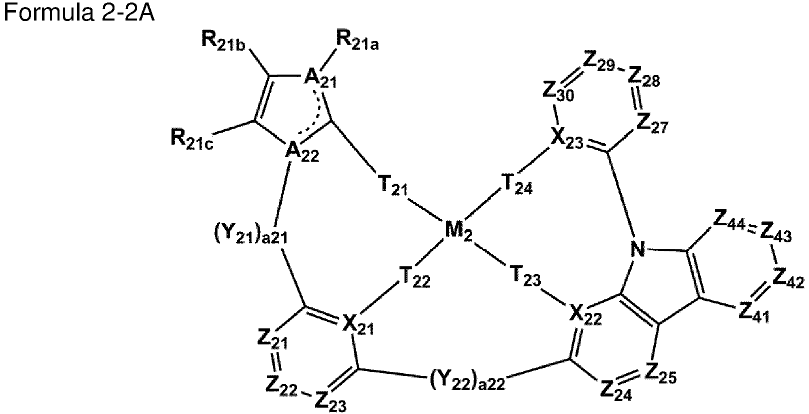
wherein in Formula 2-2A,
Z₂₁ is C(R₂₂ₐ) or N, Z₂₂ is C(R_{22b}) or N, Z₂₃ is C(R_{22c}) or N, Z₂₄ is C(R₂₃ₐ) or N, Z₂₅ is C(R_{23b}) or N, Z₂₇ is C(R₂₄ₐ) or N, Z₂₈ is C(R_{24b}) or N, Z₂₉ is C(R_{24c}) or N, Z₃₀ is C(R_{24d}) or N, Z₄₁ is C(R₂₅ₐ) or N, Z₄₂ is C(R_{25b}) or N, Z₄₃ is C(R_{25c}) or N, and Z₄₄ is C(R_{25d}) or N,
R₂₂ₐ to R_{22c} are each understood by referring to the description of R₂₂ provided herein,
R₂₃ₐ to R_{23c} are each understood by referring to the description of R₂₃ provided herein,
R₂₄ₐ to R_{24d} are each understood by referring to the description of R₂₄ provided herein,
R₂₅ₐ to R_{25d} are each understood by referring to the description of R₂₅ provided herein, and
M₂, A₂₁, A₂₂, X₂₁ to X₂₃, Y₂₁ to Y₂₃, a21 to a23, T₂₁ to T₂₄, and R₂₁ₐ to R_{21c} are respectively understood by referring to the descriptions of M₂, A₂₁, A₂₂, X₂₁ to X₂₃, Y₂₁ to Y₂₃, a21 to a23, T₂₁ to T₂₄, and R₂₁ₐ to R_{21c} provided herein.

According to one or more embodiments, in Formula 2-2A, M₂ may be Pt.

According to one or more embodiments, in Formula 2-2A, Z₂₂ may be C(R_{22b}), Z₄₂ may be C(R_{25b}), and at least one selected from R_{22b} and R_{25b} may be a substituent other than hydrogen. In some embodiments, at least one selected from R_{22b} and R_{25b} may be a substituted or unsubstituted C₁-C₆₀ (*e.g*. C₁-C₂₀) alkyl group, a substituted or unsubstituted C₂-C₆₀ (*e.g*. C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group.

In some embodiments, in Formula 2-2A, Z₂₂ may be C(R_{22b}), Z₄₂ may be C(R_{25b}), and at least one selected from R_{22b} and R_{25b} may be a C₁-C₆₀ (e.g. C₁-C₂₀) alkyl group, a C₂-C₆₀ *(e.g.* C₂-C₂₀) alkenyl group, a C₂-C₆₀ *(e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ *(e.g.* C₆-C₃₀) aryloxy group, a C₆-C₆₀ *(e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one deuterium.

In some embodiments, in Formula 2-2A, Z₂₂ may be C(R_{22b}), Z₄₂ may be C(R_{25b}), and at least one selected from R_{22b} and R_{25b} may be an electron-donating group selected from an iso-propyl group, a tert-butyl group, and groups represented by Formulae 10-1 to 10-61.

According to one or more embodiments, the third compound may be selected from Compounds BD1, BD2, and Pt-1 to Pt-24, but the present disclosure is not limited thereto:

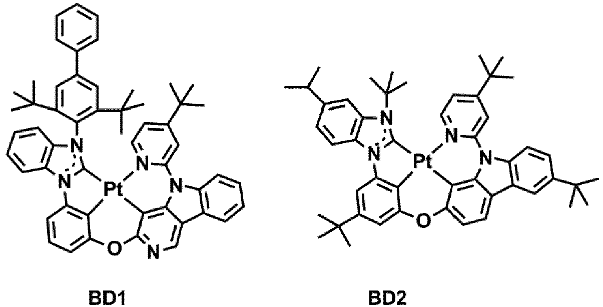

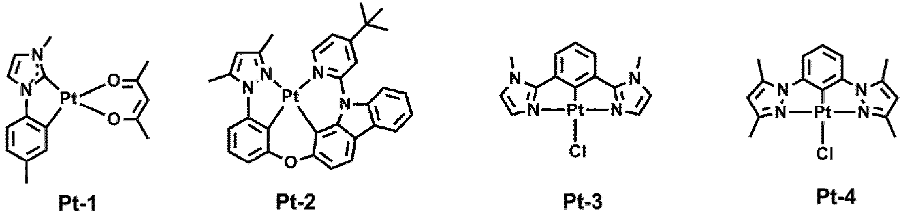

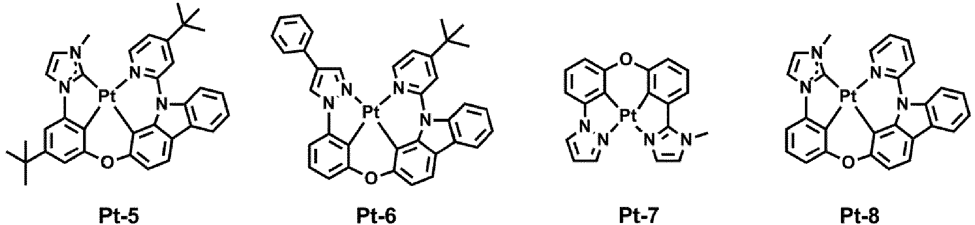

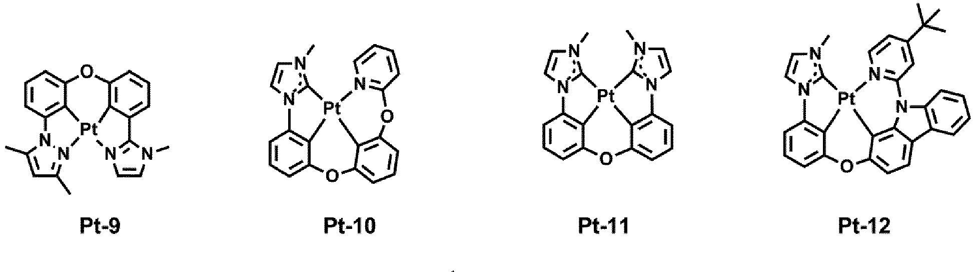

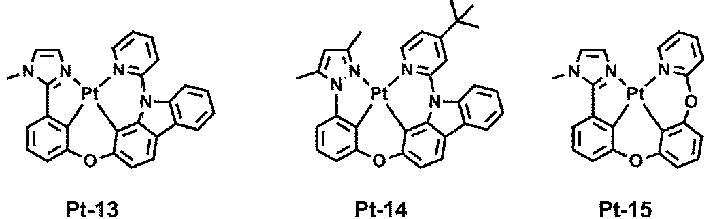

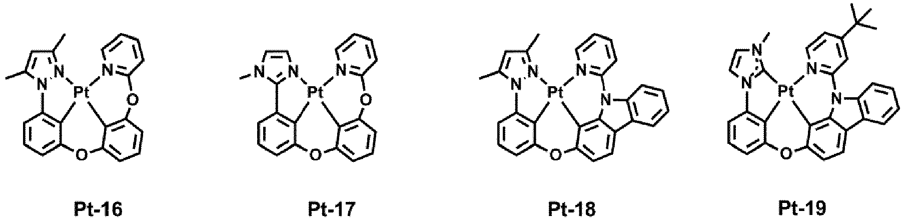

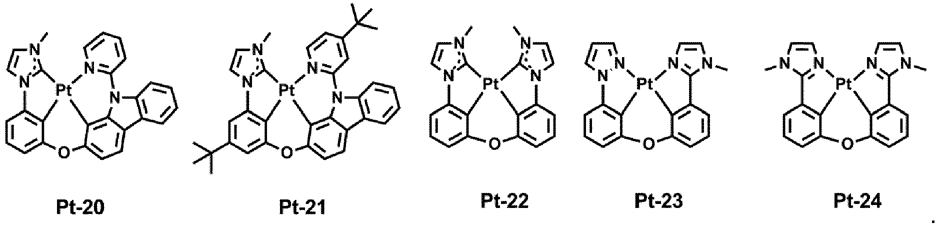

According to one or more embodiments, the fourth compound may be selected from the following compounds, but the present disclosure is not limited thereto: 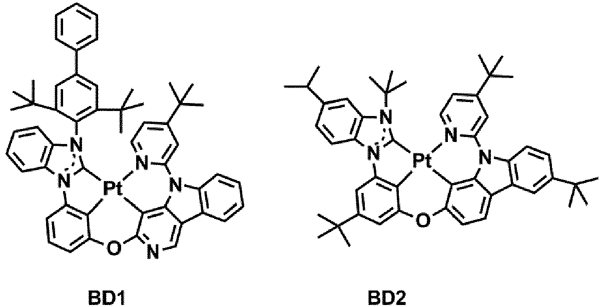 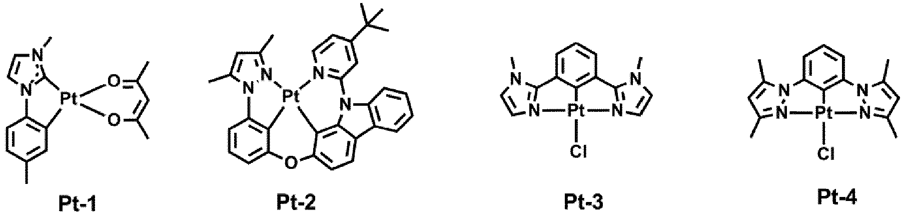 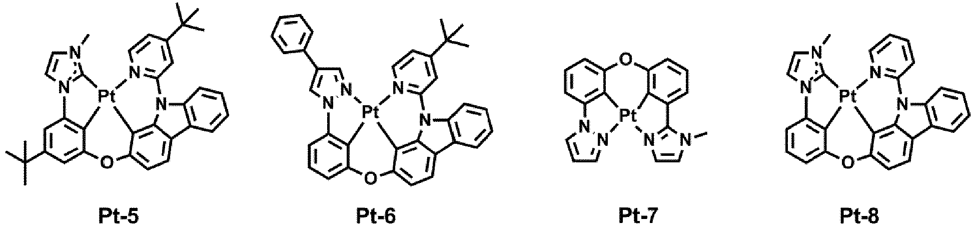 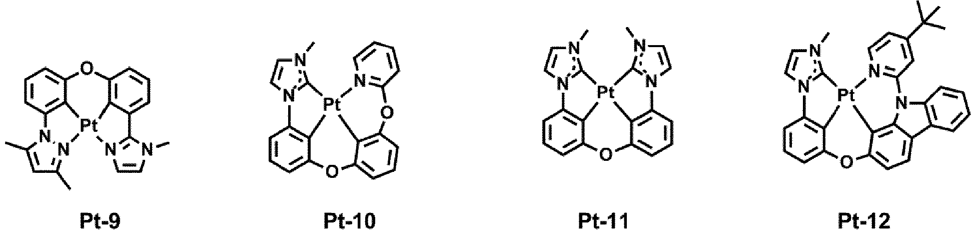 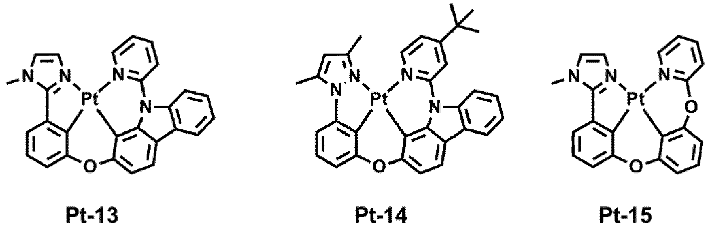 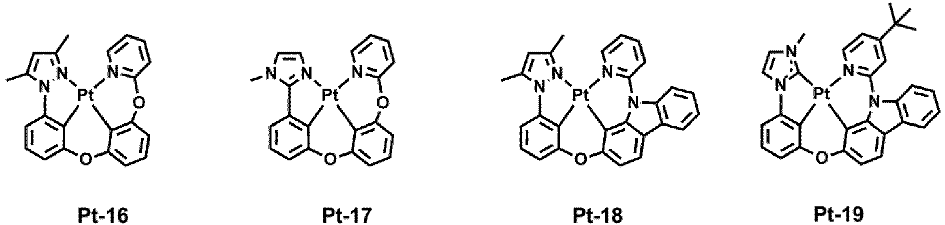 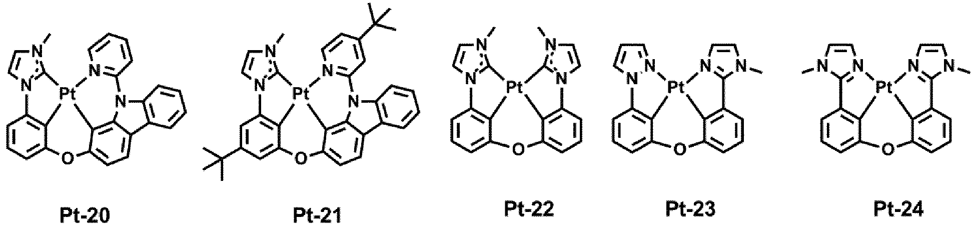 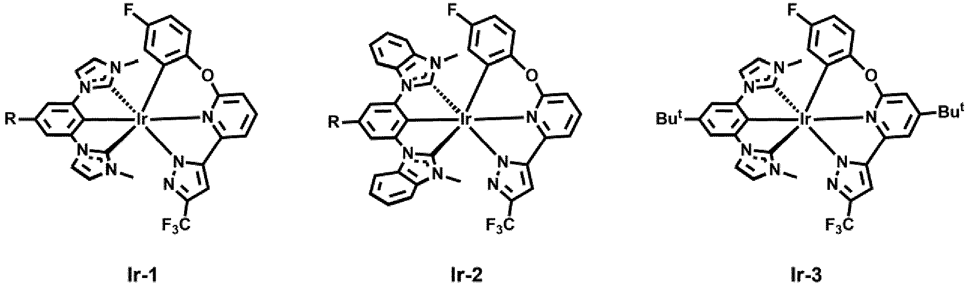 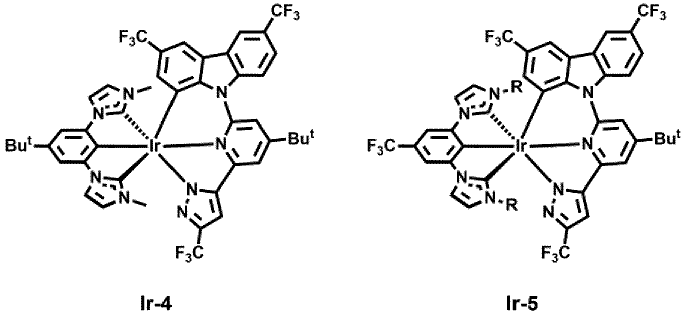 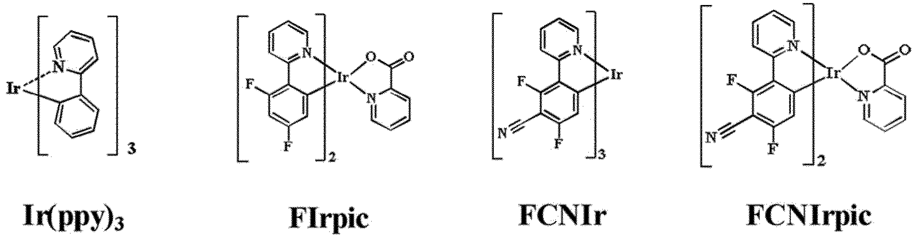 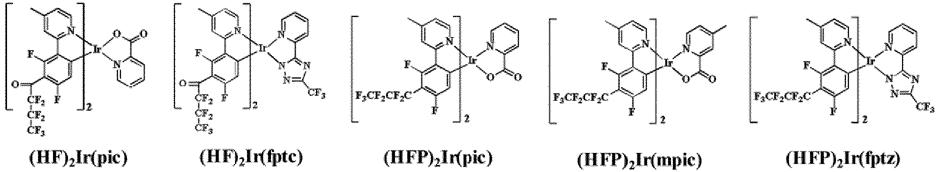 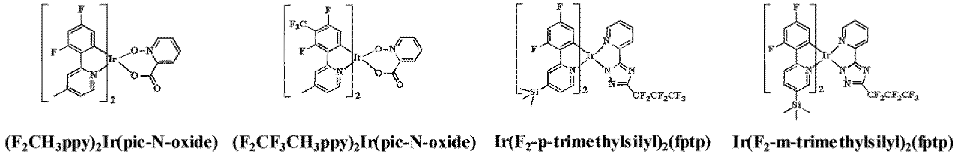 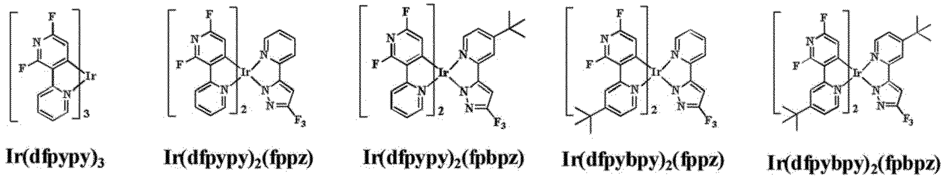 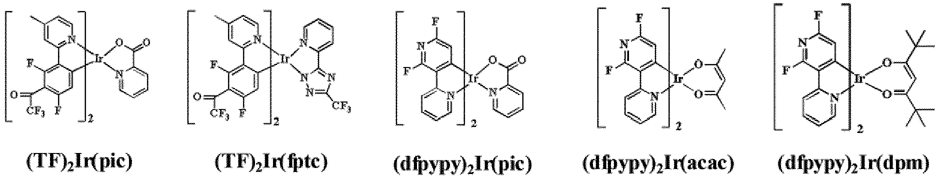 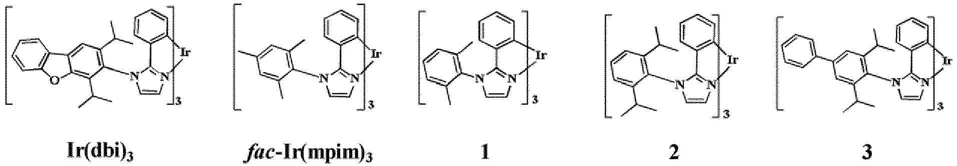 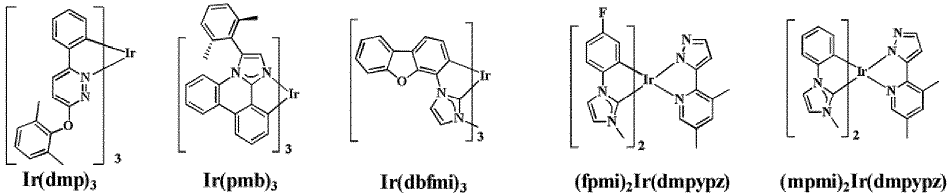 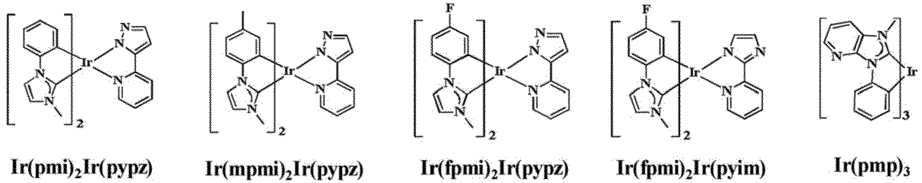 .

According to one or more embodiments, a weight ratio of the third compound to the fourth compound may be in a range of about 100:1 to about 1:100, but the present disclosure is not limited thereto.

The difference between a maximum emission wavelength of light emitted from the third compound and a maximum emission wavelength of light emitted from the fourth compound is in a range of about 0 nanometer (nm) to about 35 nm, for example, about 0 nm to about 20 nm, or for example, about 0 nm to about 10 nm.

According to the invention, the third compound and the fourth compound each emit blue light. In some embodiments, the third compound may emit light having a maximum emission wavelength in a range of about 445 nm to about 470 nm, and the fourth compound may emit light having a maximum emission wavelength in a range of about 450 nm to about 480 nm. The difference between a maximum emission wavelength of light emitted from the third compound and a maximum emission wavelength of light emitted from the fourth compound is in a range of about 0 nm to about 35 nm.

As the organic light-emitting device includes the third compound as a dopant, the color purity of blue light emitted from the emission layer may improve.

In some embodiments, a y coordinate among CIE color-coordinates of light emitted from the emission layer may be in a range of about 0.045 to about 0.06. Accordingly, the organic light-emitting device may emit blue light with high color purity.

The term "CIE color-coordinates," as used herein, refers to x, y, z coordinates of light according to CIE 1931 color space.

When the fourth compound is included as a co-dopant with the third compound in the emission layer, the organic light-emitting device may have long lifespan. In some embodiments, when driven by the same luminance under the same condition of thickness and composition of organic layers, an organic light-emitting device including the fourth compound as an emission layer dopant (hereinafter, referred to as a "first device") may have a longer T95 lifespan than an organic light-emitting device including the third compound (or only the third compound) as an emission layer dopant (hereinafter, referred to as a "second device").

Accordingly, according to one or more embodiments, the organic light-emitting device 10 may satisfy Equation 1: $T 95 \left(C4\right) > T 95 \left(C3\right)$ Equation 1
wherein, in Equation 1,
T95(C3) indicates a T95 lifespan of the organic light-emitting device including the third compound as a single dopant in the emission layer (the second device), and
T95(C4) indicates a T95 lifespan of the organic light-emitting device including the fourth compound as a single dopant in the emission layer (the first device).

In Equation 1, T95(C4) and T95(C3) may each be a T95 lifespan when driven by the same initial luminance.

A content ratio (e.g., weight ratio or mole ratio) of the third compound to the fourth compound in the emission layer may differ depending on the lifespan ratio of the second device to the first device.

In some embodiments, when the T95 lifespan of the second device is smaller than the T95 lifespan of the first device and greater than or equal to 80% of the T95 lifespan of the first device, the content ratio (e.g., weight ratio or mole ratio) of the third compound to the fourth compound may be in a range of about 1:0.01 to about 1:1, or for example, about 1:0.1 to about 1:0.5.

In some embodiments, when the T95 lifespan of the second device is smaller than 80% of the T95 lifespan of the first device and greater than or equal to 50% of the T95 lifespan of the first device, the content ratio (e.g., weight ratio or mole ratio) of the third compound to the fourth compound may be in a range of about 1:0.01 to about 0.01:1, for example, about 1:0.5 to about 1:0.8, or for example, about 0.5:1 to about 0.8:1.

In some embodiments, when the T95 lifespan of the second device is smaller than 50% of the T95 lifespan of the first device, a weight ratio of the third compound to the fourth compound may be in a range of about 1:0.01 to about 0.01:1, or for example, about 0.3:1 to about 0.5:1.

The organic light-emitting device according to one or more embodiments includes both the third compound and the fourth compound as emission layer dopants, thus having color purity improvement by the third compound and lifespan improvement by the fourth compound.

According to one or more embodiments, the organic light-emitting device may have a T95 lifespan of 30 hours or longer, based on the initial luminance of 1,000 nit.

According to one or more embodiments, the total content (e.g., amount or volume) of the third compound and the fourth compound in the emission layer may be generally in a range of about 1 percent by volume (vol%) to about 50 vol%, for example, about 5 vol% to about 50 vol%, or for example, about 10 vol% to about 25 vol%, based on the total volume of the first compound and the second compound, but the present disclosure is not limited thereto.

According to one or more embodiments, the emission layer may include at least one selected from a fluorescent dopant and delayed fluorescent dopant.

According to one or more embodiments, the fluorescent dopant may include a compound represented by Formula 501: 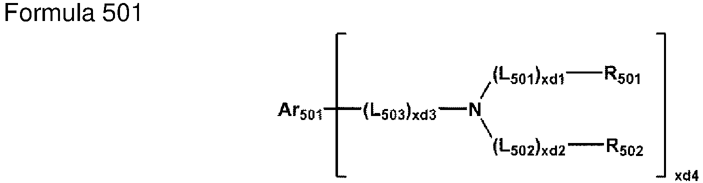
wherein, in Formula 501,
Ar₅₀₁ may be selected from a substituted or unsubstituted C₅-C₆₀ carbocyclic group (or a substituted or unsubstituted C₄-C₆₀ carbocyclic group) and a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₀) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ *(e.g.* C₆-C₃₀) aryloxy group, a substituted or unsubstituted C₆-C₆₀ *(e.g.* C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer from 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In some embodiments, in Formula 501, Ar₅₀₁ may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In an embodiment, in Formula 501, L₅₀₁ and L₅₀₃ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In an embodiment, in Formula 501, R₅₀₁ and R₅₀₂ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but the present disclosure is not limited thereto.

In some embodiments, the fluorescent dopant may be selected from Compounds FD1 to FD22:

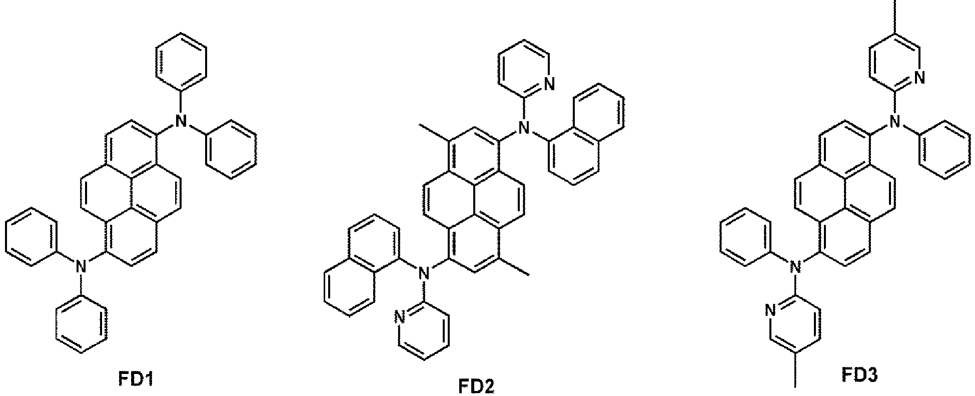

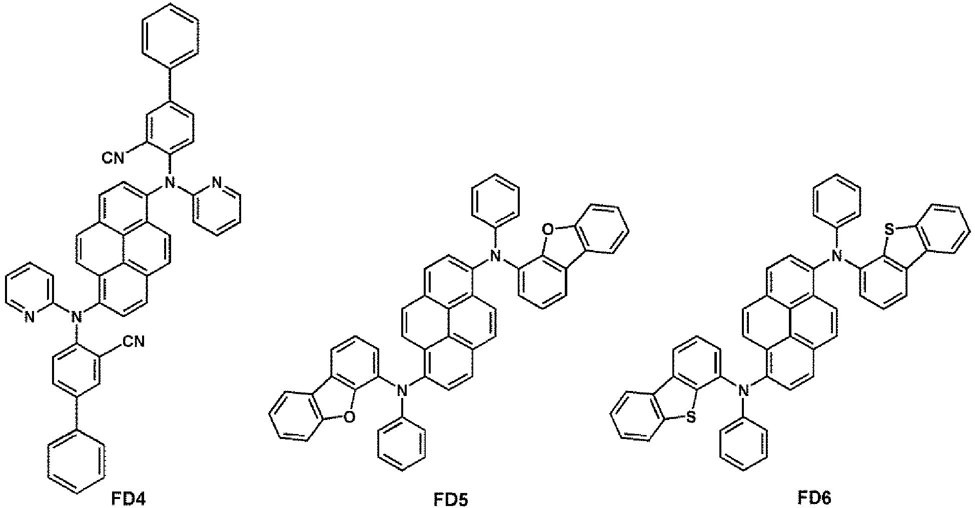

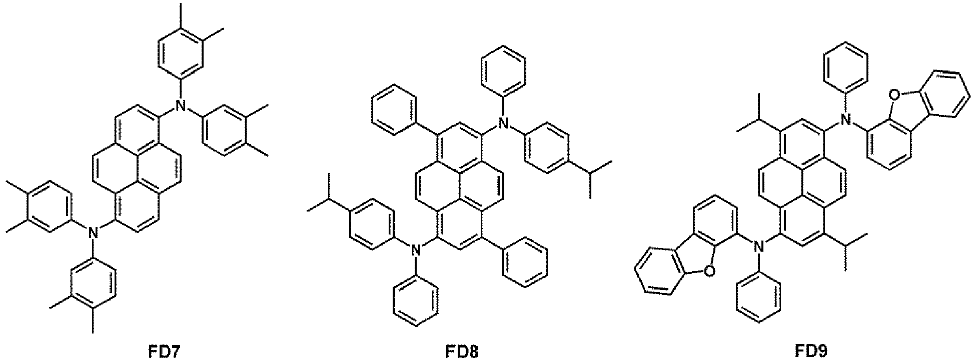

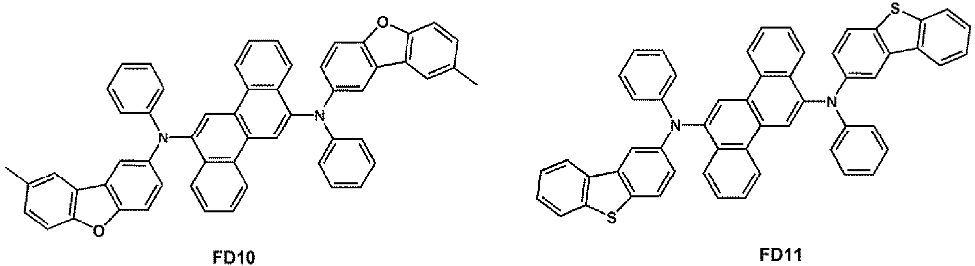

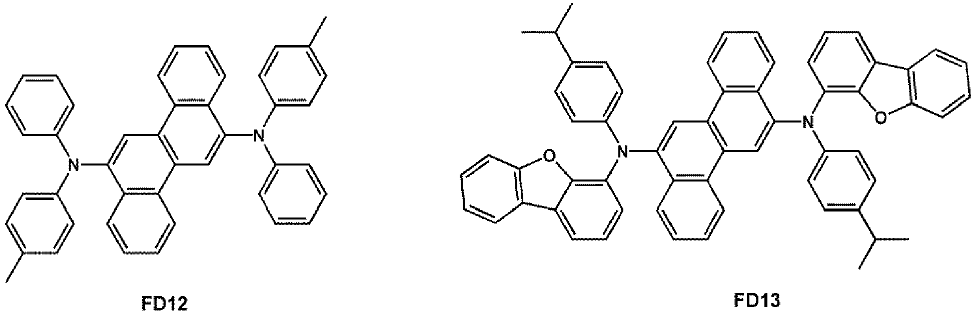

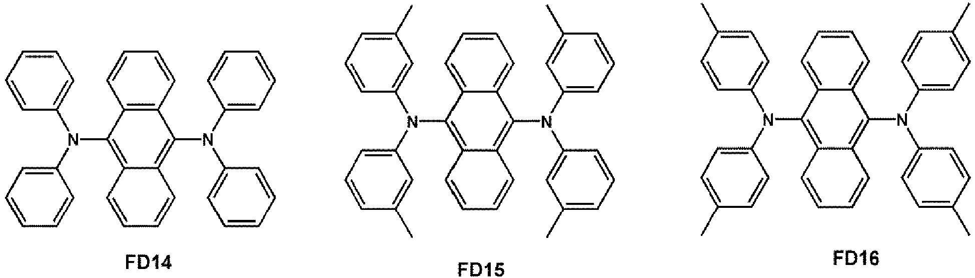

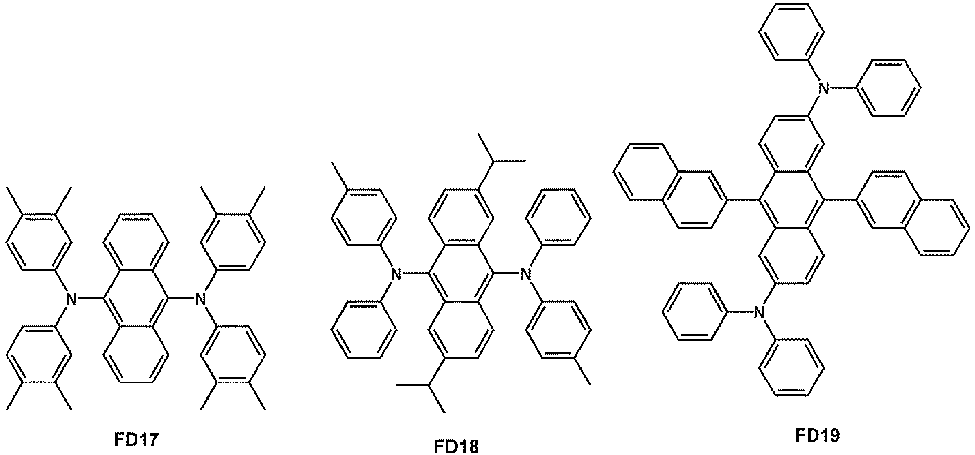

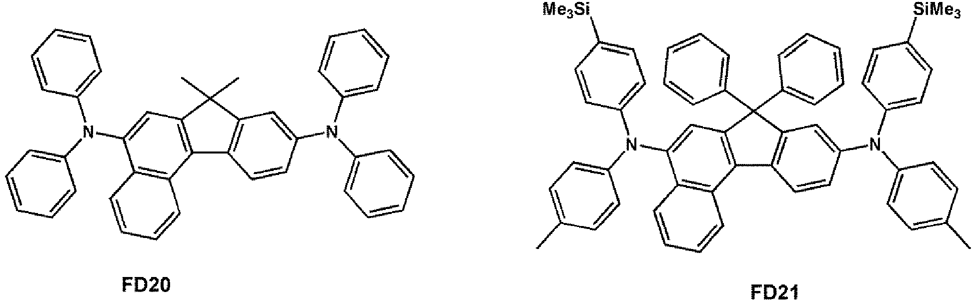

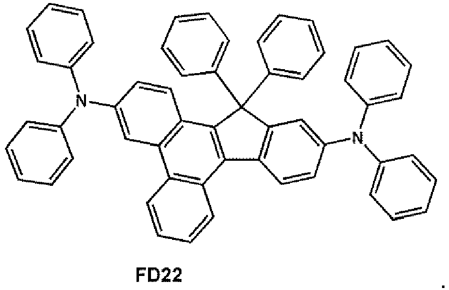

In some embodiments, the fluorescent dopant may be selected from the following compounds, but the present disclosure is not limited thereto:

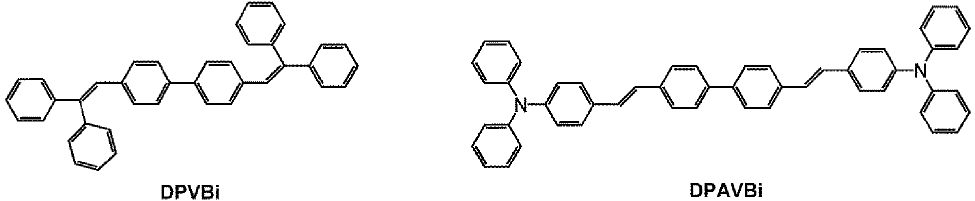

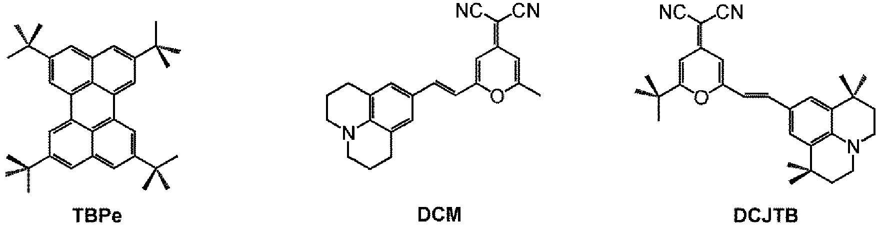

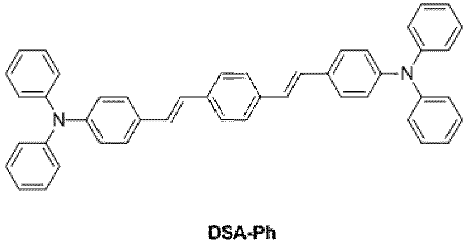

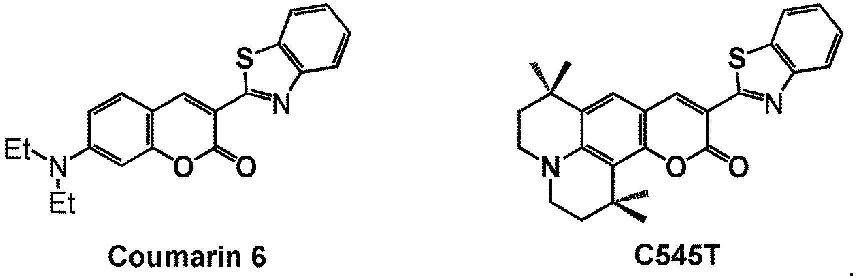

The delayed fluorescent dopant may satisfy Equation 3:
${ΔE}_{ST} = \left|S1\left(D\right)-T1\left(D\right)\right| \leq 0.5 eV$ Equation 3
wherein, in Equation 3,
S1(D) indicates a lowest excited singlet energy level of the dopant, and
T1(D) indicates a lowest excited triplet energy level of the dopant.

A delayed fluorescent dopant that satisfies Equation 3 may emit thermal activated delayed fluorescence (TADF) even at room temperature. In some embodiments, the delayed fluorescent dopant may satisfy | S1(D) - T1(D) | ≤ 0.2 eV, but the present disclosure is not limited thereto.

In addition, the delayed fluorescent dopant may not include a metal atom. For example, the delayed fluorescent dopant is distinguished from a phosphorescent dopant including a metal atom. In some embodiments, the delayed fluorescent dopant may not include iridium (Ir), platinum (Pt), palladium (Pd), osmium (Os), titanium (Ti), zirconium (Zr), hafnium (Hf), europium (Eu), terbium (Tb), rhodium (Rh), and thulium (Tm) and be distinguished from the phosphorescent dopant.

The emission layer includes a first emission layer and a second emission layer, and the first emission layer may be between the first electrode and the second emission layer. The first emission layer includes the first compound, the second compound, and a first dopant, and the second emission layer includes the first compound, the second compound, and a second dopant, wherein the first dopant is any one selected from the third compound and the fourth compound, the second dopant is different from the first dopant and is the other one of the third compound and the fourth compound.

As described above, the third compound and the fourth compound are each included in different emission layers.

In some embodiments, the third compound may be included in a first emission layer, and the fourth compound may be included in a second emission layer, or the fourth compound may be included in a first emission layer, and the third compound may be included in a second emission layer.

The first emission layer and the second emission layer may be in direct contact (e.g., physical contact) with each other, or another organic layer may be between the first emission layer and the second emission layer.

According to one or more embodiments, the first emission layer and the second emission layer may be in direct contact (e.g., physical contact) with each other.

According to one or more embodiments, the organic light-emitting device may further include a charge-generation layer between the first emission layer and the second emission layer and including an n-type charge-generation layer and a p-type charge-generation layer.

One emission layer of the first emission layer and the second emission layer may be physically in contact with the charge-generation layer, and another layer may be between the one emission layer and the charge-generation layer. In some embodiments, an electron transport region may be between a first emission layer, from among the two emission layers, and the charge-generation layer, the first emission layer being adjacent to a first electrode. In some embodiments, a hole transport region may be between a second emission layer, from among the two emission layers, and a charge-generation layer, the second emission layer being adjacent to a second electrode.

The charge-generation layer may generate charge or separate holes and electrons to serve as a cathode for an emission unit of two adjacent emission units by injecting electrons and as an anode for the other emission unit by injecting holes. The charge-generation layer may serve to separate adjacent emission units while not being directly coupled to an electrode.

The term "n-type," as used herein, refers to n-type semiconductor properties, e.g., properties capable of injection and transport of electrons. The term "p-type," as used herein, refers to p-type semiconductor properties, e.g., properties capable of injection and transport of holes.

According to one or more embodiments, the first dopant may be included in a range of about 1 vol% to about 30 vol%, based on the total volume of the first emission layer, and the second dopant may be included in a range of about 1 vol% to about 30 vol%, based on the total volume of the second emission layer, but the present disclosure is not limited thereto.

The thicknesses of the first emission layer and the second emission layer may each be in a range of about 10 Å to about 1,000 Å, and in some embodiments, about 100 Å to about 500 Å or about 150 Å to about 500 Å. When the thicknesses of the first emission layer and the second emission layer are within any of the foregoing ranges, luminescence characteristics may be improved without a substantial increase in driving voltage.

According to one or more embodiments, a thickness ratio of the first emission layer to the second emission layer may be in a range of about 1:9 to about 9:1. In some embodiments, the thickness ratio may be in a range of about 2:8 to about 8:2, or for example, about 3:7 to about 7:3.

In some embodiments, a difference between a maximum emission wavelength of light emitted from the first emission layer and a maximum emission wavelength of light emitted from the second emission layer may be in a range of about 0 nm to about 35 nm, for example, about 0 nm to about 20 nm, or for example, about 0 nm to about 10 nm.

The first emission layer and the second emission layer each emit blue light. The difference between a maximum emission wavelength of light emitted from the first emission layer and a maximum emission wavelength of light emitted from the second emission layer is in a range of about 0 nm to about 35 nm, for example, about 0 nm to about 20 nm, or for example, about 0 nm to about 10 nm.

In some embodiments, the emission layer may include a first emission layer, a second emission layer and a third emission layer, and the first emission layer may be between the first electrode and the second emission layer, and the second emission layer may be between the first electrode and the third emission layer. In this embodiment, the first emission layer may include the first compound, the second compound, and a first dopant, the second emission layer may include the first compound, the second compound, and a second dopant, and the third emission layer may include the first compound, the second compound, and a third dopant, wherein the first dopant and the third dopant may be any one selected from the third compound and the fourth compound, the second dopant may be different from the first dopant and the third dopant and be the other one of the third compound and the fourth compound.

As described above, the third compound and the fourth compound are each included in different emission layers. In some embodiments, the third compound may be included in a first emission layer and a third emission layer, and the fourth compound may be included in a second emission layer, or the fourth compound may be included in a first emission layer and a third emission layer, and the third compound may be included in a second emission layer.

When the first emission layer and the third emission layer includes the third compound, the third compound included in the first emission layer may be identical to or different from the third compound included in the third emission layer. For example, the first dopant and the third dopant may each independently be an organometallic compound represented by Formula 1, and the first dopant and the third dopant may be identical to or different from each other.

When the first emission layer and the third emission layer includes the fourth compound, the fourth compound included in the first emission layer may be identical to or different from the fourth compound included in the third emission layer.

The first emission layer, the second emission layer, and the third emission layer may be in direct contact (e.g., physical contact) with each other, or another organic layer may be between the first emission layer and the second emission layer and/or the second emission layer and the third emission layer.

According to one or more embodiments, the first emission layer, the second emission layer, and the third emission layer may be in direct contact (e.g., physical contact) with one another. For example, the second emission layer may be at an interface between the first emission layer and the third emission layer.

According to one or more embodiments, the organic light-emitting device may further include a charge-generation layer between two adjacent emission layers from among the first emission layer, the second emission layer, and the third emission layer and including an n-type charge-generation layer and a p-type charge-generation layer. The term "adjacent," as used herein, refers to an arrangement relationship of layers arranged to be closest to each other from among the described layers. In some embodiments, the term "two adjacent emission layers," as used herein, refers to an arrangement relationship of two emission layers arranged to be closest to each other from among a plurality of emission layers.

One emission layer of the two emission layers closest to each other may be physically in contact with the charge-generation layer, and another layer may be between the one emission layer and the charge-generation layer. In some embodiments, an electron transport region may be between an emission layer, from among the two adjacent emission layers, adjacent to a first electrode and the charge-generation layer. In some embodiments, a hole transport region may be between an emission layer, from among the two adjacent emission layers, adjacent to a second electrode and a charge-generation layer.

According to one or more embodiments, the first dopant may be included in a range of about 1 vol% to about 30 vol%, based on the total volume of the first emission layer, the second dopant may be included in a range of about 1 vol% to about 30 vol%, based on the total volume of the second emission layer, and the third dopant may be included in a range of about 1 vol% to about 30 vol%, based on the total volume of the third emission layer, but the present disclosure is not limited thereto.

The thicknesses of the first emission layer, the second emission layer, and the third emission layer may each independently be in a range of about 10 Å to about 1,000 Å, and in some embodiments, about 100 Å to about 500 Å or about 150 Å to about 500 Å. When the thicknesses of the first emission layer, the second emission layer, and the third emission layer are within any of the foregoing ranges, luminescence characteristics may be improved without a substantial increase in driving voltage.

According to one or more embodiments, the first emission layer, the second emission layer, and the third emission layer may each emit blue light. In this embodiment, a difference between a maximum emission wavelength of light emitted from the first emission layer, a maximum emission wavelength of light emitted from the second emission layer, and a maximum emission wavelength of light emitted from the third emission layer may be in a range of about 0 nm to about 35 nm, for example, about 0 nm to about 20 nm, or for example, about 0 nm to about 10 nm.

When the organic light-emitting device 10 is a full color organic light-emitting device, the emission layer may be patterned into a red emission layer, a green emission layer, or a blue emission layer, according to a sub-pixel. In one or more embodiments, the emission layer may have a stacked structure. The stacked structure may include two or more layers selected from a red emission layer, a green emission layer, and a blue emission layer. The two or more layers may be in direct contact (e.g., physical contact) with each other. In some embodiments, the two or more layers may be separated from each other. In one or more embodiments, the emission layer may include two or more materials. The two or more materials may include a red light-emitting material, a green light-emitting material, or a blue light-emitting material. The two or more materials may be mixed with each other in a single layer. The two or more materials mixed with each other in the single layer may emit white light.

The total thickness of the emission layer may be in a range of about 20 Å to about 1,000 Å, for example, about 200 Å to about 600 Å, or for example, about 150 Å to about 500 Å. When the thickness of the emission layer is within any of the foregoing ranges, improved luminescence characteristics may be obtained without a substantial increase in driving voltage.

The organic layer 150 may further include a hole transport region between the first electrode 110 and the emission layer and an electron transport region between the emission layer and the second electrode 190.

### Hole transport region in organic layer 150

The hole transport region may have i) a single-layered structure including (or consisting of) a single layer including (or consisting of) a single material, ii) a single-layered structure including (or consisting of) a single layer including a plurality of different materials, or iii) a multi-layered structure having a plurality of layers including a plurality of different materials.

The hole transport region may include at least one layer selected from a hole injection layer, a hole transport layer, an emission auxiliary layer, and an electron blocking layer.

For example, the hole transport region may have a single-layered structure including a single layer including a plurality of different materials or a multi-layered structure, e.g., a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein layers of each structure are sequentially stacked on the first electrode 110 in each stated order, but the present disclosure is not limited thereto.

The hole transport region may include at least one selected from m-MTDATA, TDATA, 2-TNATA, NPB (NPD), β-NPB, TPD, a spiro-TPD, a spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented by Formula 201, and a compound represented by Formula 202: 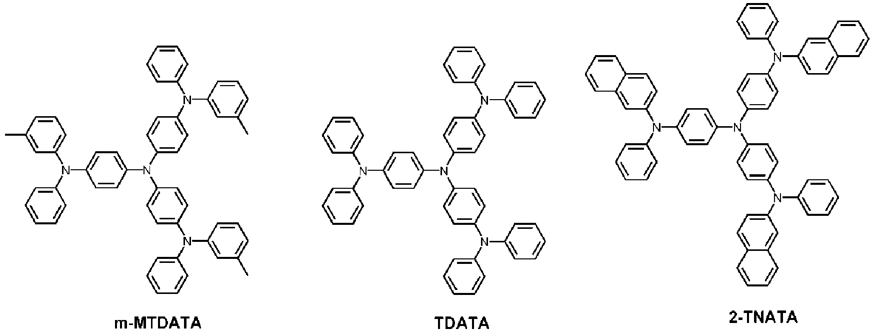 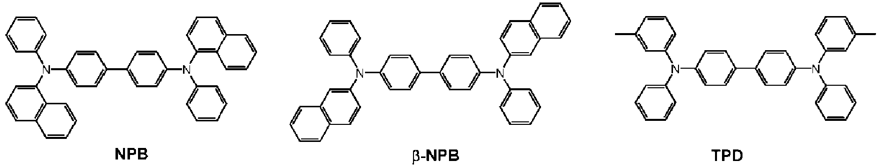 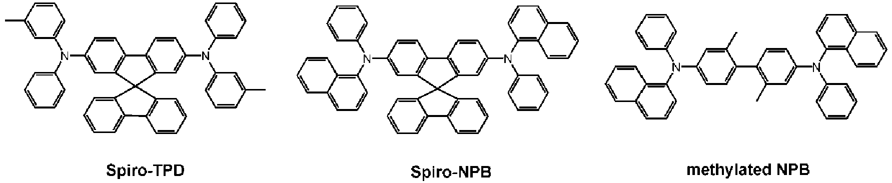 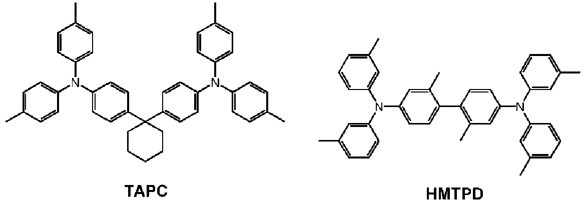 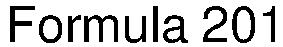 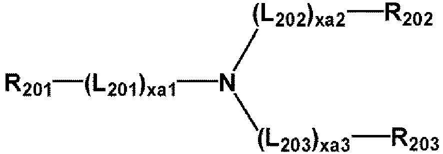 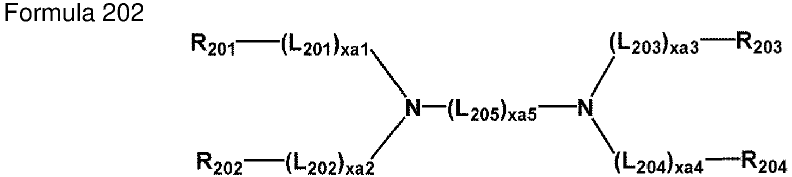
wherein, in Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g*. C₆-C₃₂) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g*. C₅-C₃₂) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₂) aryl group, a substituted or unsubstituted C₆-C₆₀ *(e.g.* C₆-C₃₂) aryloxy group, a substituted or unsubstituted C₆-C₆₀ *(e.g.* C₆-C₃₂) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group.

In some embodiments, in Formula 202, R₂₀₁ and R₂₀₂ may optionally be bound via a single bond, a dimethyl-methylene group, or a diphenyl-methylene group, and R₂₀₃ and R₂₀₄ may optionally be bound via a single bond, a dimethyl-methylene group, or a diphenyl-methylene group.

In some embodiments, in Formulae 201 and 202,
L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may respectively be understood by referring to the descriptions of Q₃₁ to Q₃₃ provided herein.

In one or more embodiments, in Formula 201, at least one selected from R₂₀₁ to R₂₀₃ may be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but the present disclosure is not limited thereto.

In one or more embodiments, in Formula 202, i) R₂₀₁ and R₂₀₂ may be bound via a single bond, and/or ii) R₂₀₃ and R₂₀₄ may be bound via a single bond.

In one or more embodiments, in Formula 202, at least one selected from R₂₀₁ to R₂₀₄ may be selected from:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but the present disclosure is not limited thereto.

The compound represented by Formula 201 may be represented by Formula 201-1:

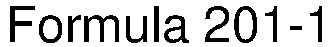

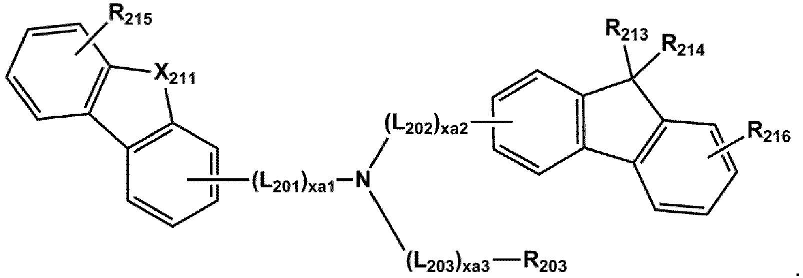

In some embodiments, the compound represented by Formula 201 may be represented by Formula 201-2, but the present disclosure is not limited thereto:

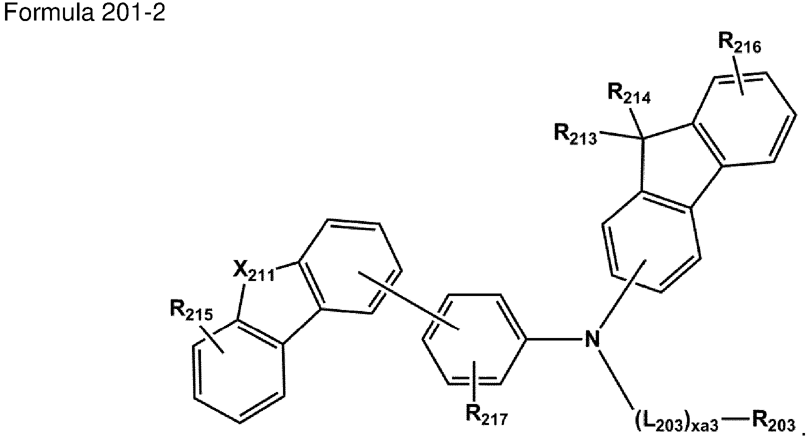

In some embodiments, the compound represented by Formula 201 may be represented by Formula 201-2(1), but the present disclosure is not limited thereto:

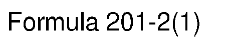

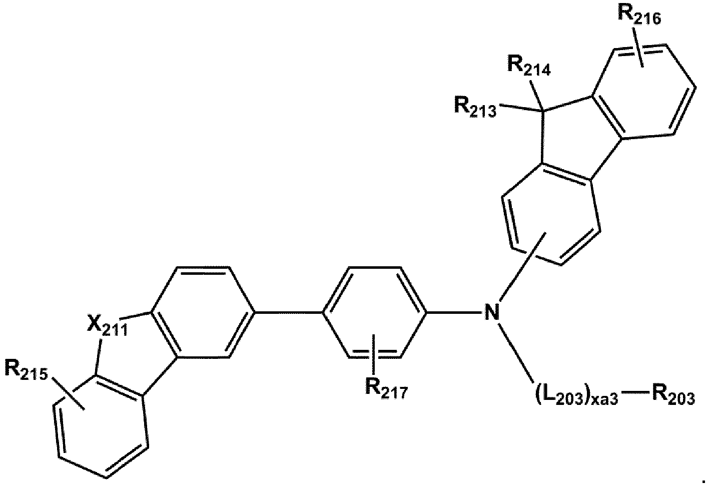

The compound represented by Formula 201 may be represented by Formula 201A:

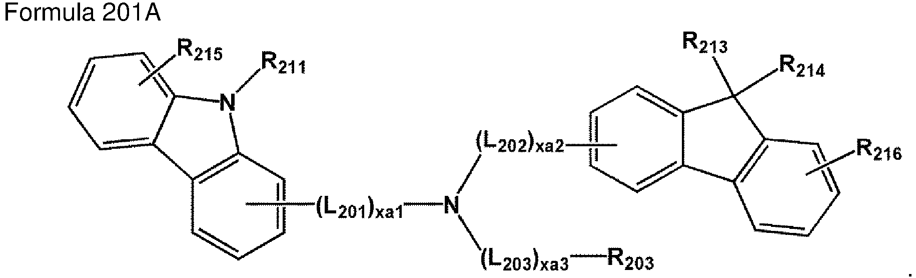

In some embodiments, the compound represented by Formula 201 may be represented by Formula 201A(1), but the present disclosure is not limited thereto:

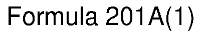

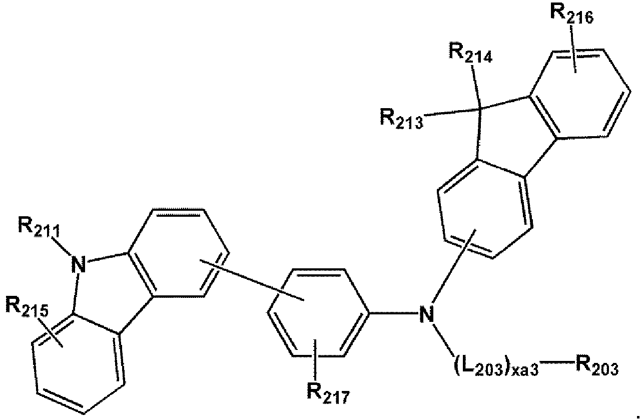

In some embodiments, the compound represented by Formula 201 may be represented by Formula 201A-1, but the present disclosure is not limited thereto:

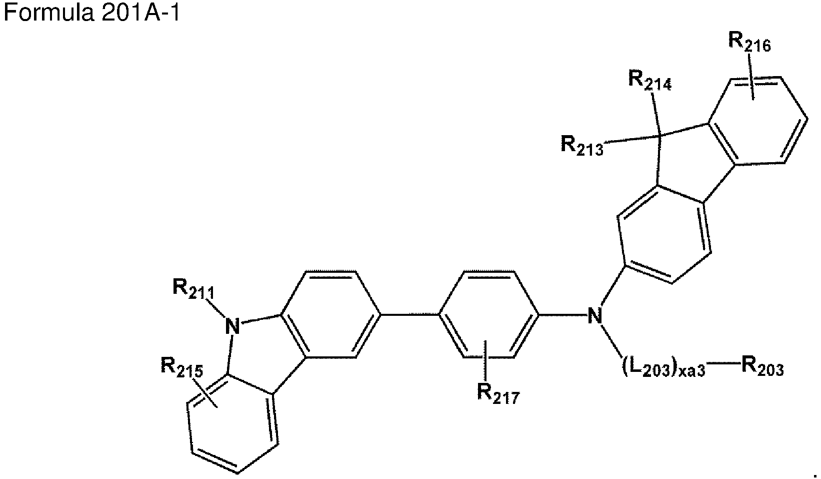

The compound represented by Formula 202 may be represented by Formula 202-1:

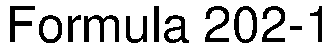

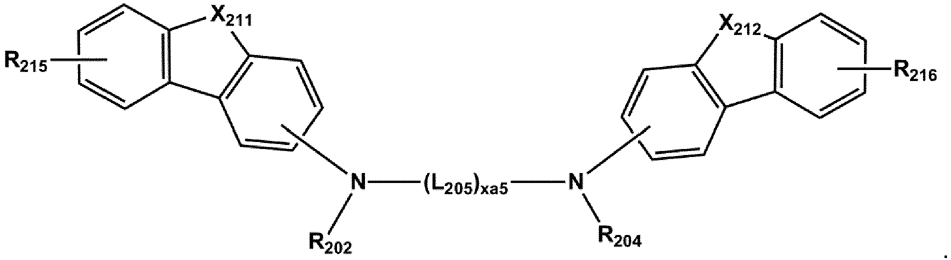

In one or more embodiments, the compound represented by Formula 202 may be represented by Formula 202-1 (1):

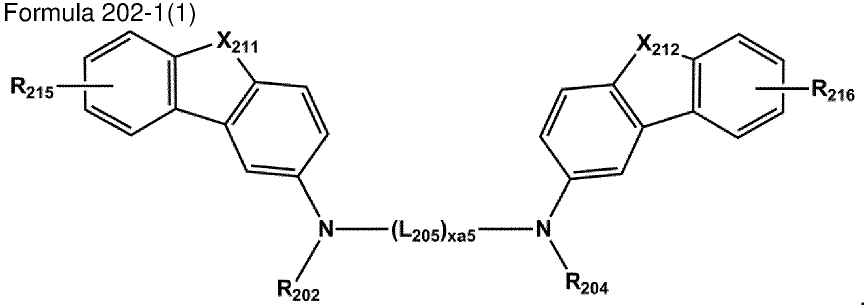

In some embodiments, the compound represented by Formula 202 may be represented by Formula 202A:

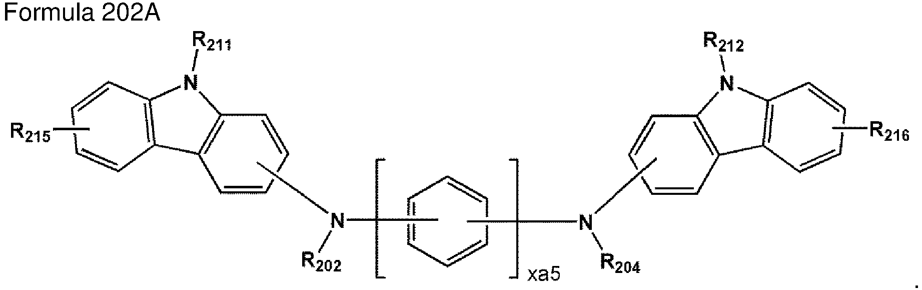

In some embodiments, the compound represented by Formula 202 may be represented by Formula 202A-1:

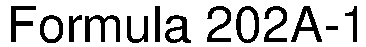

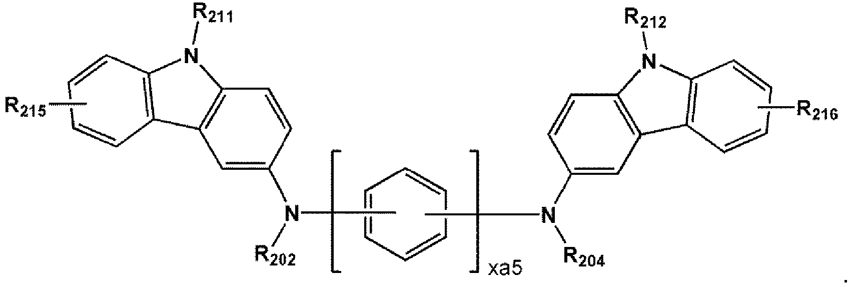

In Formulae 201-1, 201-2, 201-2(1), 201A, 201A(1), 201A-1, 202-1, 202-1(1), 202A, and 202A-1,
L₂₀₁ to L₂₀₃, xa1 to xa3, xa5, and R₂₀₂ to R₂₀₄ may respectively be understood by referring to the descriptions of L₂₀₁ to L₂₀₃, xa1 to xa3, xa5, and R₂₀₂ to R₂₀₄ provided herein,
L₂₀₅ may be selected from a phenylene group and a fluorenylene group,
X₂₁₁ may be selected from O, S, and N(R₂₁₁),
X₂₁₂ may be selected from O, S, and N(R₂₁₂),
R₂₁₁ and R₂₁₂ may each be understood by referring to the description of R₂₀₃ provided herein, and
R₂₁₃ to R₂₁₇ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT48, but the present disclosure is not limited thereto:

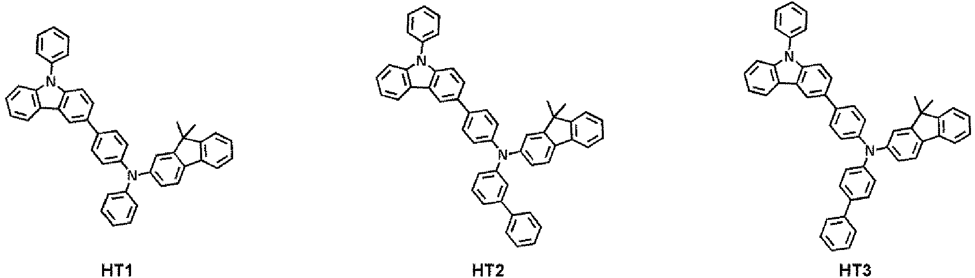

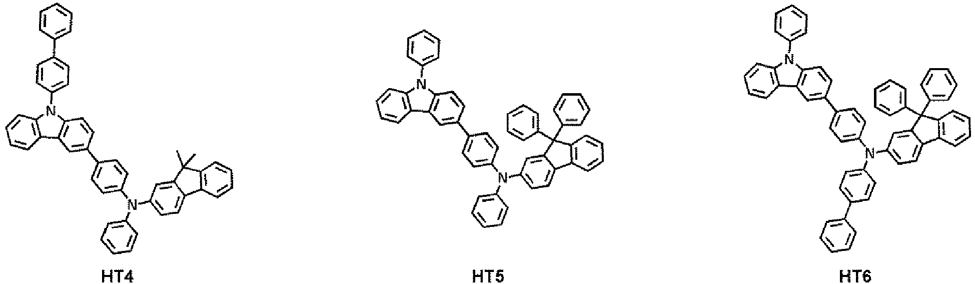

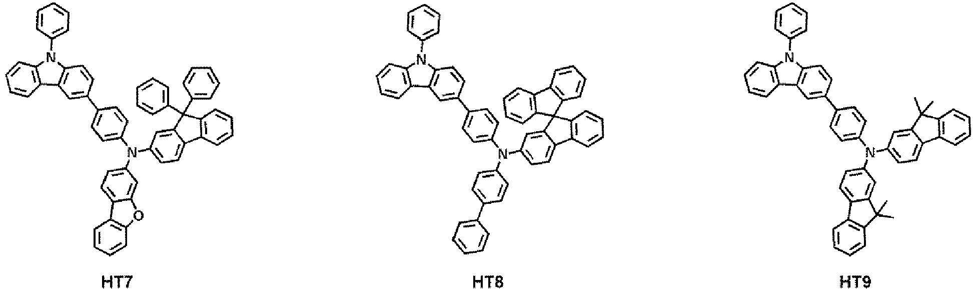

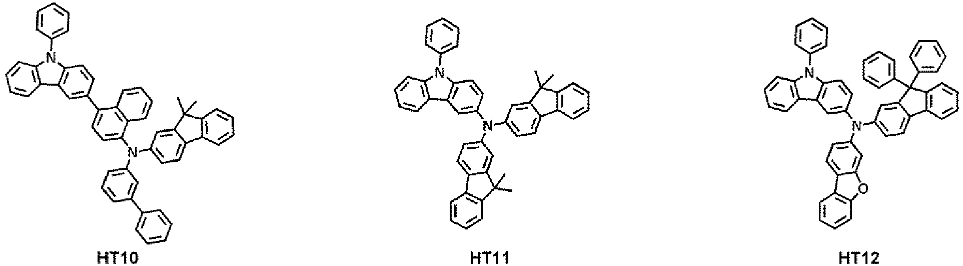

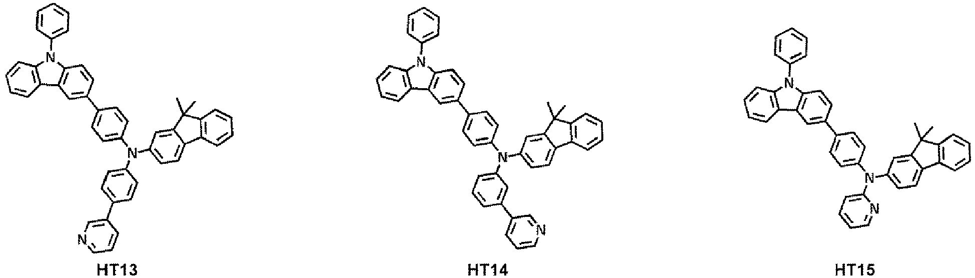

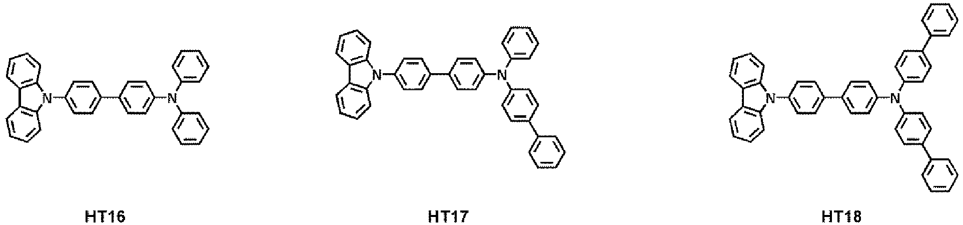

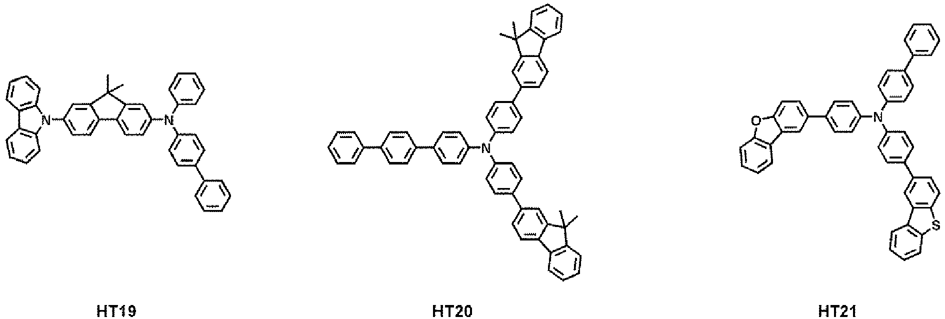

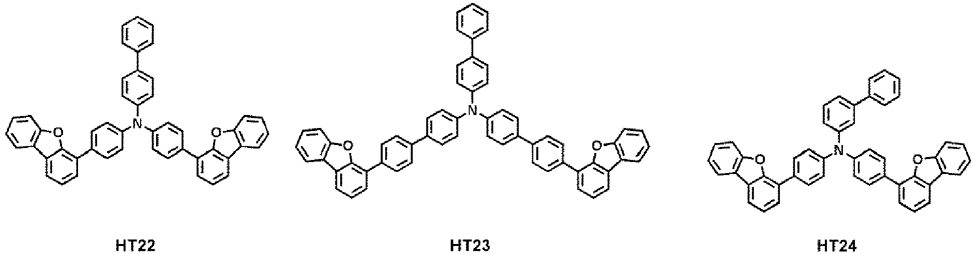

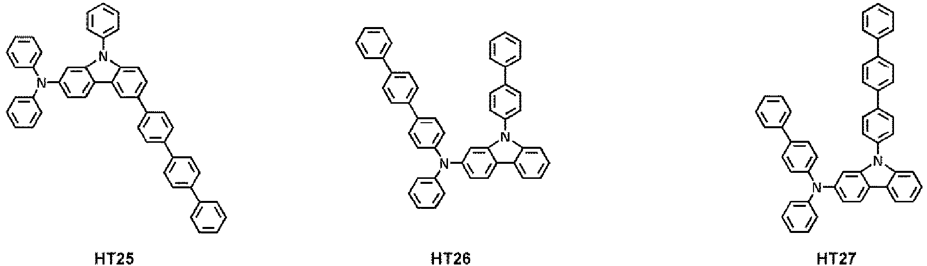

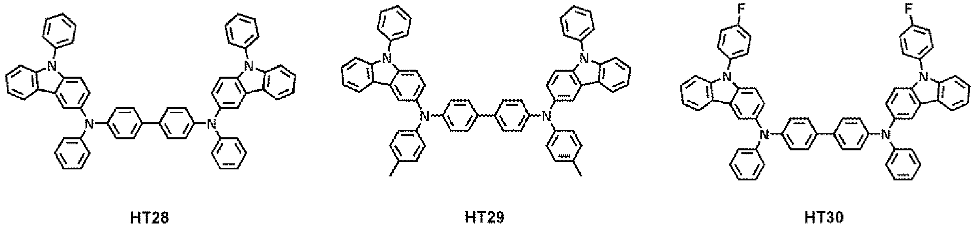

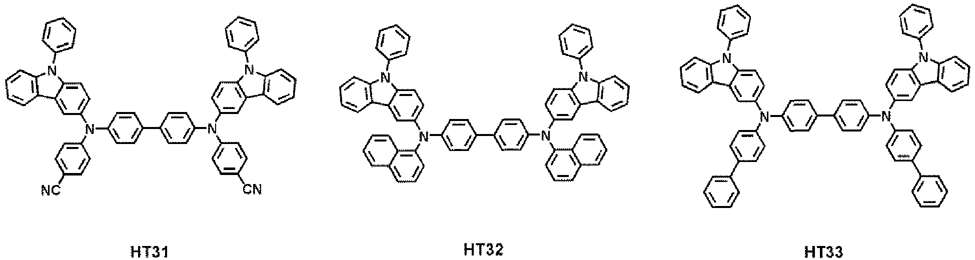

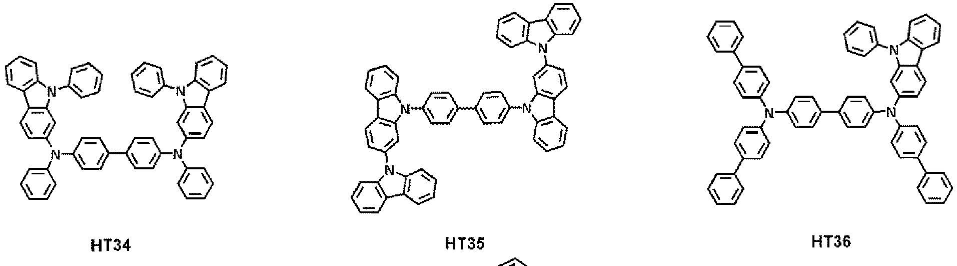

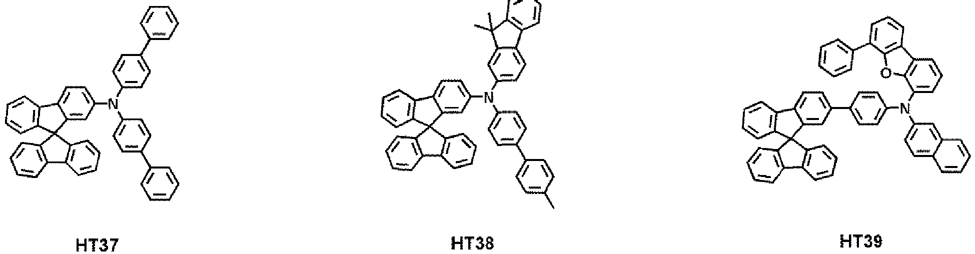

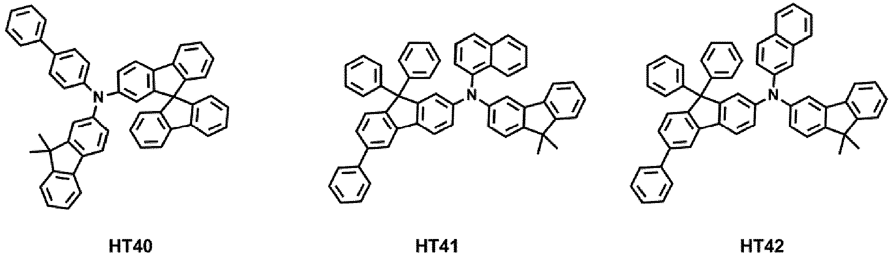

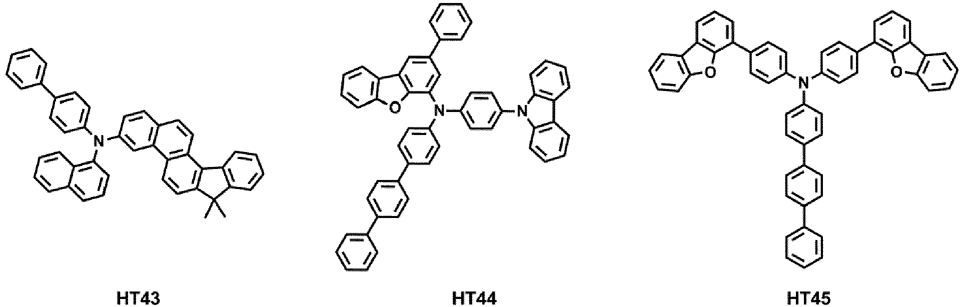

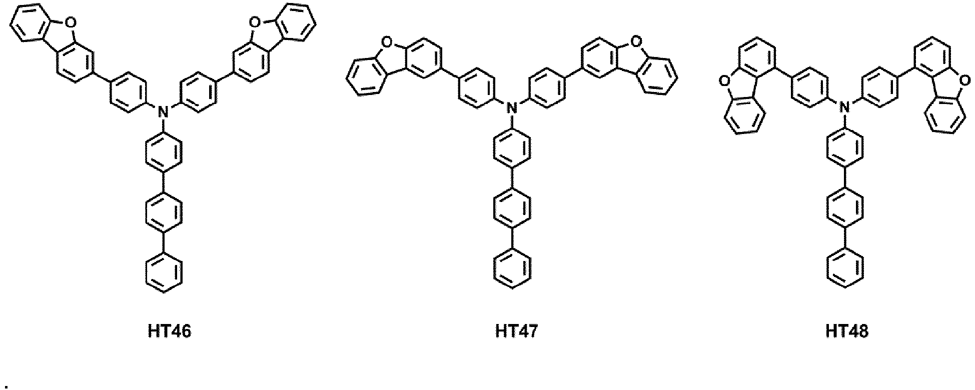

The thickness of the hole transport region may be in a range of about 100 (Angstroms) Å to about 10,000 Å, and in some embodiments, about 100 Å to about 7,000 Å, about 100 Å to about 5,000 Å, or about 100 Å to about 1,000 Å. When the hole transport region includes at least one selected from a hole injection layer and a hole transport layer, the thickness of the hole injection layer may be in a range of about 100 Å to about 9,000 Å, and in some embodiments, about 100 Å to about 7,000 Å, about 100 Å to about 5,000 Å, about 100 Å to about 3,000 Å, about 100 Å to about 2,000 Å, about 100 Å to about 1,000 Å or about 100 Å to about 300 Å, and the thickness of the hole transport layer may be in a range of about 50 Å to about 3,000 Å, and in some embodiments, about 100 Å to about 1,500 Å. When the thicknesses of the hole transport region, the hole injection layer, and the hole transport layer are within any of the foregoing ranges, excellent hole transport characteristics may be obtained without a substantial increase in driving voltage.

The emission auxiliary layer may increase light emission efficiency by compensating for an optical resonance distance according to the wavelength of light emitted by an emission layer. The electron blocking layer may reduce or eliminate the flow of electrons from an electron transport region. The emission auxiliary layer and the electron blocking layer may include the aforementioned materials.

### p-dopant

The hole transport region may include a charge generating material as well as the aforementioned materials, to improve conductive properties of the hole transport region. The charge generating material may be substantially homogeneously or nonhomogeneously dispersed in the hole transport region.

The charge generating material may include, for example, a p-dopant.

In some embodiments, the lowest unoccupied molecular orbital (LUMO) energy level of the p-dopant may be -3.5 eV or less.

The p-dopant may include at least one selected from a quinone derivative, a metal oxide, and a cyano group-containing compound, but the present disclosure is not limited thereto.

In some embodiments, the p-dopant may include:
a quinone derivative, such as tetracyanoquinodimethane (TCNQ) or 2,3,5,6-tetrafluoro-7,7,8,8-tetracyanoquinodimethane (F4-TCNQ);
a metal oxide, such as tungsten oxide or molybdenum oxide;
1,4,5,8,9,12-hexaazatriphenylene-hexacarbonitrile (HAT-CN);
F6-TNAP, Compound 201, and Compound 202; and
a compound represented by Formula 221,
but the present disclosure is not limited thereto: 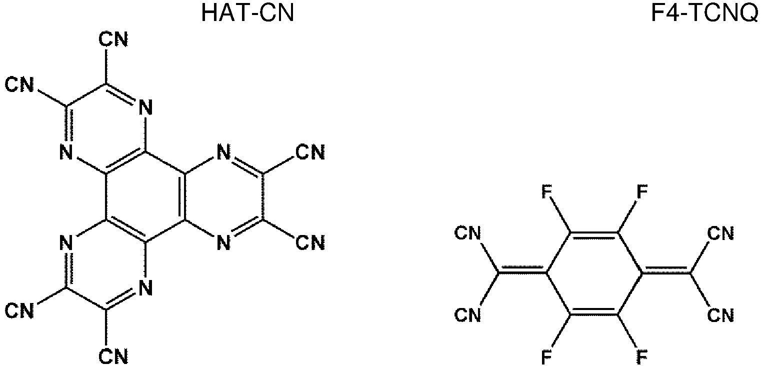 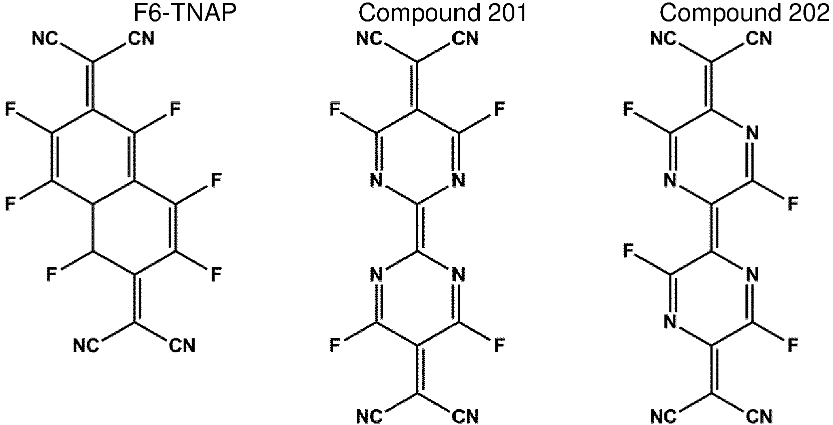 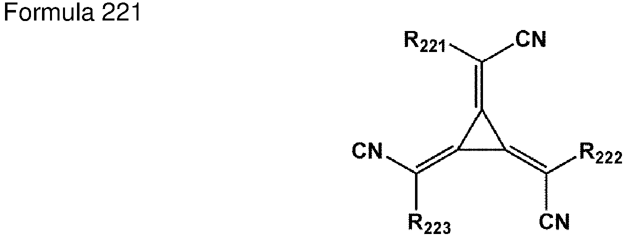
wherein, in Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₂) aryl group, a substituted or unsubstituted C₁-C₆₀ (e.g. C₁-C₂₀) heteroaryl group, a substituted or unsubstituted monovalent non-aromatic condensed polycyclic group, and a substituted or unsubstituted monovalent non-aromatic condensed heteropolycyclic group, wherein at least one selected from R₂₂₁ to R₂₂₃ may include at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Electron transport region in organic layer 150

The electron transport region may have i) a single-layered structure including (or consisting of) a single layer including (or consisting of) a single material, ii) a single-layered structure including (or consisting of) a single layer including a plurality of different materials, or iii) a multi-layered structure each having a plurality of layers, each having a plurality of different materials.

The electron transport region may include at least one selected from a buffer layer, a hole blocking layer, an electron control layer, an electron transport layer, and an electron injection layer, but the present disclosure is not limited thereto.

In some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein layers of each structure are sequentially stacked on the emission layer in each stated order, but the present disclosure is not limited thereto.

The electron transport region (for example, the buffer layer, the hole blocking layer, the electron control layer, or the electron transport layer in the electron transport region) may include a metal-free compound including at least one π electron-depleted nitrogen-containing ring.

The term "π electron-depleted nitrogen-containing ring," as used herein, refers to a C₁-C₆₀ (e.g. a C₁-C₃₀) heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which at least two 5-membered to 7-membered heteromonocyclic groups, each having at least one *-N=*' moiety, are condensed (e.g., combined together), or iii) a heteropolycyclic group in which at least one selected from a 5-membered to 7-membered heteromonocyclic group, each having at least one *-N=*' moiety, is condensed with (e.g., combined with) at least one C₅-C₆₀ (*e.g*. a C₅-C₃₀) carbocyclic group (or at least one C₄-C₆₀ (*e*.*g*. C₄-C₃₀) carbocyclic group).

Examples of the π electron-depleted nitrogen-containing ring may include imidazole, pyrazole, thiazole, isothiazole, oxazole, isoxazole, pyridine, pyrazine, pyrimidine, pyridazine, indazole, purine, quinoline, isoquinoline, benzoquinoline, phthalazine, naphthyridine, quinoxaline, quinazoline, cinnoline, phenanthridine, acridine, phenanthroline, phenazine, benzimidazole, isobenzothiazole, benzoxazole, isobenzoxazole, triazole, tetrazole, oxadiazole, triazine, thiadiazole, imidazopyridine, imidazopyrimidine, and azacarbazole, but the present disclosure is not limited thereto.

In some embodiments, the electron transport region may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ may be selected from a substituted or unsubstituted C₅-C₆₀ carbocyclic group and a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
wherein Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In some embodiments, at least one selected from Ar₆₀₁(s) in the number of xe11 and R₆₀₁(s) in the number of xe21 may include the π electron-depleted nitrogen-containing ring.

For example, Ar₆₀₁ may be a substituted or unsubstituted C₅-C₃₀ carbocyclic group or a substituted or unsubstituted C₁-C₂₀ heterocyclic group, but embodiments are not limited thereto.

In some embodiments, in Formula 601, ring Ar₆₀₁ may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or greater, at least two Ar₆₀₁(s) may be bound via a single bond.

In one or more embodiments, Ar₆₀₁ in Formula 601 may be an anthracene group.

In some embodiments, the compound represented by Formula 601 may be represented by Formula 601-1: 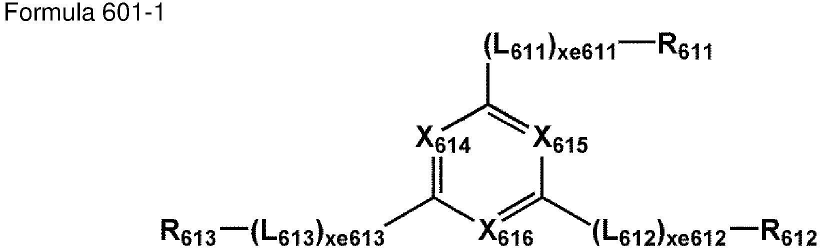
wherein, in Formula 601-1,
X₆₁₄ may be N or C(R₆₁₄), X₆₁₅ may be N or C(R₆₁₅), X₆₁₆ may be N or C(R₆₁₆), at least one selected from X₆₁₄ to X₆₁₆ may be N,
L₆₁₁ to L₆₁₃ may each independently be understood by referring to the description of L₆₀₁ provided herein,
xe611 to xe613 may each independently be understood by referring to the description of xe1 provided herein,
R₆₁₁ to R₆₁₃ may each independently be understood by referring to the description of R₆₀₁ provided herein, and
R₆₁₄ to R₆₁₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

In some embodiments, in Formulae 601 and 601-1, L₆₀₁ and L₆₁₁ to L₆₁₃ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but the present disclosure is not limited thereto.

In one or more embodiments, in Formulae 601 and 601-1, xe1 and xe611 to xe613 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂).

In one or more embodiments, in Formulae 601 and 601-1, R₆₀₁ and R₆₁₁ to R₆₁₃ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may respectively be understood by referring to the descriptions of Q₆₀₁ and Q₆₀₂ provided herein.

The electron transport region may include at least one compound selected from Compounds ET1 to ET39, but the present disclosure is not limited thereto:

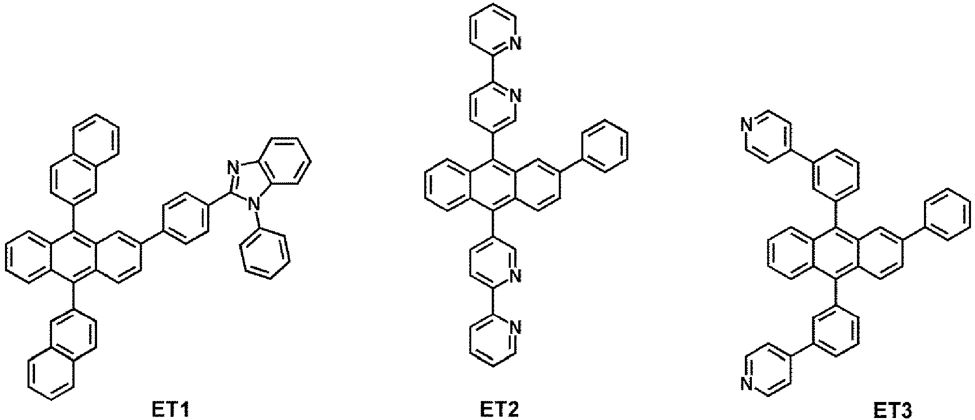

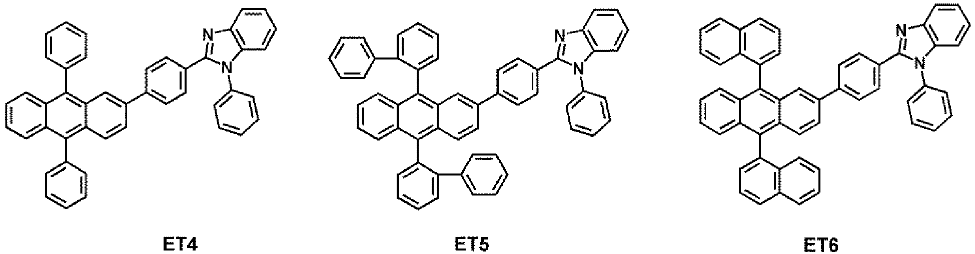

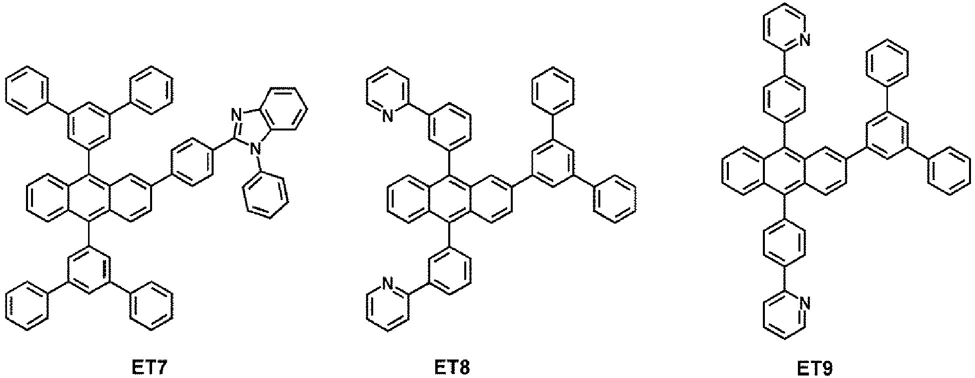

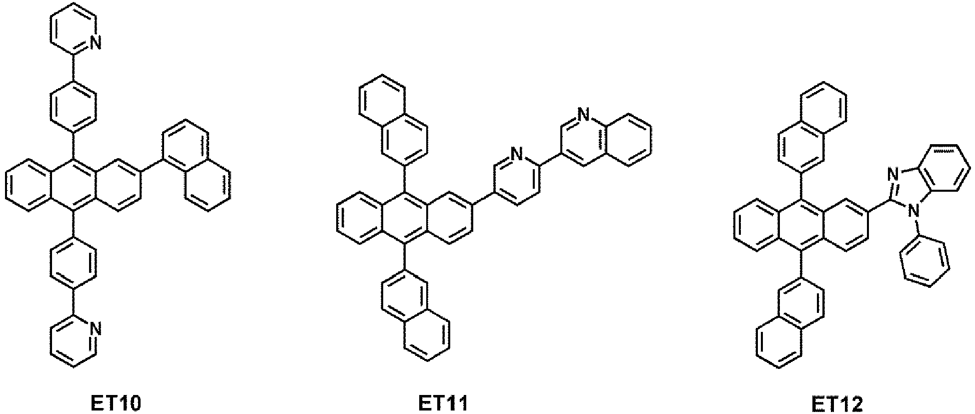

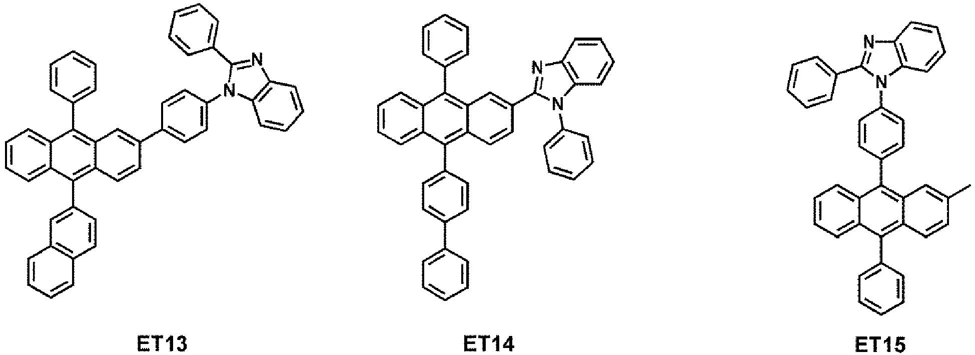

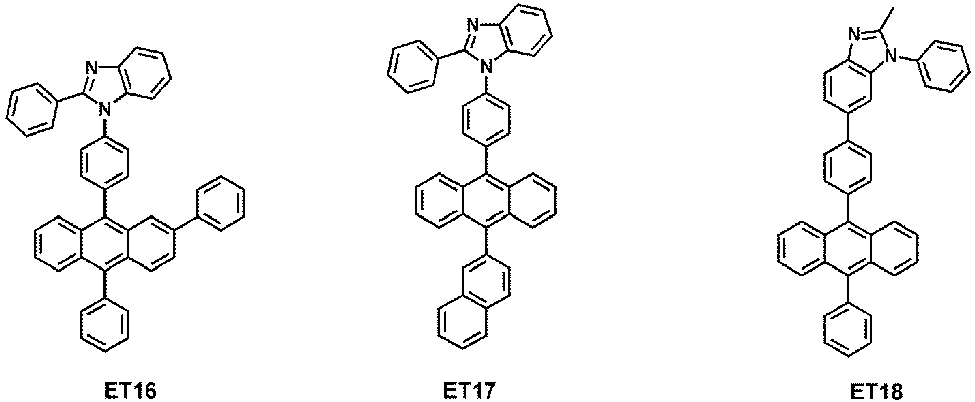

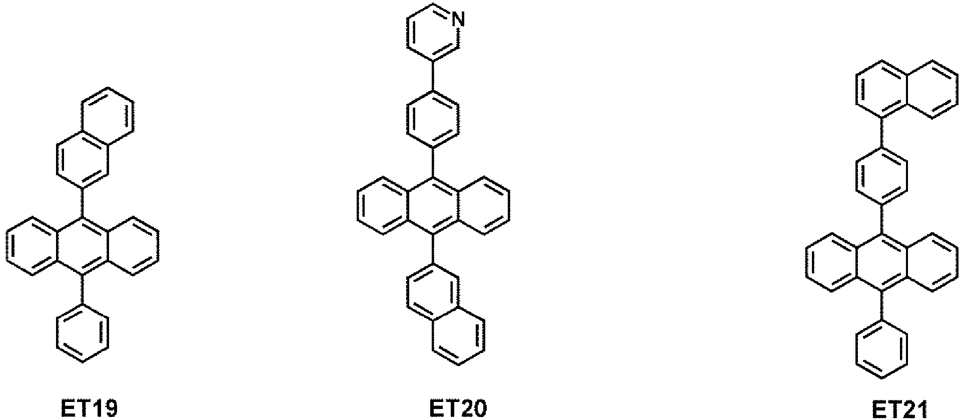

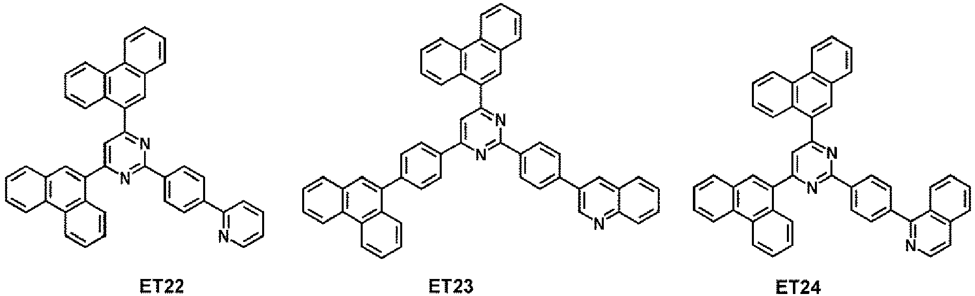

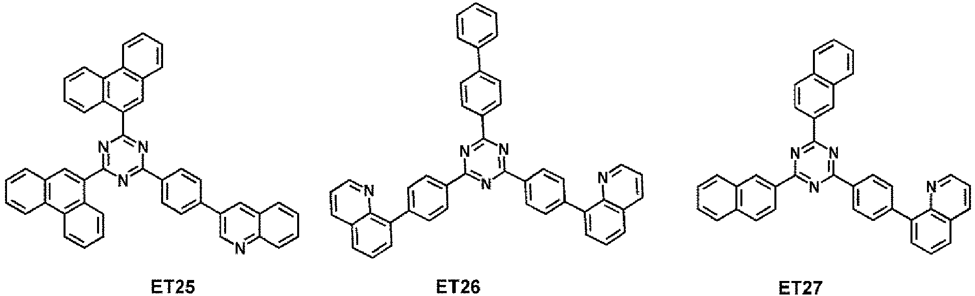

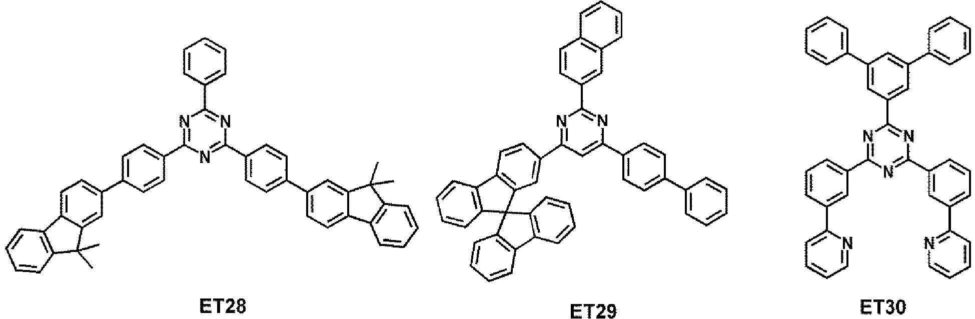

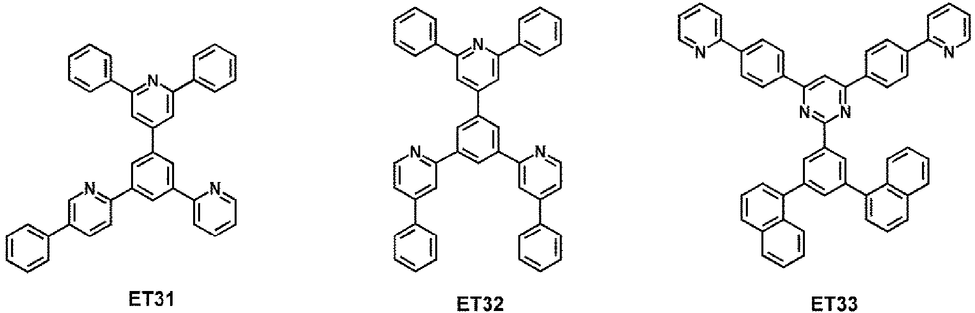

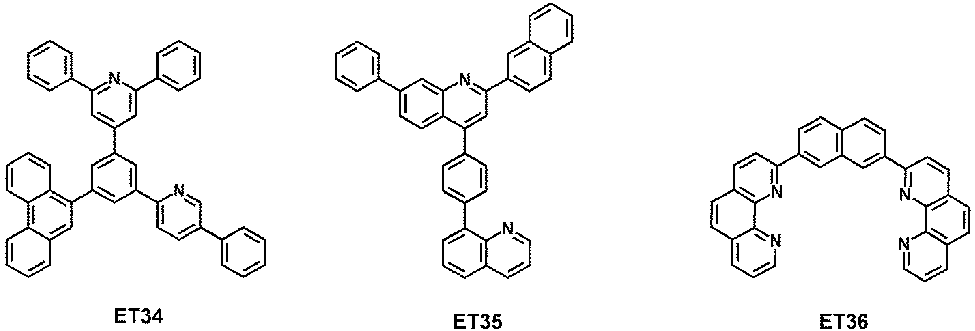

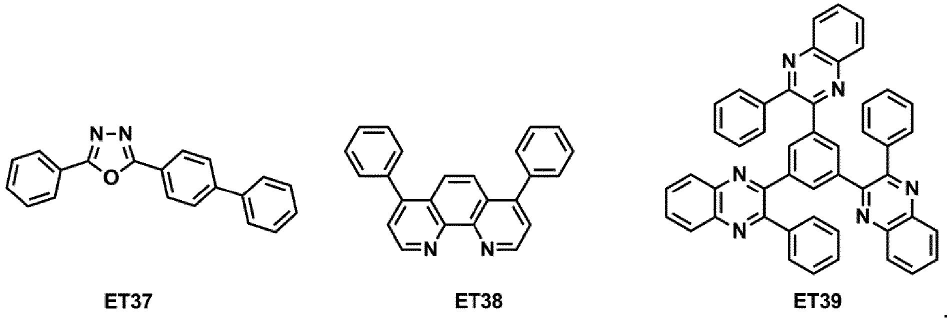

In some embodiments, the electron transport region may include at least one compound selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), NTAZ, 2,2',2"-(1,3,5-benzinetriyl)-tris(1-phenyl-1-H-benzimidazole) (TPBi), 4,4'-bis(4,6-diphenyl-1,3,5-triazin-2-yl)biphenyl (BTB), and 1,3,5-tris(3-pyridyl-3-phenyl)benzene (TmPyPB):

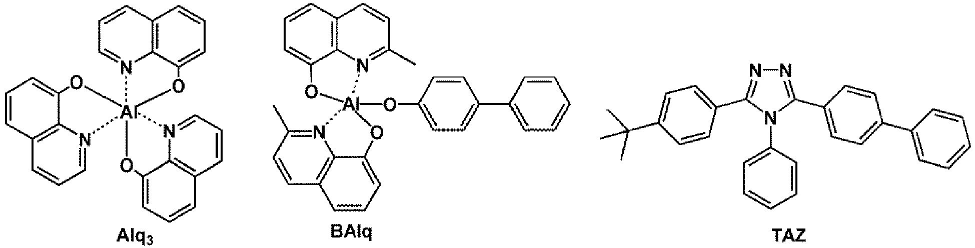

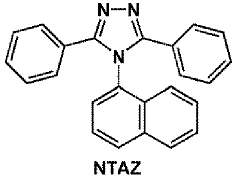

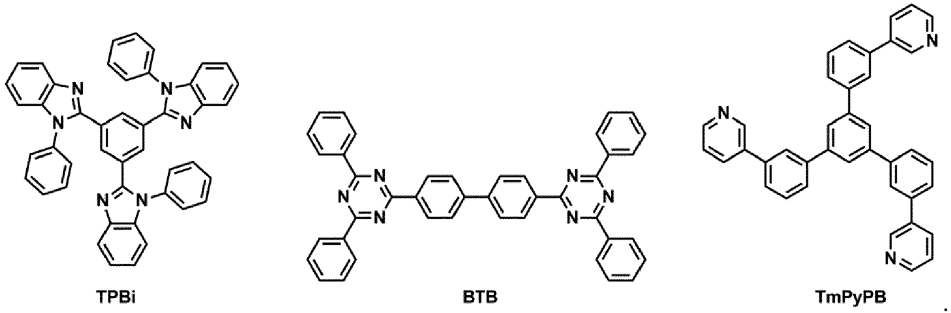

The thicknesses of the buffer layer, the hole blocking layer, or the electron control layer may each independently be in a range of about 10 Å to about 1,000 Å, and in some embodiments, about 20 Å to about 700 Å, about 20 Å to about 500 Å, about 20 Å to about 400 Å, about 30 Å to about 400 Å or about 30 Å to about 300 Å. When the thicknesses of the buffer layer, the hole blocking layer or the electron control layer are within any of the foregoing ranges, excellent hole blocking characteristics or excellent electron controlling characteristics may be obtained without a substantial increase in driving voltage.

The thickness of the electron transport layer may be in a range of about 100 Å to about 3,000 Å, and in some embodiments, about 100 Å to about 700 Å, about 100 Å to about 600 Å, about 150 Å to about 600 Å, about 150 Å to about 500 Å or about 200 Å to about 400 Å. When the thickness of the electron transport layer is within any of the foregoing ranges, excellent electron transport characteristics may be obtained without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkaline earth metal complex. The alkali metal complex may include a metal ion selected from a lithium (Li) ion, a sodium (Na) ion, a potassium (K) ion, a rubidium (Rb) ion, and a cesium (Cs) ion. The alkaline earth metal complex may include a metal ion selected from a beryllium (Be) ion, a magnesium (Mg) ion, a calcium (Ca) ion, a strontium (Sr) ion, and a barium (Ba) ion. Each ligand coordinated with the metal ion of the alkali metal complex and the alkaline earth metal complex may independently be selected from hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, and cyclopentadiene, but the present disclosure is not limited thereto.

For example, the metal-containing material may include a Li complex. The Li complex may include, e.g., Compound ET-D1 (LiQ) or Compound ET-D2:

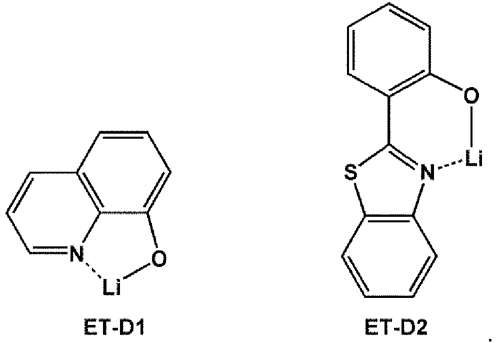

The electron transport region may include an electron injection layer that facilitates injection of electrons from the second electrode 190. The electron injection layer may be in direct contact (e.g., physical contact) with the second electrode 190.

The electron injection layer may have i) a single-layered structure including (or consisting of) a single layer including (or consisting of) a single material, ii) a single-layered structure including (or consisting of) a single layer including a plurality of different materials, or iii) a multi-layered structure having a plurality of layers, each including a plurality of different materials.

The electron injection layer may include an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

The alkali metal may be selected from Li, Na, K, Rb, and Cs. In some embodiments, the alkali metal may be Li, Na, or Cs. In one or more embodiments, the alkali metal may be Li or Cs, but the present disclosure is not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth metal compound, and the rare earth metal compound may each independently be selected from oxides and halides (e.g., fluorides, chlorides, bromides, or iodides) of the alkali metal, the alkaline earth metal, and the rare earth metal, respectively.

The alkali metal compound may be selected from alkali metal oxides, such as Li₂O, Cs₂O, or K₂O, and alkali metal halides, such as LiF, NaF, CsF, KF, Lil, Nal, Csl, or KI. In some embodiments, the alkali metal compound may be selected from LiF, Li₂O, NaF, Lil, Nal, Csl, and KI, but the present disclosure is not limited thereto.

The alkaline earth-metal compound may be selected from alkaline earth-metal compounds, such as BaO, SrO, CaO, BaₓSr₁₋ₓO (wherein 0<x<1), and BaₓCa₁₋ₓO (wherein 0<x<1). In some embodiments, the alkaline earth metal compound may be selected from BaO, SrO, and CaO, but the present disclosure is not limited thereto.

The rare earth metal compound may be selected from YbF₃, ScF₃, Sc₂O₃, Y₂O₃, Ce₂O₃, GdF₃, and TbF₃. In some embodiments, the rare earth metal compound may be selected from YbF₃, ScF₃, TbF₃, YbI₃, ScI₃, and TbI₃, but the present disclosure is not limited thereto.

The alkali metal complex, the alkaline earth metal complex, and the rare earth metal complex may each include ions of the above-described alkali metal, alkaline earth metal, and rare earth metal. Each ligand coordinated with the metal ion of the alkali metal complex, the alkaline earth metal complex, and the rare earth metal complex may independently be selected from hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, and cyclopentadiene, but the present disclosure is not limited thereto.

The electron injection layer may include (or consist of) an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In some embodiments, the electron injection layer may further include an organic material. When the electron injection layer further includes an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or a combination thereof may be homogeneously or non-homogeneously dispersed in a matrix including the organic material.

The thickness of the electron injection layer may be in a range of about 1 Å to about 100 Å, and in some embodiments, about 3 Å to about 90 Å or about 3 Å to about 20 Å. When the thickness of the electron injection layer is within any of the foregoing ranges, excellent electron injection characteristics may be obtained without a substantial increase in driving voltage.

### n-dopant

The electron transport region may include a charge generating material such as an n-dopant as well as the aforementioned materials, to improve conductive properties of the hole transport region. The charge generating material may be substantially homogeneously or non-homogeneously dispersed in the electron transport region.

The n-dopant may be a molecule and/or a neutral radical having a highest occupied molecular orbital (HOMO) of -3.3 eV or higher, or for example, -2.8 eV or higher (higher positive number). The HOMO of the n-dopant may be determined by cyclic voltammetry measurement of the oxidation potential.

In some embodiments, the n-dopant may include at least one selected from Compounds 701 to 706, but the present disclosure is not limited thereto:

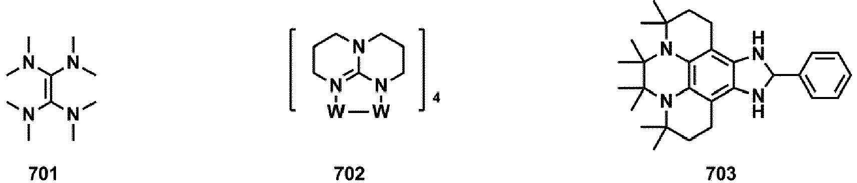

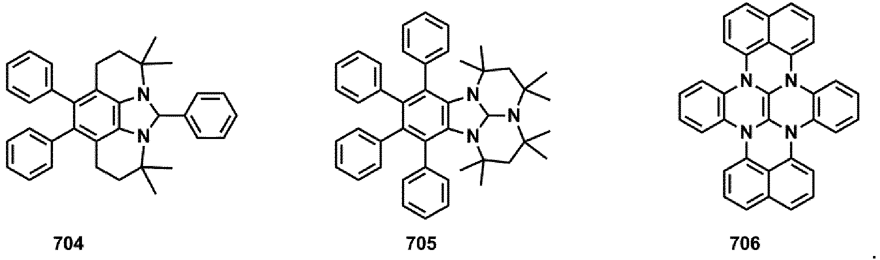

### Second electrode 190

The second electrode 190 may be on the organic layer 150. In an embodiment, the second electrode 190 may be a cathode that is an electron injection electrode. In this embodiment, a material for forming the second electrode 190 may be a material having a low work function, for example, a metal, an alloy, an electrically conductive compound, or a combination thereof.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but the present disclosure is not limited thereto. The second electrode 190 may be a transmissive electrode, a semi-transmissive electrode, or a reflective electrode.

The second electrode 190 may have a single-layered structure, or a multi-layered structure including two or more layers.

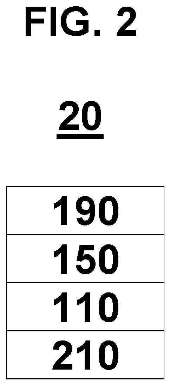

### Description of FIGS. 2 to 4

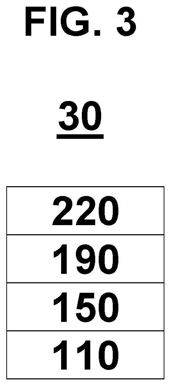

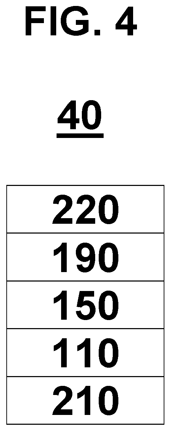

Referring to FIG. 2, an organic light-emitting device 20 has a first capping layer 210, the first electrode 110, the organic layer 150, and the second electrode 190 structure, wherein the layers are sequentially stacked in this stated order. Referring to FIG. 3, an organic light-emitting device 30 has the first electrode 110, the organic layer 150, the second electrode 190, and a second capping layer 220 structure, wherein the layers are sequentially stacked in this stated order. Referring to FIG. 4, an organic light-emitting device 40 has the first capping layer 210, the first electrode 110, the organic layer 150, the second electrode 190, and the second capping layer 220 structure, wherein the layers are stacked in this stated order.

The first electrode 110, the organic layer 150, and the second electrode 190 illustrated in FIGS. 2 to 4 may be substantially the same as those illustrated in FIG. 1.

In the organic light-emitting devices 20 and 40, light emitted from the emission layer in the organic layer 150 may pass through the first electrode 110 (which may be a semi-transmissive electrode or a transmissive electrode) and through the first capping layer 210 to the outside. In the organic light-emitting devices 30 and 40, light emitted from the emission layer in the organic layer 150 may pass through the second electrode 190 (which may be a semi-transmissive electrode or a transmissive electrode) and through the second capping layer 220 to the outside.

The first capping layer 210 and the second capping layer 220 may improve the external luminescence efficiency based on the principle of constructive interference.

The first capping layer 210 and the second capping layer 220 may each independently have a refractive index of 1.6 or greater at a wavelength of 589 nm.

The first capping layer 210 and the second capping layer 220 may each independently be a capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphine derivatives, phthalocyanine derivatives, naphthalocyanine derivatives, alkali metal complexes, and alkaline earth metal complexes. The carbocyclic compound, the heterocyclic compound, and the amine group-containing compound may optionally be substituted with a substituent containing at least one element selected from O, N, S, Se, Si, F, Cl, Br, and I. In some embodiments, at least one selected from the first capping layer 210 and the second capping layer 220 may each independently include an amine-based compound.

In one or more embodiments, at least one selected from the first capping layer 210 and the second capping layer 220 may each independently include a compound represented by Formula 201 or a compound represented by 202.

In one or more embodiments, at least one selected from the first capping layer 210 and the second capping layer 220 may each independently include a compound selected from Compounds HT28 to HT33 and Compound CP1 to CP5, but the present disclosure is not limited thereto:

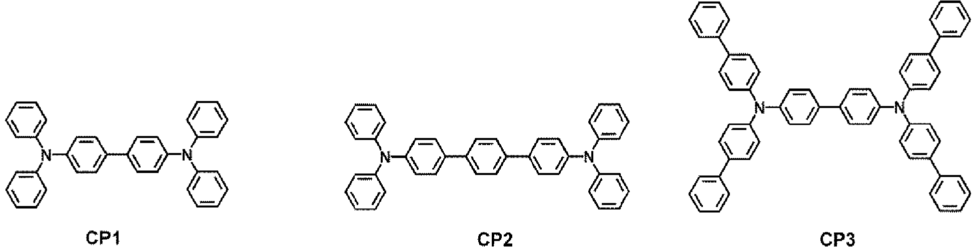

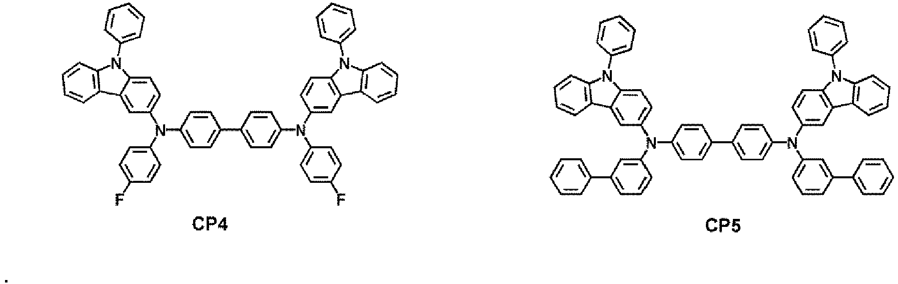

Hereinbefore, the organic light-emitting device has been described with reference to FIGS. 1 to 4, but the present disclosure is not limited thereto.

The layers constituting the hole transport region, the emission layer, and the layers constituting the electron transport region may be formed in a set or specific region by using one or more suitable methods such as vacuum deposition, spin coating, casting, Langmuir-Blodgett (LB) deposition, ink-jet printing, laser printing, and/or laser-induced thermal imaging.

When the layers constituting the hole transport region, the emission layer, and the layers constituting the electron transport region are each formed by vacuum deposition, the vacuum deposition may be performed at a deposition temperature in a range of about 100 °C to about 500 °C at a vacuum degree in a range of about 10⁻⁸ torr to about 10⁻³ torr, and at a deposition rate in a range of about 0.01 Angstroms per second (Å/sec) to about 100 Å/sec, depending on the material to be included in each layer and the structure of each layer to be formed.

When the layers constituting the hole transport region, the emission layer, and the layers constituting the electron transport region are each formed by spin coating, the spin coating may be performed at a coating rate of about 2,000 revolutions per minute (rpm) to about 5,000 rpm and at a heat treatment temperature of about 80 °C°C to about 200 °C, depending on the material to be included in each layer and the structure of each layer to be formed.

### Electronic apparatus

The organic light-emitting device may be included in various suitable electronic apparatuses. In some embodiments, an electronic apparatus including the organic light-emitting device may be an emission apparatus or an authentication apparatus.

The electronic apparatus (e.g., an emission apparatus) may further include, in addition to the organic light-emitting device, i) a color filter, ii) a color-conversion layer, or iii) a color filter and a color-conversion layer. The color filter and/or the color-conversion layer may be on at least one traveling direction of light emitted from the organic light-emitting device. For example, light emitted from the organic light-emitting device may be blue light or white light. The organic light-emitting device may be understood by referring to the description of the organic light-emitting device provided herein. In some embodiments, the color-conversion layer may include a quantum dot. The quantum dot may be, for example, the quantum dot known in the art.

The electronic apparatus may include a first substrate. The first substrate may include a plurality of sub-pixel areas, the color filter may include a plurality of color filter areas respectively corresponding to the plurality of sub-pixel areas, and the color-conversion layer may include a plurality of color-conversion areas respectively corresponding to the plurality of sub-pixel areas.

A pixel defining film may be located between the plurality of sub-pixel areas to define each sub-pixel area.

The color filter may further include a plurality of color filter areas and light-blocking patterns between the plurality of color filter areas, and the color-conversion layer may further include a plurality of color-conversion areas and light-blocking patterns between the plurality of color-conversion areas.

The plurality of color filter areas (or a plurality of color-conversion areas) may include: a first area emitting first color light; a second area emitting second color light; and/or a third area emitting third color light, and the first color light, the second color light, and/or the third color light may have different maximum emission wavelengths. In some embodiments, the first color light may be red light, the second color light may be green light, and the third color light may be blue light. In some embodiments, the plurality of color filter areas (or the plurality of color-conversion areas) may each include a quantum dot. In some embodiments, the first area may include a red quantum dot, the second area may include a green quantum dot, and the third area may not include a quantum dot. The quantum dot may be, for example, the quantum dot known in the art. The first area, the second area, and/or the third area may each further include an emitter.

In some embodiments, the organic light-emitting device may emit first light, the first area may absorb the first light to emit 1-1th color light, the second area may absorb the first light to emit 2-1th color light, and the third area may absorb the first light to emit 3-1th color light. In this embodiment, the 1-1th color light, the 2-1th color light, and the 3-1th color light may each have a different maximum emission wavelength. In some embodiments, the first light may be blue light, the 1-1th color light may be red light, the 2-1th color light may be green light, and the 3-1th color light may be blue light.

The electronic apparatus may further include a thin-film transistor, in addition to the organic light-emitting device. The thin-film transistor may include a source electrode, a drain electrode, and an activation layer (e.g. an active layer), wherein one selected from the source electrode and the drain electrode may be electrically coupled to one of the first electrode and the second electrode of the organic light-emitting device.

The thin-film transistor may further include a gate electrode, a gate insulating film, and/or the like.

The activation layer may include a crystalline silicon, an amorphous silicon, an organic semiconductor, and/or an oxide semiconductor.

The electronic apparatus may further include a sealing portion for sealing the organic light-emitting device. The sealing portion may be located between the color filter and/or the color-conversion layer and the organic light-emitting device. The sealing portion may allow light to pass to the outside from the organic light-emitting device and prevent or reduce the permeation of the air and moisture into the organic light-emitting device at the same time. The sealing portion may be a sealing substrate including a transparent glass and/or a plastic substrate. The sealing portion may be a thin-film encapsulating layer including at least one selected from an organic layer and an inorganic layer. When the sealing portion is a thin film encapsulating layer, the electronic apparatus may be flexible.

In addition to the color filter and/or the color-conversion layer, various suitable functional layers may be on the sealing portion depending on the use of an electronic apparatus. Examples of the functional layer may include a touch screen layer, a polarization layer, and/or the like. The touch screen layer may be a resistive touch screen layer, a capacitive touch screen layer, and/or an infrared beam touch screen layer. The authentication apparatus may be, for example, a biometric authentication apparatus that identifies an individual according to biometric information (e.g., a fingertip, a pupil, and/or the like).

The authentication apparatus may further include a biometric information collecting unit, in addition to the organic light-emitting device described above.

The electronic apparatus may be applicable to various suitable displays, an optical source, lighting, a personal computer (e.g., a mobile personal computer), a cellphone, a digital camera, an electronic note, an electronic dictionary, an electronic game console, a medical device (e.g., an electronic thermometer, a blood pressure meter, a glucometer, a pulse measuring device, a pulse wave measuring device, an electrocardiograph recorder, an ultrasonic diagnosis device, and/or an endoscope display device), a fish finder, various suitable measurement devices, gauges (e.g., gauges of an automobile, an airplane, and/or a ship), and/or a projector.

### General definitions of substituents

The term "C₁-C₆₀ alkyl group," as used herein, refers to a linear or branched aliphatic hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group," as used herein, refers to a divalent group having substantially the same structure as the C₁-C₆₀ alkyl group. Corresponding definitions apply to other ranges given for the number of carbon atoms in an alkyl/alkylene group.

The term "C₂-C₆₀ alkenyl group," as used herein, refers to a hydrocarbon group having at least one carbon-carbon double bond at a main chain (e.g., in the middle) or at a terminal end (e.g., the terminus) of the C₂-C₆₀ alkyl group. Examples thereof include an ethenyl group, a propenyl group, and a butenyl group. The term "C₂-C₆₀ alkenylene group," as used herein, refers to a divalent group having substantially the same structure as the C₂-C₆₀ alkenyl group. Corresponding definitions apply to other ranges given for the number of carbon atoms in an alkenyl/alkenylene group.

The term "C₂-C₆₀ alkynyl group," as used herein, refers to a hydrocarbon group having at least one carbon-carbon triple bond at a main chain (e.g., in the middle) or at a terminal end (e.g., the terminus) of the C₂-C₆₀ alkyl group. Examples thereof include an ethynyl group and a propynyl group. The term "C₂-C₆₀ alkynylene group," as used herein, refers to a divalent group having substantially the same structure as the C₂-C₆₀ alkynyl group. Corresponding definitions apply to other ranges given for the number of carbon atoms in an alkynyl/alkynylene group.

The term "C₁-C₆₀ alkoxy group," as used herein, refers to a monovalent group represented by -OA₁₀₁ (wherein A₁₀₁ is a C₁-C₁ alkyl group). Examples thereof include a methoxy group, an ethoxy group, and an isopropyloxy group. Corresponding definitions apply to other ranges given for the number of carbon atoms in an alkoxy group.

The term "C₃-C₁₀ cycloalkyl group," as used herein, refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent monocyclic group including at least one heteroatom selected from N, O, Si, P, and S as a ring-forming atom and 1 to 10 carbon atoms. Examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group.

The term "C₃-C₁₀ cycloalkenyl group," as used herein, refers to a monovalent monocyclic group that has 3 to 10 carbon atoms and at least one double bond in its ring, and is not aromatic. Examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent monocyclic group including at least one heteroatom selected from N, O, Si, P, and S as a ring-forming atom, 1 to 10 carbon atoms, and at least one double bond in its ring. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkylene group," as used herein, refers to a divalent group having substantially the same structure as the C₁-C₁₀ heterocycloalkyl group.

The term "C₆-C₆₀ aryl group," as used herein, refers to a monovalent group having a carbocyclic aromatic system having 6 to 6 carbon atoms. The term "C₆-C₆₀ arylene group," as used herein, refers to a divalent group having a carbocyclic aromatic system having 6 to 60 carbon atoms. Examples of the C₆-C₆₀ aryl group include a fluorenyl group, a phenyl group, a naphthyl group, an anthracenyl group, a phenanthrenyl group, a pyrenyl group, and a chrysenyl group. When the C₆-C₆₀ aryl group and the C₆-C₆₀ arylene group each independently include two or more rings, the respective rings may be fused (e.g., combined together). Corresponding definitions apply to other ranges given for the number of carbon atoms in an aryl/arylene group.

The term "C₁-C₆₀ heteroaryl group," as used herein, refers to a monovalent group having a heterocyclic aromatic system having at least one heteroatom selected from N, O, Si, P, and S as a ring-forming atom and 1 to 60 carbon atoms. The term "C₁-C₆₀ heteroarylene group," as used herein, refers to a divalent group having a heterocyclic aromatic system having at least one heteroatom selected from N, O, Si, P, and S as a ring-forming atom and 1 to 60 carbon atoms. Examples of the C₁-C₆₀ heteroaryl group include a carbazolyl group, a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently include two or more rings, the respective rings may be fused (e.g., combined together). Corresponding definitions apply to other ranges given for the number of carbon atoms in an heteroaryl/heteroarylene group.

The term "C₆-C₆₀ aryloxy group," as used herein, is represented by -OA₁₀₂ (wherein A₁₀₂ is the C₆-C₆₀ aryl group). The term "C₆-C₆₀ arylthio group," as used herein, is represented by -SA₁₀₃ (wherein A₁₀₃ is the C₆-C₆₀ aryl group). Corresponding definitions apply to other ranges given for the number of carbon atoms in an aryloxy group and an arylthio group.

The term "monovalent non-aromatic condensed polycyclic group," as used herein, refers to a monovalent group that has two or more rings condensed and only carbon atoms as ring forming atoms (e.g., 8 to 60 carbon atoms), wherein the entire molecular structure is non-aromatic. Examples of the monovalent non-aromatic condensed polycyclic group may include an adamantyl group. The term "divalent non-aromatic condensed polycyclic group," as used herein, refers to a divalent group having substantially the same structure as the monovalent non-aromatic condensed polycyclic group.

The term "monovalent non-aromatic condensed heteropolycyclic group," as used herein, refers to a monovalent group that has two or more condensed rings and at least one heteroatom selected from N, O, Si, P, and S, in addition to carbon atoms (e.g., 1 to 60 carbon atoms), as a ring-forming atom, wherein the entire molecular structure is non-aromatic. Examples of the monovalent non-aromatic condensed heteropolycyclic group may include an azaadamantyl group. The term "divalent non-aromatic condensed heteropolycyclic group," as used herein, refers to a divalent group having substantially the same structure as the monovalent non-aromatic condensed heteropolycyclic group.

The term "C₅-C₆₀ carbocyclic group," as used herein, refers to a monocyclic or polycyclic group having 5 to 60 carbon atoms only as ring-forming atoms, and the term "C₄-C₃₀ carbocyclic group," as used refers to a monocyclic or polycyclic group having 4 to 60 carbon atoms only as ring-forming atoms. The C₅-C₆₀ carbocyclic group (or the C₄-C₆₀ or C₄-C₃₀ carbocyclic group) may be an aromatic carbocyclic group or a non-aromatic carbocyclic group. The terms "C₅-C₆₀ carbocyclic group" and "C₄-C₃₀ carbocyclic group," as used herein, refers to a ring (e.g., a benzene group), a monovalent group (e.g., a phenyl group), or a divalent group (e.g., a phenylene group). Also, depending on the number of substituents connected to the C₅-C₆₀ carbocyclic group or the C₄-C₃₀ carbocyclic group, the C₅-C₆₀ carbocyclic group or the C₄-C₃₀ carbocyclic group may be a trivalent group or a quadrivalent group. Corresponding definitions apply to other ranges given for the number of carbon atoms in a carbocyclic group.

The term "C₁-C₆₀ heterocyclic group," as used herein, refers to a group having substantially the same structure as the C₅-C₆₀ carbocyclic group, except that at least one heteroatom selected from N, O, Si, P, and S is used as a ring-forming atom, in addition to carbon atoms (e.g., 1 to 60 carbon atoms). Corresponding definitions apply to other ranges given for the number of carbon atoms in a heterocyclic group.

In the present specification, at least one of substituents of the substituted C₅-C₆₀ (e.g. C₅-C₃₀) carbocyclic group (or the substituted C₄-C₃₀ carbocyclic group), the substituted C₁-C₆₀ (e.g. C₁-C₂₀) heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ *(e.g.* C₆-C₃₀) arylene group, the substituted C₁-C₆₀ *(e.g.* C₁-C₂₀) heteroarylene group, the substituted divalent non-aromatic condensed polycyclic group, the substituted divalent non-aromatic condensed heteropolycyclic group, the substituted C₁-C₆₀ *(e.g.* C₁-C₂₀) alkyl group, the substituted C₂-C₆₀ *(e.g.* C₂-C₂₀) alkenyl group, the substituted C₂-C₆₀ *(e.g.* C₂-C₂₀) alkynyl group, the substituted C₁-C₆₀ *(e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (e.g. C₆-C₃₀) aryl group, the substituted C₆-C₆₀ *(e.g.* C₆-C₃₀) aryloxy group, the substituted C₆-C₆₀ *(e.g.* C₆-C₃₀) arylthio group, the substituted C₁-C₆₀ *(e.g.* C₁-C₂₀) heteroaryl group, the substituted monovalent non-aromatic condensed polycyclic group, and the substituted monovalent non-aromatic condensed heteropolycyclic group may be selected from:
deuterium, -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g*. C₁-C₂₀) alkoxy group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ *(e.g.* C₆-C₃₀) aryloxy group, a C₆-C₆₀ *(e.g.* C₆-C₃₀) arylthio group, a C₁-C₆₀ *(e.g.* C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ *(e.g.* C₂-C₂₀) alkenyl group, a C₂-C₆₀ *(e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₁-C₆₀ *(e.g.* C₁-C₂₀) heteroaryl group, a monovalent non-aromatic condensed polycyclic group, a monovalent non-aromatic condensed heteropolycyclic group, a biphenyl group, and a terphenyl group.

"Ph," as used herein, represents a phenyl group, "Me," as used herein, represents a methyl group, "Et," as used herein, represents an ethyl group, "ter-Bu" or "Bu^{t}_{,}" as used herein, represents a tert-butyl group, and "OMe," as used herein, represents a methoxy group.

The term "biphenyl group," as used herein, refers to a phenyl group substituted with at least one phenyl group. The "biphenyl group" belongs to "a substituted phenyl group" having a "C₆-C₆₀ aryl group" as a substituent.

The term "terphenyl group," as used herein, refers to a phenyl group substituted with at least one phenyl group. The "terphenyl group" belongs to "a substituted phenyl group" having a "C₆-C₆₀ aryl group substituted with a C₆-C₆₀ aryl group" as a substituent.

The symbols * and *', as used herein, unless defined otherwise, refer to a binding site to an adjacent atom in a corresponding formula.

Hereinafter an organic light-emitting device according to an embodiment will be described in more detail with reference to Examples.

### Examples

### Comparative Example 1

An anode was manufactured by cutting a Corning 15 Ω/cm² (1,200 Å) ITO glass substrate to a size of 50 mm×50 mm×0.5 mm, ultrasonically cleaning the glass substrate by using acetone, isopropyl alcohol, and pure water for 15 minutes each, and then irradiating UV light for 30 minutes thereto and being exposed to ozone to clean. Then, the anode was loaded into a vacuum deposition apparatus.

HT18 and Compound 202 (2 percent by weight, wt%) was deposited on the ITO glass substrate to a thickness of 100 Å to form a hole injection layer, and HT18 was deposited on the hole injection layer to a thickness of 1,000 Å to form a hole transport layer.

TCTA was deposited on the hole transport layer to a thickness of 100 Å to form an electron blocking layer, thereby forming a hole transport region.

CBP as a host and BD1 (at a concentration of 10 vol%) as a dopant were codeposited on the hole transport region to form an emission layer having a thickness of 300 Å.

DIC-TRZ was deposited on the emission layer to form a hole blocking layer having a thickness of 50 Å, and ET1 and Liq were deposited to a weight ratio of 1:1 to form an electron transport layer having a thickness of 300 Å.

LiF was deposited on the electron transport layer to form an electron injection layer having a thickness of 10 Å, and Al was deposited to a thickness of 120 Å to form a cathode. HT28 was deposited on the cathode to form a capping layer having a thickness of 800 Å, thereby completing the manufacture of an organic light-emitting device.

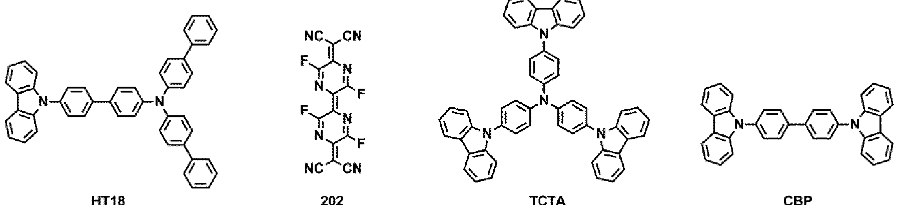

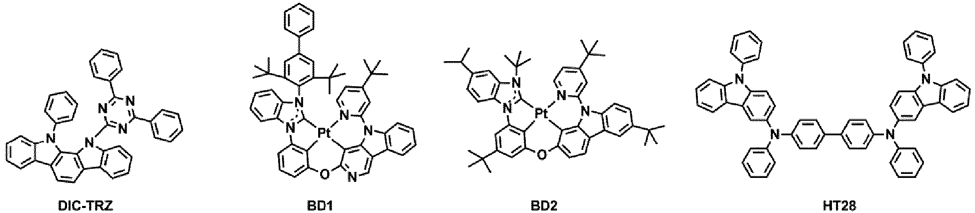

### Reference Examples 1 and 2 and Comparative Examples 2 and 3

Organic light-emitting devices were manufactured in substantially the same manner as in Comparative Example 1, except that hosts and dopants shown in Table 1 were used in the formation of an emission layer.

### Examples 3 and 4

Organic light-emitting devices were manufactured in substantially the same manner as in Comparative Example 1, except that the emission layer was formed as two emission layers in the order of a first emission layer and a second emission layer from the anode by using hosts and dopants shown in Table 1.

### Example 5

An organic light-emitting device was manufactured in substantially the same manner as in Comparative Example 1, except that the emission layer was formed as three emission layers in the order of a first emission layer, a second emission layer, and a third emission layer from the anode by using hosts and dopants shown in Table 1.

**Table 1**

| No. | First emission layer | | Second emission layer | | Third emission layer | |
|---|---|---|---|---|---|---|
| | Host | Dopant | Host | Dopant | Host | Dopant |
| Comparative Example 1 | CBP (thickness of 300 Å) | BD1 (10 vol%) | - | - | - | - |
| Comparative Example 2 | CBP (thickness of 300 Å) | BD2 (10 vol%) | - | - | - | - |
| Comparative Example 3 | CBP (thickness of 300 Å) | Ir(dmp)₃ (10 vol%) + mer-Ir(pmp)₃ (3 vol%) | - | - | - | - |
| Example 1 | CBP : DIC-TRZ (6:4) (thickness of 300 Å) | BD1(10 vol%) + BD2 (1 vol%) | - | - | - | - |
| Example 2 | CBP : DIC-TRZ (6:4) (thickness of 300 Å) | BD1(10 vol%) + BD2 (3 vol%) | - | - | - | - |
| Example 3 | CBP : DIC-TRZ (6:4) (thickness of 100 Å) | BD1 (10 vol%) | CBP : DIC-TRZ (6:4) (thickness of 100 Å) | BD2 (10 vol%) | - | - |
| Example 4 | CBP : DIC-TRZ (6:4) (thickness of 100 Å) | BD2 (10 vol%) | CBP : DIC-TRZ (6:4) (thickness of 200 Å) | BD1 (10 vol%) | - | - |
| Example 5 | CBP : DIC-TRZ (6:4) (thickness of 100 Å) | BD2 (10 vol%) | CBP : DIC-TRZ (5:5) (thickness of 100 Å) | BD1 (10 vol%) | CBP : DIC-TRZ (4:6) (thickness of 100 Å) | BD2 (10 vol%) |

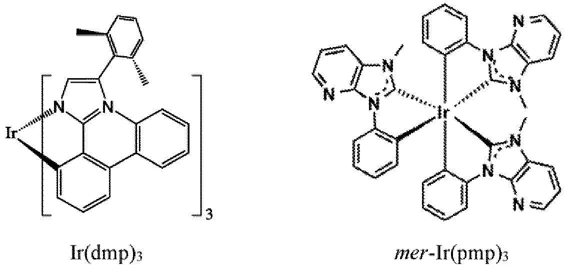

### Evaluation Example

The driving voltage (V), current efficiency (Cd/A), and lifespan (T95) of the organic light-emitting devices of Examples 1 to 5 and Comparative Examples 1 to 3 were measured at a luminance of 1,000 nit. The results thereof are shown in Table 2. The driving voltage and efficiency of the organic light-emitting devices were measured by using a current voltmeter Keithley SMU 236 and a luminance meter PR650. The lifespan indicates a time (hour) for the luminance of the organic light-emitting device to decline to 95% of its initial luminance.

**Table 2**

| No. | Driving voltage (V) | CIE_y | Efficiency (Cd/A) | T95 lifespan (@1,000 nit) (h) |
|---|---|---|---|---|
| Comparative Example 1 | 6.1 | 0.052 | 18.3 | 49 |
| Comparative Example 2 | 5.9 | 0.063 | 18.8 | 62 |
| Comparative Example 3 | 6.8 | 0.112 | 13.1 | 9 |
| Example 1 | 6.1 | 0.053 | 18.5 | 60 |
| Example 2 | 6.0 | 0.055 | 18.8 | 75 |
| Example 3 | 6.0 | 0.057 | 18.8 | 55 |
| Example 4 | 5.9 | 0.055 | 19.1 | 71 |
| Example 5 | 5.6 | 0.053 | 19.3 | 78 |

As shown in Table 2, the organic light-emitting devices of Examples 1 to 5 exhibited improved driving voltage, color purity, efficiency, and/or lifespan, as compared with the organic light-emitting devices of Comparative Examples 1 to 3.

As is apparent from the foregoing description, the organic light-emitting device may have high color purity, high efficiency, and long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

1. An organic light-emitting device (10) comprising:
a first electrode (110);
a second electrode (190) facing the first electrode (110); and
an organic layer (150) between the first electrode (110) and the second electrode (190) and comprising an emission layer,
wherein the emission layer comprises a host and a dopant,
the host comprises a first compound and a second compound different from the first compound,
the dopant comprises a third compound and a fourth compound different from the third compound,
wherein the emission layer comprises a first emission layer and a second emission layer,
the first emission layer is between the first electrode (110) and the second emission layer,
the first emission layer comprises the first compound, the second compound, and a first dopant,
the second emission layer comprises the first compound, the second compound, and a second dopant,
the first dopant is one selected from the third compound and the fourth compound, and
the second dopant is different from the first dopant and is the other one selected from the third compound and the fourth compound,
wherein a difference between a maximum emission wavelength of light emitted from the first emission layer and a maximum emission wavelength of light emitted from the second emission layer is in a range of 0 nm to 35 nm, **characterised in that** the first emission layer and the second emission layer each emit blue light and **in that** the third compound is a platinum-containing organometallic compound.

2. An organic light-emitting device (10) according to claim 1, wherein:
(i) a weight ratio of the third compound to the fourth compound in the emission layer is in a range of 100:1 to 1:100; and/or
(ii) the first compound is a hole-transporting host, and
the second compound is an electron-transporting host.

3. An organic light-emitting device (10) according to claim 1 or claim 2, wherein the first compound comprises at least one moiety represented by any one selected from Formulae 3-1 to 3-3: 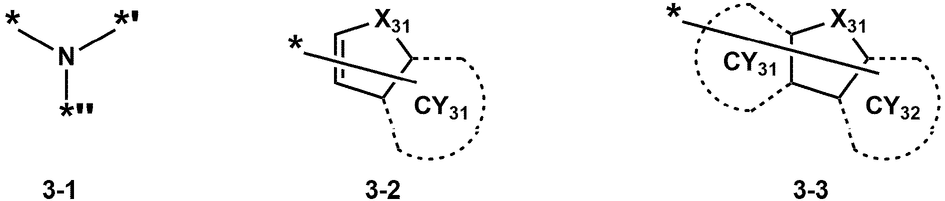
wherein, in Formulae 3-1 to 3-3,
X₃₁ is selected from O, S, N-(L₃₃)ₐ₃₃-(R₃₃)_{b33}, C(R₃₃)(R₃₄), and Si(R₃₃)(R₃₄),
CY₃₁ and CY₃₂ are each independently a π-electron rich cyclic group,
L₃₃ is selected from a single bond, a substituted or unsubstituted C₅-C₃₀ carbocyclic group, and a substituted or unsubstituted C₁-C₃₀ heterocyclic group,
a33 is an integer from 1 to 10,
R₃₃ and R₃₄ are each independently selected from hydrogen, deuterium, -F, -Cl, -Br, -I, a hydroxyl group, a cyano group, a nitro group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
b33 is an integer from 1 to 10, and
*, *', and *" each indicate a binding site to an adjacent atom.

4. An organic light-emitting device (10) according to any one of claims 1 to 3, wherein the first compound is selected from compounds represented by Formulae 3-11 to 3-14: 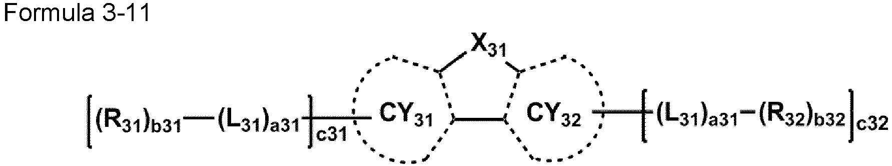 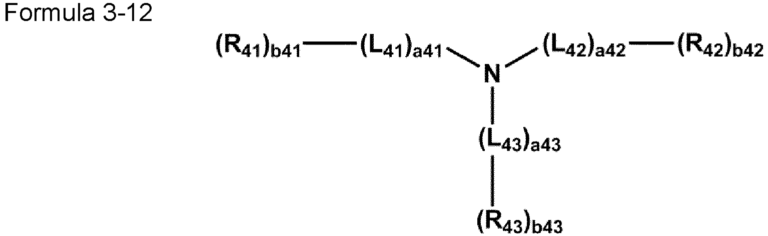 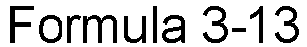 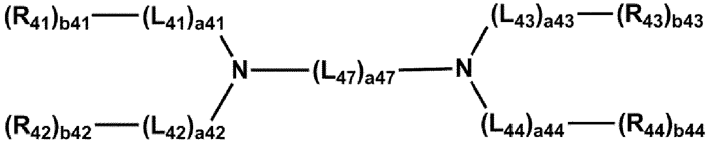 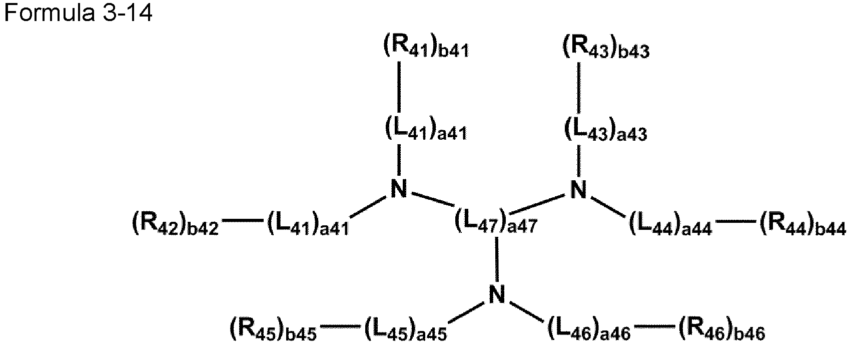
wherein, in Formula 3-11,
CY₃₁ and CY₃₂ are each independently a π-electron rich cyclic group having 3 to 30 carbon atoms,
X₃₁ is selected from O, S, N-(L₃₃)ₐ₃₃-(R₃₃)_{b33}, C(R₃₃)(R₃₄), and Si(R₃₃)(R₃₄),
c31 and c32 are each independently an integer from 0 to 3,
wherein, in Formulae 3-11 to 3-14,
L₃₁ to L₃₃ and L₄₁ to L₄₇ are each independently selected from a single bond, a substituted or unsubstituted C₅-C₃₀ carbocyclic group, and a substituted or unsubstituted C₁-C₃₀ heterocyclic group,
a31 to a33 and a41 to a47 are each independently an integer from 1 to 10,
R₃₁ to R₃₄ and R₄₁ to R₄₆ are each independently selected from hydrogen, deuterium, -F, -Cl, -Br, -I, a hydroxyl group, a cyano group, a nitro group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
b31 to b33 and b41 to b46 are each independently an integer from 1 to 10, and at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, - Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -1, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amino group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

5. An organic light-emitting device (10) according to any one of claims 1 to 4, wherein the second compound comprises an electron-transporting moiety comprising at least one selected from -F, a cyano group, a C₁-C₆₀ alkyl group substituted with -F or a cyano group, a C₆-C₆₀ aryl group substituted with -F or a cyano group, and a π-electron-depleted nitrogen-containing cyclic group.

6. An organic light-emitting device (10) according to any one of claims 1 to 5, wherein the second compound is a compound represented by Formula 4-1: 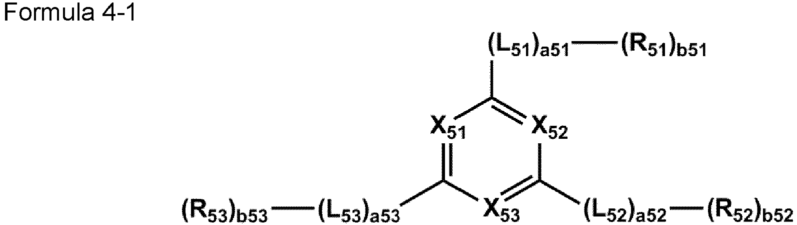
wherein, in Formula 4-1,
X₅₁ is N or C[(L₅₄)ₐ₅₄-(R₅₄)_{b54}], X₅₂ is N or C[(L₅₅)ₐ₅₅-(R₅₅)_{b55}], and X₅₃ is N or C[(L₅₆)ₐ₅₆-(R₅₆)_{b56}],
L₅₁ to L₅₆ are each independently selected from a single bond, a substituted or unsubstituted C₅-C₃₀ carbocyclic group, and a substituted or unsubstituted C₁-C₃₀ heterocyclic group,
a51 to a56 are each independently an integer from 1 to 10,
R₅₁ to R₅₆ are each independently selected from hydrogen, deuterium, -F, -Cl, - Br, -I, a hydroxyl group, a cyano group, a nitro group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
b51 to b56 are each independently an integer from 1 to 10, and
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amino group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

7. An organic light-emitting device (10) according to any one of claims 1 to 6, wherein the third compound and the fourth compound are each independently an organometallic compound represented by Formula 1:
Formula 1 M(L₁)ₙ₁(L₂)ₙ₂ 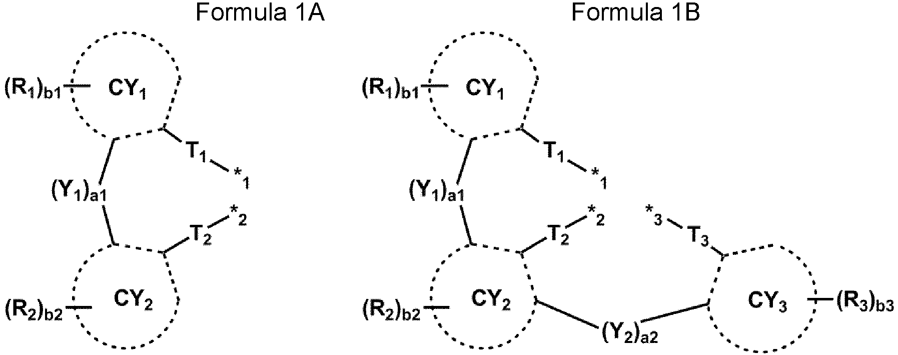 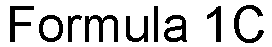 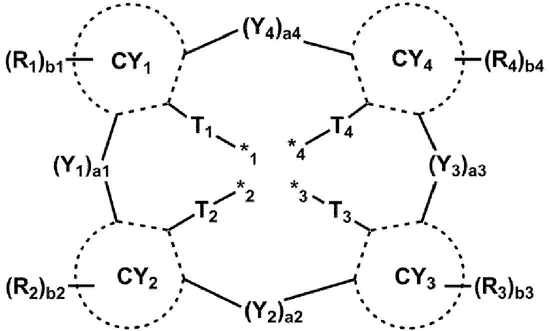
wherein, in Formulae 1 and 1A to 1C,
M is selected from a first-row transition metal, a second-row transition metal, and a third-row transition metal, wherein M in the third compound is platinum (Pt),
L₁ is selected from a ligand represented by Formula 1A, a ligand represented by Formula 1B, and a ligand represented by Formula 1C,
L₂ is selected from a monodentate ligand, a bidentate ligand, and a tridentate ligand,
n1 is selected from 1, 2, and 3,
n2 is selected from 0, 1, 2, 3, and 4,
CY₁ to CY₄ are each independently selected from a C₅-C₃₀ carbocyclic group and a C₁-C₃₀ heterocyclic group,
Y₁ to Y₄ are each independently selected from a single bond, a double bond, a substituted or unsubstituted C₆-C₃₀ arylene group, a substituted or unsubstituted C₁-C₃₀ heteroarylene group, *-O-*', *-S-*', *-C(=O)-*', *-S(=O)-*', *-C(R₆)(R₆)-*', *-C(R₅)=C(R₆)-*', *-C(R₅)=*', *-Si(R₅)(R₆)-*', *-B(R₅)-*', *-N(R₅)-*', and *-P(R₅)-*',
a1 to a3 are each independently selected from 1, 2, and 3,
a4 is selected from 0, 1, 2, and 3, and when a4 is 0, CY₂ and CY₄ are not connected to each other,
T₁ to T₄ are each independently selected from a chemical bond, *-O-*', *-S-*', *-B(R₇)-*', *-N(R₇)-*', *-P(R₇)-*', *-C(R₇)(R₈)-*', *-Si(R₇)(R₈)-*', *-Ge(R₇)(R₈)-*', *-C(=O)-*', and *-C(=S)-*',
*₁, *₂, *₃, and *₄ are each a binding site to M,
R₁ to R₈ are each independently selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - C(Q₁)(Q₂)(Q₃), -Si(Q₁)(Q₂)(Q₃), -B(Q₁)(Q₂), -N(Q₁)(Q₂), -P(Q₁)(Q₂), -C(=O)(Q₁), - S(=O)(Q₁), -S(=O)₂(Q₁), -P(=O)(Q₁)(Q₂), and -P(=S)(Q₁)(Q₂), wherein adjacent groups from among R₁ to R₈ are optionally bound to form a substituted or unsubstituted C₅-C₆₀ carbocyclic group or a substituted or unsubstituted C₁-C₆₀ heterocyclic group,
adjacent groups from among R₁ to R₈ and Y₁ to Y₄ are optionally bound to form a substituted or unsubstituted C₅-C₆₀ carbocyclic group or a substituted or unsubstituted C₁-C₆₀ heterocyclic group,
b1 to b4 are each independently an integer from 0 to 10, and
at least one substituent of the substituted C₆-C₃₀ arylene group, the substituted C₁-C₃₀ heteroarylene group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, the substituted monovalent non-aromatic condensed heteropolycyclic group, the substituted C₅-C₆₀ carbocyclic group, and the substituted C₁-C₆₀ heterocyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, - Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amino group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group, and
* and *' each indicate a binding site to an adjacent atom.

8. An organic light-emitting device (10) according to claim 7, wherein the third compound and the fourth compound are each independently selected from compounds represented by Formulae 1-1 and 1-2: 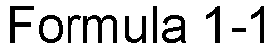 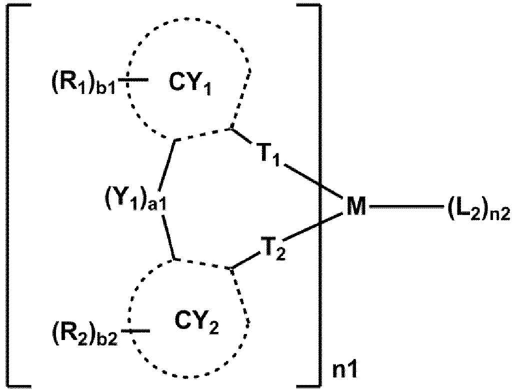 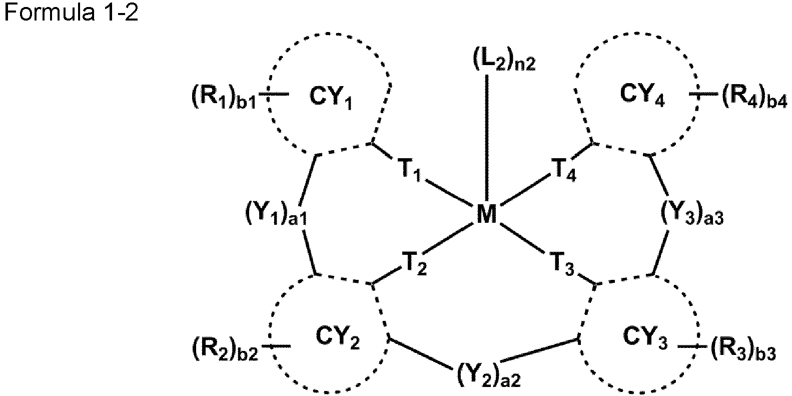
wherein, in Formulae 1-1 and 1-2,
M, L₂, n1, n2, CY₁ to CY₄, Y₁ to Y₃, a1 to a3, T₁ to T₄, R₁ to R₄, and b1 to b4 are respectively understood by referring to the descriptions of M, L₂, n1, n2, CY₁ to CY₄, Y₁ to Y₃, a1 to a3, T₁ to T₄, R₁ to R₄, and b1 to b4 in Formulae 1 and 1A to 1C.

9. An organic light-emitting device (10) according to any one of claims 1 to 8, wherein the third compound is a compound represented by Formula 2-1, and
the fourth compound is a compound represented by Formula 2-2: 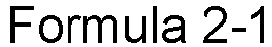 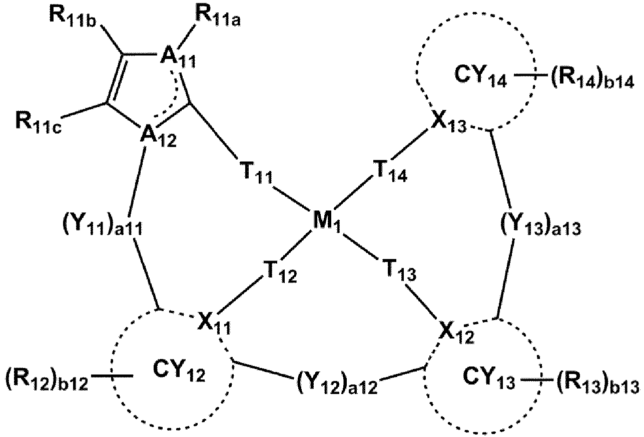 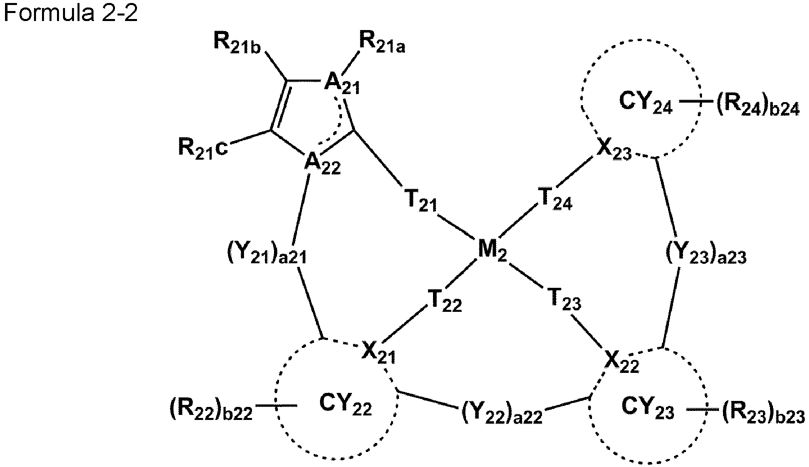
wherein, in Formulae 2-1 and 2-2,
M₁ is Pt,
M₂ is selected from a first-row transition metal, a second-row transition metal, and a third-row transition metal,
CY₁₂ to CY₁₄ and CY₂₂ to CY₂₄ are each independently selected from a C₅-C₃₀ carbocyclic group and a C₁-C₃₀ heterocyclic group,
A₁₁, A₁₂, A₂₁, and A₂₂ are each independently N or P,
X₁₁ to X₁₃ and X₂₁ to X₂₃ are each independently N or C,
Y₁₁ to Y₁₃ are each independently selected from a single bond, a double bond, a substituted or unsubstituted C₆-C₃₀ arylene group, a substituted or unsubstituted C₁-C₃₀ heteroarylene group, *-O-*', *-S-*', *-C(=O)-*', *-S(=O)-*', *-C(R₁₅)(R₁₆)-*', *-C(R₁₅)=C(R₁₆)-*', *-C(R₁₅)=*', *-Si(R₁₅)(R₁₆)-*', *-B(R₁₅)-*', *-N(R₁₅)-*', and *-P(R₁₅)-*',
Y₂₁ to Y₂₃ are each independently selected from a single bond, a double bond, a substituted or unsubstituted C₆-C₃₀ arylene group, a substituted or unsubstituted C₁-C₃₀ heteroarylene group, *-O-*', *-S-*', *-C(=O)-*', *-S(=O)-*', *-C(R₂₅)(R₂₆)-*', *-C(R₂₅)=C(R₂₆)-*', *-C(R₂₅)=*', *-Si(R₂₅)(R₂₆)-*', *-B(R₂₅)-*', *-N(R₂₅)-*', and *-P(R₂₅)-*',
a11 to a13 are each independently selected from 1, 2, and 3,
a21 to a23 are each independently selected from 1, 2, and 3,
T₁₁ to T₁₄ are each independently selected from a chemical bond, *-O-*', *-S-*', *-B(R₁₇)-*', *-N(R₁₇)-*', *-P(R₁₇)-*', *-C(R₁₇)(R₁₈)-*', *-Si(R₁₇)(R₁₈)-*', *-Ge(R₁₇)(R₁₈)-*', *-C(=O)-*', and *-C(=S)-*',
T₂₁ to T₂₄ are each independently selected from a chemical bond, *-O-*', *-S-*', *-B(R₂₇)-*', *-N(R₂₇)-*', *-P(R₂₇)-*', *-C(R₂₇)(R₂₈)-*', *-Si(R₂₇)(R₂₈)-*', *-Ge(R₂₇)(R₂₈)-*', *-C(=O)-*', and *-C(=S)-*',
R₁₁ₐ to R_{11c}, R₁₂ to R₁₈, R₂₁ₐ to R_{21c}, and R₂₂ to R₂₈ are each independently selected from hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), -Si(Q₁)(Q₂)(Q₃), -B(Q₁)(Q₂), -N(Q₁)(Q₂), - P(Q₁)(Q₂), -C(=O)(Q₁), -S(=O)(Q₁), -S(=O)₂(Q₁), -P(=O)(Q₁)(Q₂), and -P(=S)(Q₁)(Q₂), wherein adjacent groups from among R₁₁ₐ to R_{11c} and R₁₂ to R₁₈ are optionally bound to form a substituted or unsubstituted C₅-C₆₀ carbocyclic group or a substituted or unsubstituted C₁-C₆₀ heterocyclic group, and adjacent groups from among R₂₁ₐ to R_{21c} and R₂₂ to R₂₈ are optionally bound to form a substituted or unsubstituted C₅-C₆₀ carbocyclic group or a substituted or unsubstituted C₁-C₆₀ heterocyclic group,
b12 to b14 and b22 to b24 are each independently an integer from 0 to 10, and
at least one substituent of the substituted C₆-C₃₀ arylene group, the substituted C₁-C₃₀ heteroarylene group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, the substituted monovalent non-aromatic condensed heteropolycyclic group, the substituted C₅-C₆₀ carbocyclic group, and the substituted C₁-C₆₀ heterocyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₆ alkoxy group, each substituted with at least one selected from deuterium, -F, -CI, - Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(O₃₁)(O₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amino group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group, and
* and *' each indicate a binding site to an adjacent atom.

10. An organic light-emitting device (10) according to claim 9, wherein, in Formula 2-1, at least one selected from R₁₁ₐ to R_{11c} and R₁₄ is an electron-donating group, and
in Formula 2-2, i) at least one selected from R₂₂ and R₂₃ is a substituent other than hydrogen, ii) Y₂₃ is *-N(R₂₅)-*', and R₂₅ is a substituted C₆-C₆₀ aryl group, or iii) at least one selected from R₂₂ and R₂₃ is a substituent other than hydrogen, Y₂₃ is *-N(R₂₅)-*', and R₂₅ is a substituted C₆-C₆₀ aryl group, optionally wherein the electron-donating group is a substituent selected from an iso-propyl group, a tert-butyl group, and groups represented by Formulae 10-1 to 10-61: 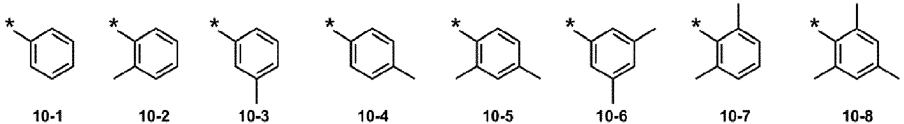 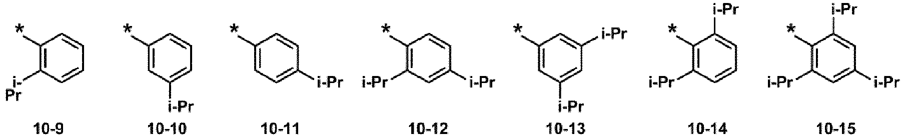 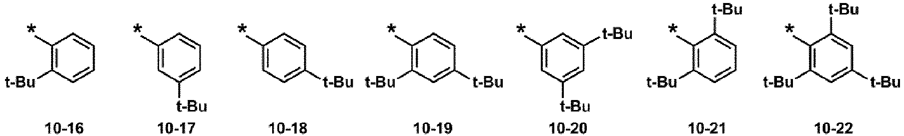 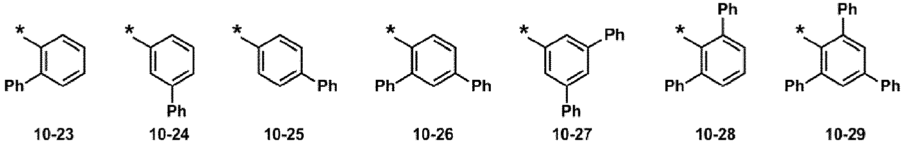 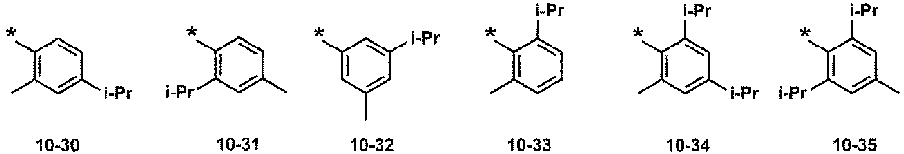 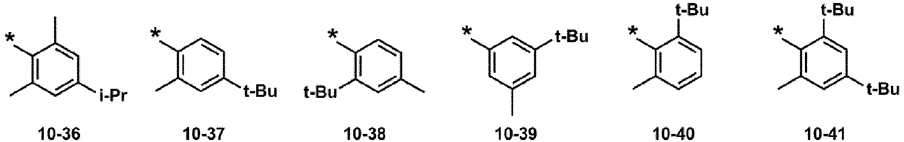 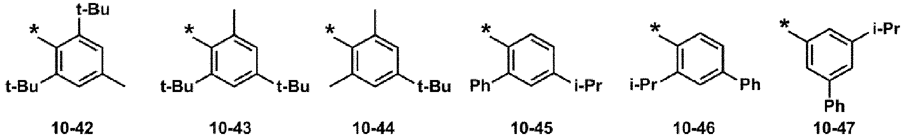 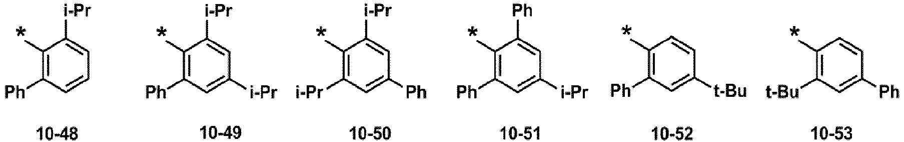 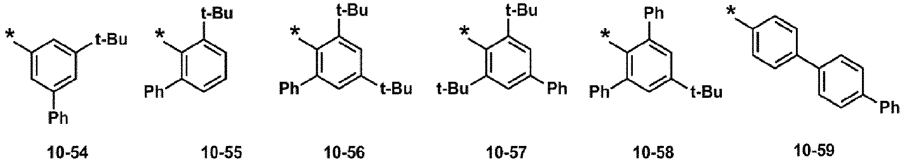 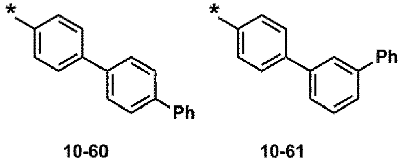
wherein, in Formulae 10-1 to 10-61,
"i-Pr" represents an iso-propyl group, "t-Bu" represents a t-butyl group,
"Ph" represents a phenyl group, and
* indicates a binding site to an adjacent atom.

11. An organic light-emitting device (10) according to claim 9 or claim 10, wherein the third compound is an organometallic compound represented by Formula 2-1A or Formula 2-1B, and
the fourth compound is an organometallic compound represented by Formula 2-2A: 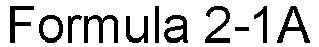 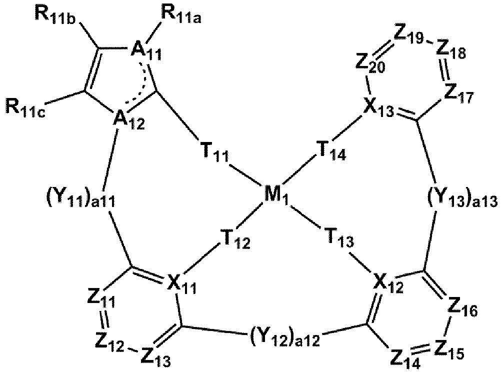 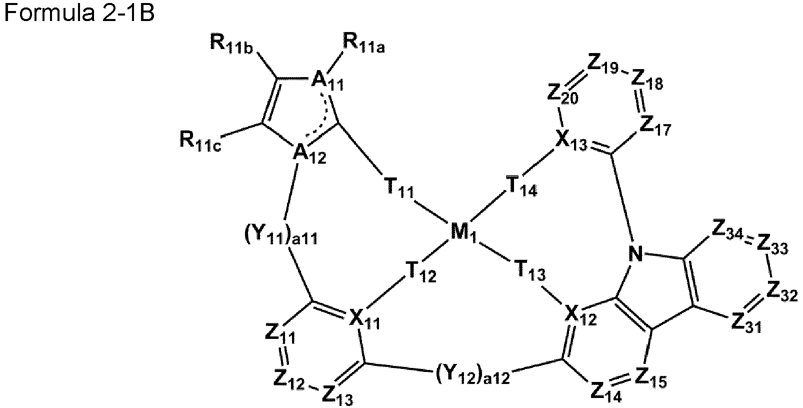 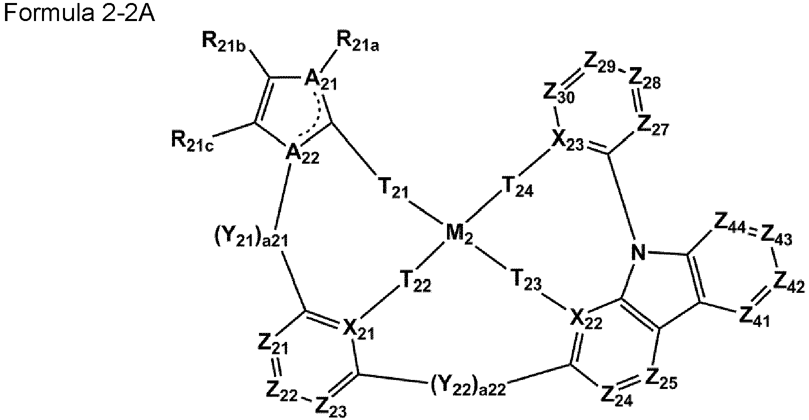
wherein in Formulae 2-1A, 2-1B, and 2-2A,
Z₁₁ is C(R₁₂ₐ) or N, Z₁₂ is C(R_{12b}) or N, Z₁₃ is C(R_{12c}) or N, Z₁₄ is C(R₁₃ₐ) or N, Z₁₅ is C(R_{13b}) or N, Z₁₆ is C(R_{13c}) or N, Z₁₇ is C(R₁₄ₐ) or N, Z₁₈ is C(R_{14b}) or N, Z₁₉ is C(R_{14c}) or N, Z₂₀ is C(R_{14d}) or N, Z₃₁ is C(R₁₆ₐ) or N, Z₃₂ is C(R_{15b}) or N, Z₃₃ is C(R_{15c}) or N, and Z₃₄ is C(R_{15d}) or N,
Z₂₁ is C(R₂₂ₐ) or N, Z₂₂ is C(R_{22b}) or N, Z₂₃ is C(R_{22c}) or N, Z₂₄ is C(R₂₃ₐ) or N, Z₂₅ is C(R_{23b}) or N, Z₂₇ is C(R₂₄ₐ) or N, Z₂₈ is C(R_{24b}) or N, Z₂₉ is C(R_{24c}) or N, Z₃₀ is C(R_{24d}) or N, Z₄₁ is C(R₂₅ₐ) or N, Z₄₂ is C(R_{25b}) or N, Z₄₃ is C(R_{25c}) or N, and Z₄₄ is C(R_{25d}) or N,
R₁₂ₐ to R_{12c} are each understood by referring to the description of R₁₂ in Formula 2-1,
R₁₃ₐ to R_{13c} are each understood by referring to the description of R₁₃ in Formula 2-1,
R₁₄ₐ to R_{14d} are each understood by referring to the description of R₁₄ in Formula 2-1,
R₁₅ₐ to R_{15d} are each understood by referring to the description of R₁₅ in Formula 2-1,
R₂₂ₐ to R_{22c} are each understood by referring to the description of R₂₂ in Formula 2-2,
R₂₃ₐ to R_{23c} are each understood by referring to the description of R₂₃ in Formula 2-2,
R₂₄ₐ to R_{24d} are each understood by referring to the description of R₂₄ in Formula 2-2,
R₂₅ₐ to R_{25d} are each understood by referring to the description of R₂₅ in Formula 2-2, and
M₁, M₂, A₁₁, A₁₂, A₂₁, A₂₂, X₁₁ to X₁₃, X₂₁ to X₂₃, Y₁₁ to Y₁₃, Y₂₁ to Y₂₃, a11 to a13, a21 to a23, T₁₁ to T₁₄, T₂₁ to T₂₄, R₁₁ₐ to R_{11c}, and R₂₁ₐ to R_{21c} are respectively understood by referring to the descriptions of M₁, M₂, A₁₁, A₁₂, A₂₁, A₂₂, X₁₁ to X₁₃, X₂₁ to X₂₃, Y₁₁ to Y₁₃, Y₂₁ to Y₂₃, a11 to a13, a21 to a23, T₁₁ to T₁₄, T₂₁ to T₂₄, R₁₁ₐ to R_{11c}, and R₂₁ₐ to R_{21c} in Formulae 2-1 and 2-2.

12. An organic light-emitting device (10) according to any one of claims 1 to 11, wherein:
(i) the total content of the third compound and the fourth compound is in a range of 1 percent by volume (vol%) to 50 vol%, based on the total volume of the first compound and the second compound in the emission layer; and/or
(ii) the organic light-emitting device further comprises a capping layer (220) on the second electrode (190),
wherein the capping layer (220) has a refractive index of 1.6 or greater at a wavelength of 589 nanometers (nm).

13. An organic light-emitting device (10) according to any one of claims 1 to 12, wherein the emission layer comprises a third emission layer,
the second emission layer is between the first electrode (110) and the third emission layer,
the third emission layer comprises the first compound, the second compound, and a third dopant,
the first dopant and the third dopant are each one selected from the third compound and the fourth compound, and
the second dopant is different from the first dopant and the third dopant and is the other one selected from the third compound and the fourth compound.

14. An electronic apparatus comprising: a thin-film transistor comprising a source electrode, a drain electrode, and an active layer; and the organic light-emitting device (10) according to any one of claims 1 to 13, wherein the first electrode (110) of the organic light-emitting device (10) is electrically coupled to any one selected from the source electrode and the drain electrode of the thin-film transistor.

## Patentansprüche

1. Organische lichtemittierende Vorrichtung (10), umfassend:
eine erste Elektrode (110);
eine zweite Elektrode (190), die der ersten Elektrode (110) zugewandt ist; und
eine organische Schicht (150) zwischen der ersten Elektrode (110) und der zweiten Elektrode (190) und eine Emissionsschicht umfassend,
wobei die Emissionsschicht einen Wirt und einen Dotierstoff umfasst,
der Wirt eine erste Verbindung und eine zweite Verbindung, die sich von der ersten Verbindung unterscheidet, umfasst,
der Dotierstoff eine dritte Verbindung und eine vierte Verbindung, die sich von der dritten Verbindung unterscheidet, umfasst,
wobei die Emissionsschicht eine erste Emissionsschicht und eine zweite Emissionsschicht umfasst,
die erste Emissionsschicht zwischen der ersten Elektrode (110) und der zweiten Emissionsschicht liegt,
die erste Emissionsschicht die erste Verbindung, die zweite Verbindung und einen ersten Dotierstoff umfasst,
die zweite Emissionsschicht die erste Verbindung, die zweite Verbindung und einen zweiten Dotierstoff umfasst,
der erste Dotierstoff eine ist, ausgewählt aus der dritten Verbindung und der vierten Verbindung, und
der zweite Dotierstoff sich von dem ersten Dotierstoff unterscheidet und der andere aus der dritten Verbindung und der vierten Verbindung ausgewählt ist,
wobei eine Differenz zwischen einer maximalen Emissionswellenlänge eines von der ersten Emissionsschicht emittierten Lichts und einer maximalen Emissionswellenlänge eines von der zweiten Emissionsschicht emittierten Lichts in einem Bereich von 0 nm bis 35 nm liegt, **dadurch gekennzeichnet, dass** die erste Emissionsschicht und die zweite Emissionsschicht jeweils blaues Licht emittieren und dass die dritte Verbindung eine platinhaltige organometallische Verbindung ist.

2. Organische lichtemittierende Vorrichtung (10) nach Anspruch 1, wobei:
(i) ein Gewichtsverhältnis der dritten Verbindung zur vierten Verbindung in der Emissionsschicht in einem Bereich von 100:1 bis 1:100 liegt; und/oder
(ii) die erste Verbindung ein lochtransportierender Wirt ist, und
die zweite Verbindung ein elektronentransportierender Wirt ist.

3. Organische lichtemittierende Vorrichtung (10) nach Anspruch 1 oder Anspruch 2, wobei die erste Verbindung mindestens eine Einheit umfasst, die durch eine dargestellt wird, ausgewählt aus der Formeln 3-1 bis 3-3: 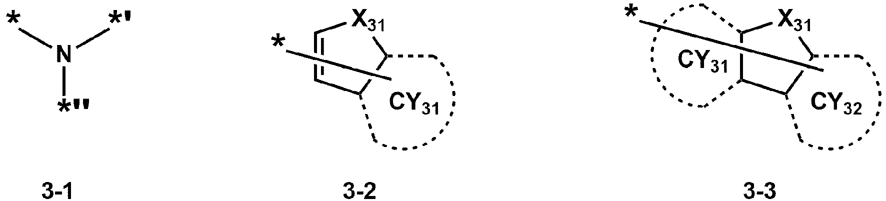
wobei in den Formeln 3-1 bis 3-3
X₃₁ aus O, S, N-(L₃₃)ₐ₃₃-(R₃₃)_{b33}, C(R₃₃)(R₃₄) und Si(R₃₃)(R₃₄) ausgewählt ist,
CY₃₁ und CY₃₂ jeweils unabhängig voneinander eine π-elektronenreiche cyclische Gruppe sind, L₃₃ aus einer Einfachbindung, einer substituierten oder unsubstituierten C₅-C₃₀ carbocyclischen Gruppe und einer substituierten oder unsubstituierten C₁-C₃₀ heterocyclischen Gruppe ausgewählt ist,
a33 eine ganze Zahl von 1 bis 10 ist,
R₃₃ und R₃₄ jeweils unabhängig aus Wasserstoff, Deuterium, -F, -Cl, -Br, -I, einer Hydroxylgruppe, einer Cyanogruppe, eine Nitrogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cyloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -Si(Q₁)(Q₂)(Q₃), -N(Q₁)(Q₂), - B(Q₁)(Q₂), -C(=O)(Q₁), -S(=O)₂(Q₁) und -P(=O)(Q₁)(Q₂) ausgewählt sind,
b33 eine ganze Zahl von 1 bis 10 ist, und
*, *' und *" jeweils eine Bindungsstelle zu einem benachbarten Atom angeben.

4. Organische lichtemittierende Vorrichtung (10) nach einem der Ansprüche 1 bis 3, wobei die erste Verbindung aus Verbindungen ausgewählt ist, die durch die Formeln 3-11 bis 3-14 dargestellt sind: 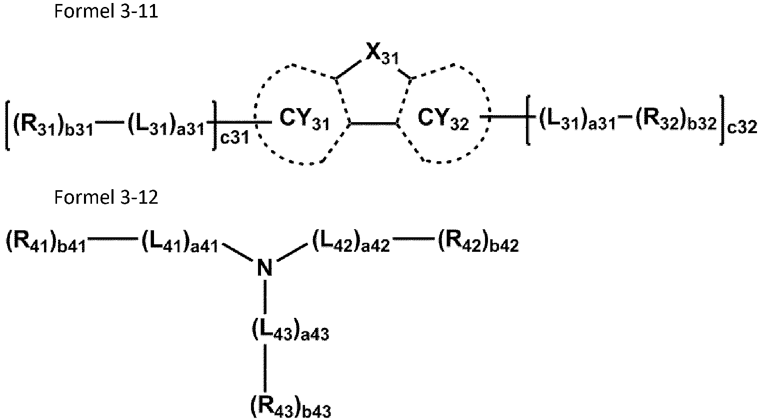 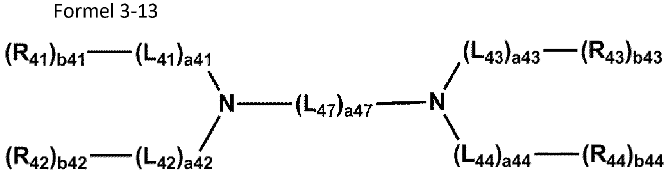 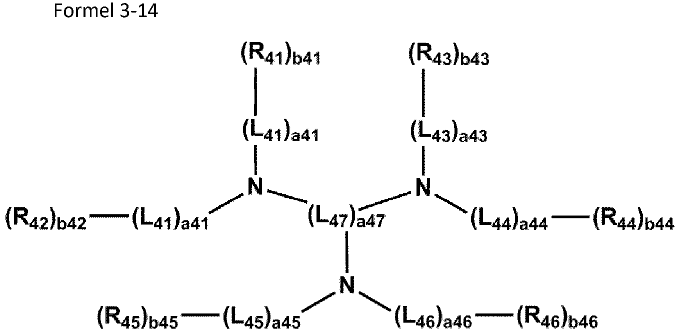
wobei in Formel 3-11,
CY₃₁ und CY₃₂ jeweils unabhängig voneinander eine π-elektronenreiche cyclische Gruppe sind, die 3 bis 30 Kohlenstoffatomen aufweist,
X₃₁ aus O, S, N-(L₃₃)ₐ₃₃-(R₃₃)_{b33}, C(R₃₃)(R₃₄) und Si(R₃₃)(R₃₄) ausgewählt ist,
c31 und c32 jeweils unabhängig voneinander ganze Zahlen von 0 bis 3 sind,
wobei in den Formeln 3-11 bis 3-14
L₃₁ bis L₃₃ und L₄₁ bis L₄₇ jeweils unabhängig aus einer Einfachbindung, einer substituierten oder unsubstituierten C₅-C₃₀ carbocyclischen Gruppe und einer substituierten oder unsubstituierten C₁-C₃₀ heterocyclischen Gruppe ausgewählt sind,
a13 bis a33 und a41 bis a47 jeweils unabhängig voneinander ganze Zahlen von 1 bis 10 sind,
R₃₁ bis R₃₄ und R₄₁ bis R₄₆ jeweils unabhängig aus Wasserstoff, Deuterium, -F, -Cl, -Br, -I, einer Hydroxylgruppe, einer Cyanogruppe, eine Nitrogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cyloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -Si(Q₁)(Q₂)(Q₃), -N(Q₁)(Q₂), - B(Q₁)(Q₂), -C(=O)(Q₁), -S(=O)₂(Q₁) und -P(=O)(Q₁)(Q₂) ausgewählt sind,
b31 bis b33 und b41 bis b46 jeweils unabhängig voneinander eine ganze Zahl von 1 bis 10 sind, und
mindestens ein Substituent der substituierten C₅-C₃₀ carbocyclischen Gruppe, der substituierten C₁-C₃₀ heterocyclischen Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nicht-aromatischen kondensierten polycyclischen Gruppe und der substituierten monovalenten nicht-aromatischen kondensierten heteropolycyclischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem ausgewählt aus Deuterium, -F, - Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe, jeweils substituiert mit mindestens einem ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig voneinander aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀ -Alkynylgruppe, einer C₁-C₆₀-Alkoxygruppe, einer C₃-C₁₀ -Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, einer Biphenylgruppe und einer Terphenylgruppe ausgewählt sind.

5. Organische lichtemittierende Vorrichtung (10) nach einem der Ansprüche 1 bis 4, wobei die zweite Verbindung eine Elektronentransporteinheit umfasst, die mindestens eines umfasst, ausgewählt aus -F, einer Cyanogruppe, einer C₁-C₆₀-Alkylgruppe substituiert mit -F oder einer Cyanogruppe, einer C₆-C₆₀-Arylgruppe substituiert mit -F oder einer Cyanogruppe und einer π-Elektronen-verarmten stickstoffhaltigen cyclischen Gruppe.

6. Organische lichtemittierende Vorrichtung (10) nach einem der Ansprüche 1 bis 5, wobei die zweite Verbindung eine Verbindung ist, die durch Formel 4-1 dargestellt ist: 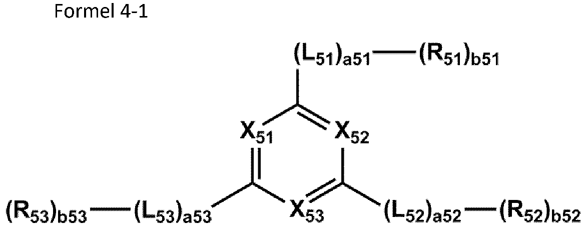
wobei in Formel 4-1
X₅₁ N oder C[(L₅₄)ₐ₅₄-(R₅₄)_{b54}] ist, X₅₂ N oder C[(L₅₅)ₐ₅₅-(R₅₅)_{b55}] ist und X₅₃ N oder C[(L₅₆)ₐ₅₆-(R₅₆)_{b56}] ist,
L₅₁ bis L₅₆ jeweils unabhängig aus einer Einfachbindung, einer substituierten oder unsubstituierten C₅-C₃₀ carbocyclischen Gruppe und einer substituierten oder unsubstituierten C₁-C₃₀ heterocyclischen Gruppe ausgewählt sind,
a51 bis a56 jeweils unabhängig voneinander ganze Zahlen von 1 bis 10 sind,
R₅₁ bis R₅₆ jeweils unabhängig aus Wasserstoff, Deuterium, -F, -Cl, -Br, -I, einer Hydroxylgruppe, einer Cyanogruppe, eine Nitrogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cyloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -Si(Q₁)(Q₂)(Q₃), -N(Q₁)(Q₂), - B(Q₁)(Q₂), -C(=O)(Q₁), -S(=O)₂(Q₁) und -P(=O)(Q₁)(Q₂) ausgewählt sind,
b51 bis b56 jeweils unabhängig voneinander eine ganze Zahl von 1 bis 10 sind, und
mindestens ein Substituent der substituierten C₅-C₃₀ carbocyclischen Gruppe, der substituierten C₁-C₃₀ heterocyclischen Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nicht-aromatischen kondensierten polycyclischen Gruppe und der substituierten monovalenten nicht-aromatischen kondensierten heteropolycyclischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem ausgewählt aus Deuterium, -F, - Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe, jeweils substituiert mit mindestens einem ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig voneinander aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀ -Alkynylgruppe, einer C₁-C₆₀-Alkoxygruppe, einer C₃-C₁₀ -Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, einer Biphenylgruppe und einer Terphenylgruppe ausgewählt sind.

7. Organische lichtemittierende Vorrichtung (10) nach einem der Ansprüche 1 bis 6, wobei die dritte Verbindung und die vierte Verbindung jeweils unabhängig voneinander eine metallorganische Verbindung sind, die durch Formel 1 dargestellt ist:
Formel 1 M(L₁)ₙ₁(L₂)ₙ₂ 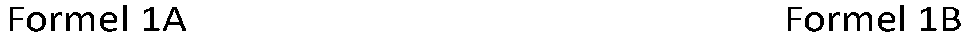 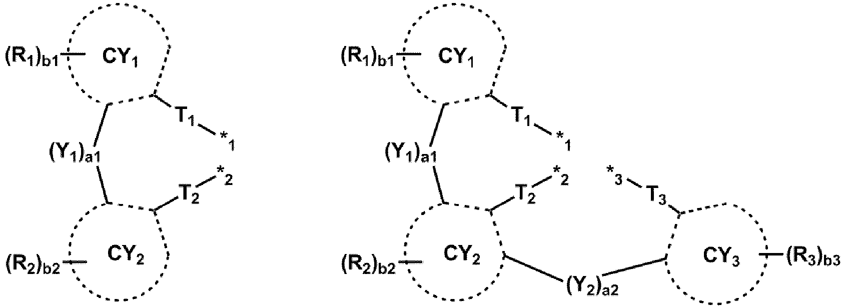 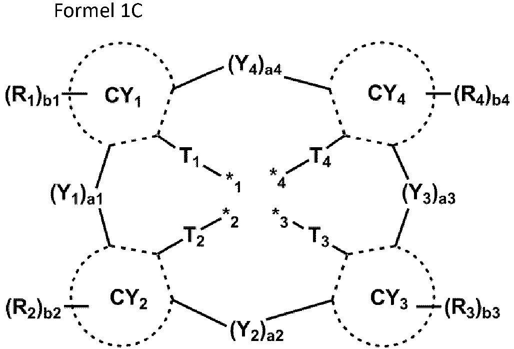
wobei in den Formeln 1 und 1A bis 1C
M aus einem Übergangsmetall der ersten Periode, einem Übergangsmetall der zweiten Periode und einem Übergangsmetall der dritten Periode ausgewählt ist, wobei M in der dritten Verbindung Platin (Pt) ist,
L₁ aus einem Liganden, der durch Formel 1A dargestellt ist, einem Liganden, der durch Formel 1B dargestellt ist, und einem Liganden, der durch Formel 1C dargestellt ist, ausgewählt ist,
L₂ aus einem monodentaten Liganden, einem bidentaten Liganden und einem tridentaten Liganden ausgewählt ist,
n1 aus 1, 2 und 3 ausgewählt ist,
n2 aus 0, 1, 2, 3 und 4 ausgewählt ist,
CY₁ bis CY₄ jeweils unabhängig voneinander aus einer C₅-C₃₀ carbocyclischen Gruppe und einer C₁-C₃₀ heterocyclischen Gruppe ausgewählt sind,
Y₁ bis Y₄ jeweils unabhängig voneinander aus einer Einfachbindung, einer Doppelbindung, einer substituierten oder unsubstituierten C₆-C₃₀-Arylengruppe, einer substituierten oder unsubstituierten C₁-C₃₀-Heteroarylengruppe, *-O-*', *-S-*', *-C(=O)-*', *-S(=O)-*', *-C(R₅)(R₆)-*', *-C(R₅)=C(R₆)-*', *-C(R₅)=*', *-Si(R₅)(R₆)-*', *-B(R₅)-*', *-N(R₅)-*' und *-P(R₅)-*' ausgewählt sind,
a1 bis a3 jeweils unabhängig voneinander aus 1, 2 und 3 ausgewählt sind,
a4 aus 0, 1, 2 und 3 ausgewählt ist, und wenn a4 0 ist, CY₂ und CY₄ nicht miteinander verbunden sind,
T₁ bis T₄ jeweils unabhängig voneinander aus einer chemischen Bindung, *-O-*', *-S-*', *-B(R₇)-*', *-N(R₇)-*', *-P(R₇)-*', *-C(R₇)(R₈)-*', *-Si(R₇)(R₈)-*', *-Ge(R₇)(R₈)-*', *-C(=O)-*' und *-C(=S)-*' ausgewählt sind,
*₁, *₂, *₃ und *₄ jeweils eine Bindungsstelle für M sind,
R₁ bis R₈ jeweils unabhängig aus Wasserstoff, Deuterium, -F, -Cl, -Br, -I, einer Hydroxylgruppe, einer Cyanogruppe, eine Nitrogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cyloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -C(Q₁)(Q₂)(Q₃), -Si(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂) und -P(=S)(Q₁)(Q₂) ausgewählt sind, wobei benachbarte Gruppen aus R₁ bis R₈ optional gebunden sind, um eine substituierte oder unsubstituierte C₅-C₆₀ carbocyclische Gruppe oder eine substituierte oder unsubstituierte C₁-C₆₀ heterocyclische Gruppe zu bilden,
benachbarte Gruppen aus R₁ bis R₈ und Y₁ bis Y₄ optional gebunden sein können, um eine substituierte oder unsubstituierte C₅-C₆₀ carbocyclische Gruppe oder eine substituierte oder unsubstituierte C₁-C₆₀ heterocyclische Gruppe zu bilden,
b1 bis b4 jeweils unabhängig voneinander eine ganze Zahl von 0 bis 10 sind, und
mindestens ein Substituent der substituierten C₆-C₃₀-Arylengruppe, der substituierten C₁-C₃₀-Heteroarylengruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nicht-aromatischen kondensierten polycyclischen Gruppe, der substituierten monovalenten nicht-aromatischen kondensierten heteropolycyclischen Gruppe, der substituierten C₅-C₆₀ carbocyclischen Gruppe und der substituierten C₁-C₆₀ heterocyclischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem ausgewählt aus Deuterium, -F, - Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe, jeweils substituiert mit mindestens einem ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig voneinander aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀ -Alkynylgruppe, einer C₁-C₆₀-Alkoxygruppe, einer C₃-C₁₀ -Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, einer Biphenylgruppe und einer Terphenylgruppe ausgewählt sind, und
* und *' jeweils eine Bindungsstelle zu einem benachbarten Atom angeben.

8. Organische lichtemittierende Vorrichtung (10) nach Anspruch 7, wobei die dritte Verbindung und die vierte Verbindung jeweils unabhängig voneinander aus Verbindungen ausgewählt sind, die durch die Formeln 1-1 und 1-2 dargestellt sind: 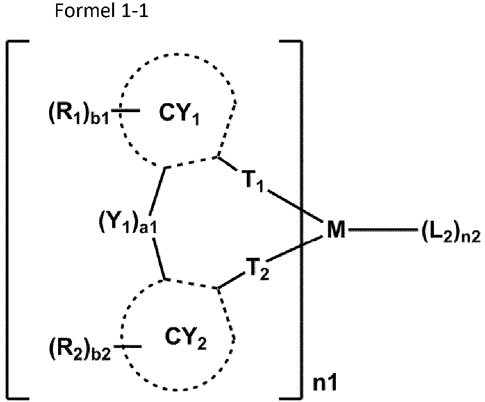 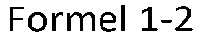 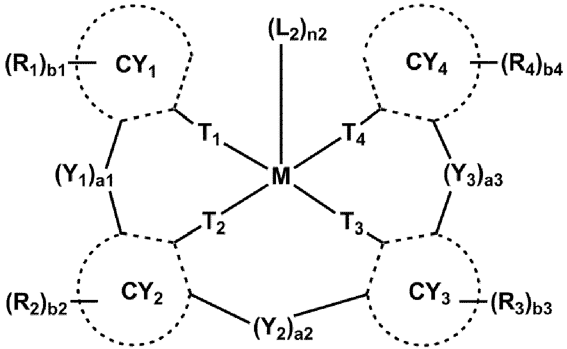
wobei in den Formeln 1-1 und 1-2
M, L₂, n1, n2, CY₁ bis CY₄, Y₁ bis Y₃, a1 bis a3, T₁ bis T₄, R₁ bis R₄ und b1 bis b4 jeweils durch Bezugnahme auf die Beschreibungen von M, L₂, n1, n2, CY₁ bis CY₄, Y₁ bis Y₃, a1 bis a3, T₁ bis T₄, R₁ bis R₄ und b1 bis b4 in den Formeln 1 und 1A bis 1C zu verstehen sind.

9. Organische lichtemittierende Vorrichtung (10) nach einem der Ansprüche 1 bis 8, wobei die dritte Verbindung eine Verbindung ist, die durch Formel 2-1 dargestellt ist, und
die vierte Verbindung eine Verbindung ist, die durch die Formel 2-2 dargestellt ist: 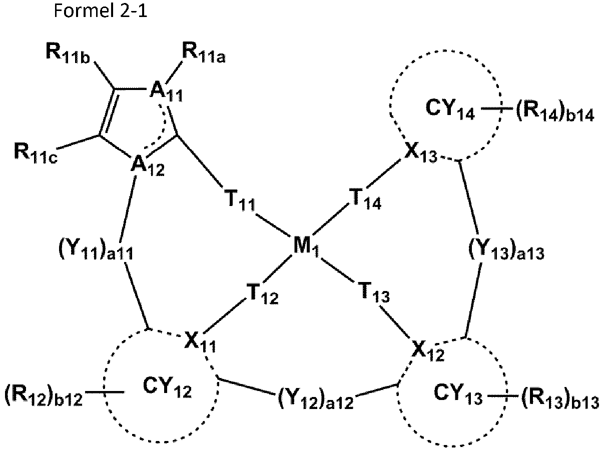 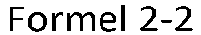 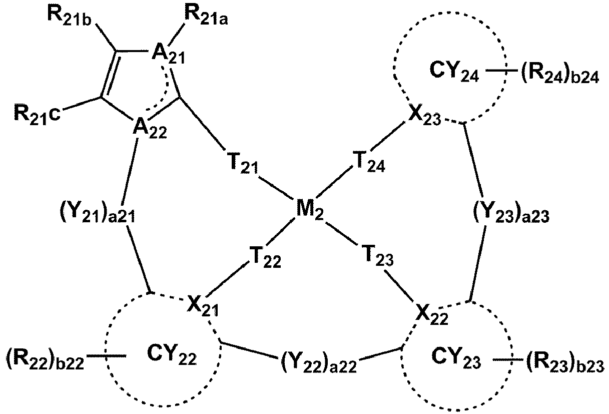
wobei in den Formeln 2-1 und 2-2
M₁ Pt ist,
M₂ aus einem Übergangsmetall der ersten Periode, einem Übergangsmetall der zweiten Periode und einem Übergangsmetall der dritten Periode ausgewählt ist,
CY₁₂ bis CY₁₄ und CY₂₂ bis CY₂₄ jeweils unabhängig voneinander aus einer C₅-C₃₀ carbocyclischen Gruppe und einer C₁-C₃₀ heterocyclischen Gruppe ausgewählt sind,
A₁₁, A₁₂, A₂₁ und A₂₂ jeweils unabhängig N oder P sind,
X₁₁ bis X₁₃ und X₂₁ bis X₂₃ jeweils unabhängig voneinander N oder C sind,
Y₁₁ bis Y₁₃ jeweils unabhängig voneinander aus einer Einfachbindung, einer Doppelbindung, einer substituierten oder unsubstituierten C₆-C₃₀-Arylengruppe, einer substituierten oder unsubstituierten C₁-C₃₀-Heteroarylengruppe, *-O-*', *-S-*', *-C(=O)-*', *-S(=O)-*', *-C(R₁₅)(R₁₆)-*', *-C(R₁₅)=C(R₁₆)-*', *-C(R₁₅)=*', *-Si(R₁₅)(R₁₆)-*', *-B(R₁₅)-*', *-N(R₁₅)-*' und *-P(R₁₅)-*' ausgewählt sind,
Y₂₁ bis Y₂₃ jeweils unabhängig voneinander aus einer Einfachbindung, einer Doppelbindung, einer substituierten oder unsubstituierten C₆-C₃₀-Arylengruppe, einer substituierten oder unsubstituierten C₁-C₃₀-Heteroarylengruppe, *-O-*', *-S-*', *-C(=O)-*', *-S(=O)-*', *-C(R₂₅)(R₂₆)-*', *-C(R₂₅)=C(R₂₆)-*', *-C(R₂₅)=*', *-Si(R₂₅)(R₂₆)-*', *-B(R₂₁)-*', *-N(R₂₅)-*' und *-P(R₂₅)-*' ausgewählt sind,
a11 bis a13 jeweils unabhängig voneinander aus 1, 2 und 3 ausgewählt sind,
a21 bis a23 jeweils unabhängig voneinander aus 1, 2 und 3 ausgewählt sind,
T₁₁ bis T₁₄ jeweils unabhängig voneinander aus einer chemischen Bindung, *-O-*', *-S-*', *-B(R₁₇)-*', *-N(R₁₇)-*', *-P(R₁₇)-*', *-C(R₁₇)(R₁₈)-*', *-Si(R₁₇)(R₁₈)-*', *-Ge(R₁₇)(R₁₈)-*', *-C(=O)-*' und *-C(=S)-*' ausgewählt sind,
T₂₁ bis T₂₄ jeweils unabhängig voneinander aus einer chemischen Bindung, *-O-*', *-S-*', *-B(R₂₇)-*', *-N(R₂₇)-*', *-P(R₂₇)-*', *-C(R₂₇)(R₂₈)-*', *-Si(R₂₇)(R₂₈)-*', *-Ge(R₂₇)(R₂₈)-*', *-C(=O)-*' und *-C(=S)-*' ausgewählt sind,
R₁₁ₐ bis R_{11c}, R₁₂ bis R₁₈, R₂₁ₐ bis R_{21c}und R₂₂ bis R₂₈ jeweils unabhängig voneinander aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -C(Q₁)(Q₂)(Q₃), -Si(Q₁)(Q₂)(Q₃), -B(Q₁)(Q₂), -N(Q₁)(Q₂), - P(Q₁)(Q₂), -C(=O)(Q₁), -S(=O)(Q₁), -S(=O)₂(Q₁), -P(=O)(Q₁)(Q₂) und -P(=S)(Q₁)(Q₂) ausgewählt sind, wobei benachbarte Gruppen aus R₁₁ₐ bis R_{11c} und R₁₂ bis R₁₈ optional so gebunden sind, dass sie eine substituierte oder unsubstituierte C₅-C₆₀ carbocyclische Gruppe oder eine substituierte oder unsubstituierte C₁-C₆₀ heterocyclische Gruppe bilden, und benachbarte Gruppen aus R₂₁ₐ bis R_{21c} und R₂₂ bis R₂₈ optional so gebunden sind, dass sie eine substituierte oder unsubstituierte C₅-C₆₀ carbocyclische Gruppe oder eine substituierte oder unsubstituierte C₁-C₆₀ heterocyclische Gruppe bilden,
b12 bis b14 und b22 bis b24 jeweils unabhängig voneinander ganze Zahlen von 0 bis 10 sind, und
mindestens ein Substituent der substituierten C₆-C₃₀-Arylengruppe, der substituierten C₁-C₃₀-Heteroarylengruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nicht-aromatischen kondensierten polycyclischen Gruppe, der substituierten monovalenten nicht-aromatischen kondensierten heteropolycyclischen Gruppe, der substituierten C₅-C₆₀ carbocyclischen Gruppe und der substituierten C₁-C₆₀ heterocyclischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem ausgewählt aus Deuterium, -F, - Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe und einer monovalenten nicht-aromatischen kondensierten heteropolycyclischen Gruppe, jeweils substituiert mit mindestens einem ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig voneinander aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀ -Alkynylgruppe, einer C₁-C₆₀-Alkoxygruppe, einer C₃-C₁₀ -Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer C₁-C₆₀-Heteroarylgruppe, einer monovalenten nicht-aromatischen kondensierten polycyclischen Gruppe, einer monovalenten nicht-aromatischen kondensierten heteropolycyclischen Gruppe, einer Biphenylgruppe und einer Terphenylgruppe ausgewählt sind, und
* und *' jeweils eine Bindungsstelle zu einem benachbarten Atom angeben.

10. Organische lichtemittierende Vorrichtung (10) nach Anspruch 9, wobei in Formel 2-1 mindestens eine, ausgewählt aus R₁₁ₐ bis R_{11c} und R₁₄, eine elektronenspendende Gruppe ist, und
in Formel 2-2 i) mindestens eine, ausgewählt aus R₂₂ und R₂₃, ein anderer Substituent als Wasserstoff ist, ii) Y₂₃ *-N(R₂₅)-*' ist und R₂₅ eine substituierte C₆-C₆₀-Arylgruppe ist, oder iii) mindestens eine, ausgewählt aus R₂₂ und R₂₃, ein anderer Substituent als Wasserstoff ist, Y₂₃ *-N(R₂₅)-*' ist und R₂₅ eine substituierte C₆-C₆₀-Arylgruppe ist, wobei optional die elektronenspendende Gruppe ein Substituent ist, ausgewählt aus einer Isopropylgruppe, einer tert-Butylgruppe und Gruppen, die durch die Formeln 10-1 bis 10-61 dargestellt sind: 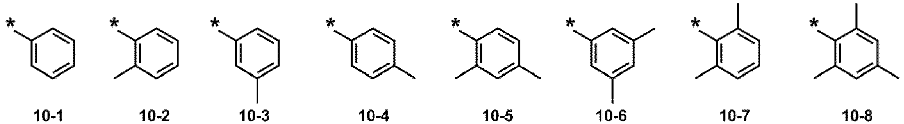 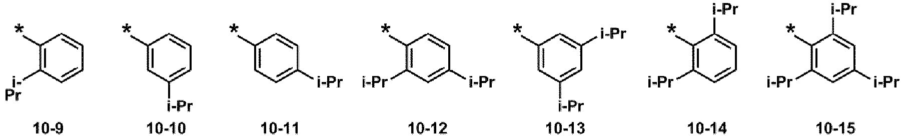 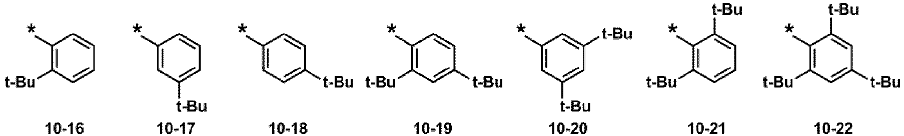 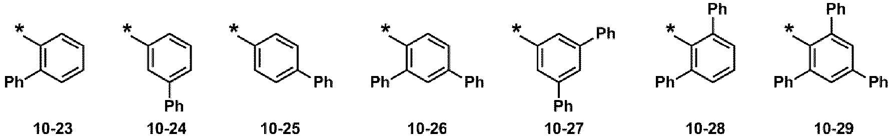 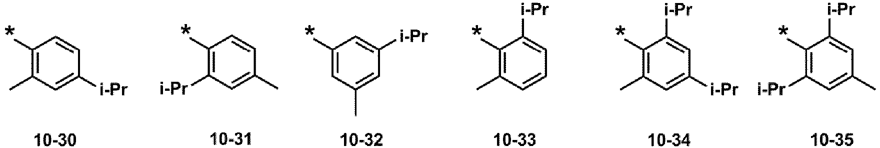 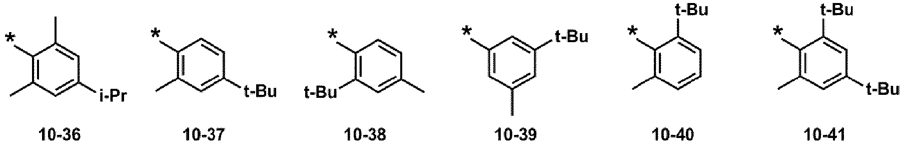 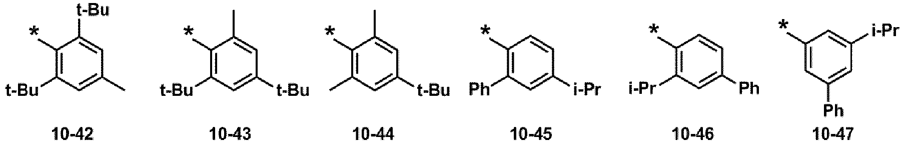 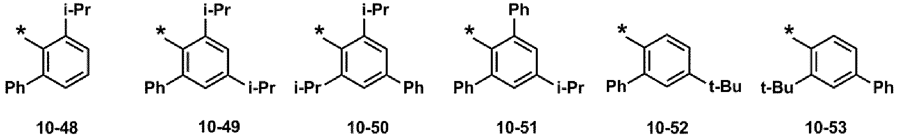 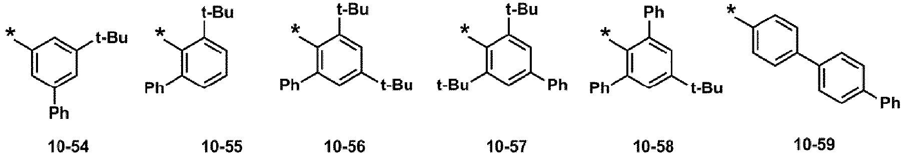 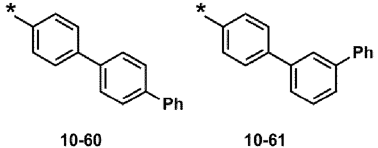
wobei in den Formeln 10-1 bis 10-61
"i-Pr" eine Isopropylgruppe darstellt, "t-Bu" eine t-Butylgruppe darstellt,
"Ph" eine Phenylgruppe darstellt, und
* eine Bindungsstelle zu einem benachbarten Atom angibt.

11. Organische lichtemittierende Vorrichtung (10) nach Anspruch 9 oder Anspruch 10, wobei die dritte Verbindung eine organometallische Verbindung ist, die durch Formel 2-1A oder Formel 2-1B dargestellt ist, und
die vierte Verbindung eine organometallische Verbindung ist, die durch die Formel 2-2A dargestellt ist: 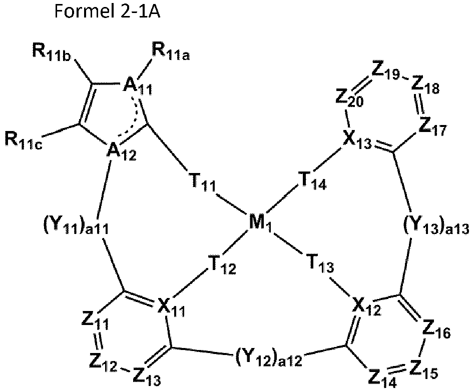 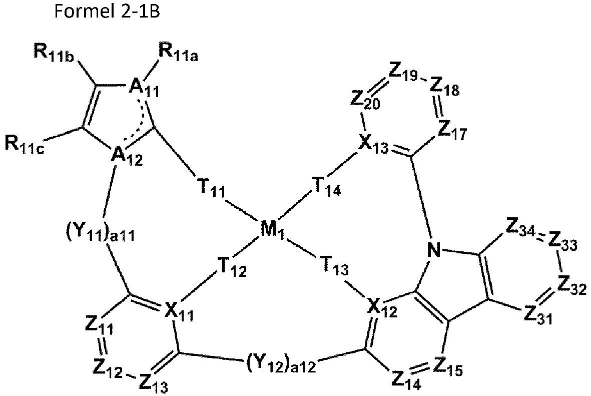 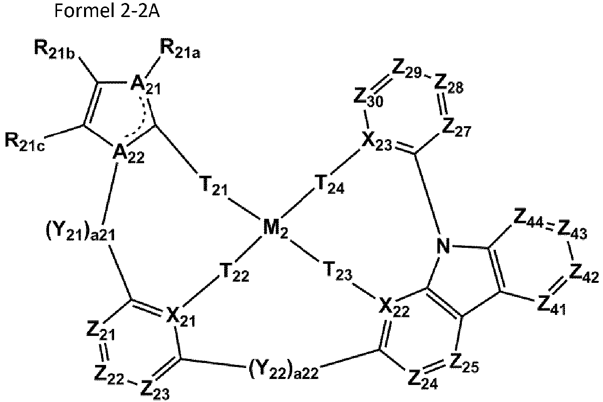
wobei in den Formeln 2-1A, 2-1B und 2-2A Z₁₁ C(R₁₂ₐ) oder N ist, Z₁₂ C(R_{12b}) oder N ist, Z₁₃ C(R_{12c}) oder N ist, Z₁₄ C(R₁₃ₐ) oder N ist, Z₁₅ C(R_{13b}) oder N ist, Z₁₆ C(R_{13c}) oder N ist, Z₁₇ C(R₁₄ₐ) oder N ist, Z₁₈ C(R_{14b}) oder N ist, Z₁₉ C(R_{14c}) oder N ist, Z₂₀ C(R_{14d}) oder N ist, Z₃₁ C(R₁₅ₐ) oder N ist, Z₃₂ C(R_{15b}) oder N ist, Z₃₃ C(R_{15c}) oder N ist und Z₃₄ C(R_{15d}) oder N ist,
Z₂₁ C(R₂₂ₐ) oder N ist, Z₂₂ C(R_{22b}) oder N ist, Z₂₃ C(R_{22c}) oder N ist, Z₂₄ C(R₂₃ₐ) oder N ist, Z₂₅ C(R_{23b}) oder N ist, Z₂₇ C(R₂₄ₐ) oder N ist, Z₂₈ C(R_{24b}) oder N ist, Z₂₉ C(R_{24c}) oder N ist, Z₃₀ C(R_{24d}) oder N ist, Z₄₁ C(R₂₅ₐ) oder N ist, Z₄₂ C(R_{25b}) oder N ist, Z₄₃ C(R_{25c}) oder N ist und Z₄₄ C(R_{25d}) oder N ist,
R₁₂ₐ bis R_{12c} jeweils durch Bezugnahme auf die Beschreibung von R₁₂ in Formel 2-1 zu verstehen sind,
R₁₃ₐ bis R_{13c} jeweils durch Bezugnahme auf die Beschreibung von R₁₃ in Formel 2-1 zu verstehen sind,
R₁₄ₐ bis R_{14c} jeweils durch Bezugnahme auf die Beschreibung von R₁₄ in Formel 2-1 zu verstehen sind,
R₁₅ₐ bis R_{15c} jeweils durch Bezugnahme auf die Beschreibung von R₁₅ in Formel 2-1 zu verstehen sind,
R₂₂ₐ bis R_{22c} jeweils durch Bezugnahme auf die Beschreibung von R₂₂ in Formel 2-2 zu verstehen sind,
R₂₃ₐ bis R_{23c} jeweils durch Bezugnahme auf die Beschreibung von R₂₃ in Formel 2-2 zu verstehen sind,
R₂₄ₐ bis R_{24d} jeweils durch Bezugnahme auf die Beschreibung von R₂₄ in Formel 2-2 zu verstehen sind,
R₂₅ₐ bis R_{25d} jeweils durch Bezugnahme auf die Beschreibung von R₂₅ in Formel 2-2 zu verstehen sind, und
M₁, M₂, A₁₁, A₁₂, A₂₁, A₂₂, X₁₁ bis X₁₃, X₂₁ bis X₂₃, Y₁₁ bis Y₁₃, Y₂₁ bis Y₂₃, a11 bis a13, a21 bis a23, T₁₁ bis T₁₄, T₂₁ bis T₂₄, R₁₁ₐ bis R_{11c} und R₂₁ₐ bis R_{21c} jeweils unter Bezugnahme auf die Beschreibungen von M₁, M₂, A₁₁, A₁₂, A₂₁, A₂₂, X₁₁ bis X₁₃, X₂₁ bis X₂₃, Y₁₁ bis Y₁₃, Y₂₁ bis Y₂₃, a11 bis a13, a21 bis a23, T₁₁ bis T₁₄, T₂₁ bis T₂₄, R₁₁ₐ bis R_{11c} und R₂₁ₐ bis R_{21c} in den Formeln 2-1 und 2-2 zu verstehen sind.

12. Organische lichtemittierende Vorrichtung (10) nach einem der Ansprüche 1 bis 11, wobei:
(i) der Gesamtgehalt der dritten Verbindung und der vierten Verbindung in einem Bereich von 1 Volumenprozent (Vol%) bis 50 Vol%, basierend auf dem Gesamtvolumen der ersten Verbindung und der zweiten Verbindung in der Emissionsschicht liegt; und/oder
(ii) die organische lichtemittierende Vorrichtung ferner eine Deckschicht (220) auf der zweiten Elektrode (190) umfasst,
wobei die Deckschicht (220) einen Brechungsindex von 1,6 oder größer bei einer Wellenlänge von 589 Nanometern (nm) aufweist.

13. Organische lichtemittierende Vorrichtung (10) nach einem der Ansprüche 1 bis 12, wobei die Emissionsschicht eine dritte Emissionsschicht umfasst,
die zweite Emissionsschicht zwischen der ersten Elektrode (110) und der dritten Emissionsschicht liegt,
die dritte Emissionsschicht die erste Verbindung, die zweite Verbindung und einen dritten Dotierstoff umfasst,
der erste Dotierstoff und der dritte Dotierstoff jeweils eine sind, ausgewählt aus der dritten Verbindung und der vierten Verbindung, und
der zweite Dotierstoff sich von dem ersten Dotierstoff und dem dritten Dotierstoff unterscheidet und der andere aus der dritten Verbindung und der vierten Verbindung ausgewählt ist.

14. Elektronische Einrichtung, umfassend: einen Dünnschichttransistor, der eine Source-Elektrode, eine Drain-Elektrode und eine aktive Schicht umfasst; und die organische lichtemittierende Vorrichtung (10) nach einem der Ansprüche 1 bis 13, wobei die erste Elektrode (110) der organischen lichtemittierenden Vorrichtung (10) elektrisch mit einer gekoppelt ist, ausgewählt aus der Source-Elektrode und der Drain-Elektrode des Dünnschichttransistors.

## Revendications

1. Dispositif électroluminescent organique (10) comprenant :
une première électrode (110) ;
une deuxième électrode (190) faisant face à la première électrode (110) ; et
une couche organique (150) entre la première électrode (110) et la deuxième électrode (190) et comprenant une couche d'émission,
dans lequel la couche d'émission comprend un hôte et un dopant,
l'hôte comprend un premier composé et un deuxième composé différent du premier composé,
le dopant comprend un troisième composé et un quatrième composé différent du troisième composé,
dans lequel la couche d'émission comprend une première couche d'émission et une deuxième couche d'émission,
la première couche d'émission se situe entre la première électrode (110) et la deuxième couche d'émission,
la première couche d'émission comprend le premier composé, le deuxième composé et un premier dopant,
la deuxième couche d'émission comprend le premier composé, le deuxième composé et un deuxième dopant,
le premier dopant est choisi parmi le troisième et le quatrième composé, et
le deuxième dopant est différent du premier dopant et est l'autre sélectionné parmi le troisième et le quatrième composé,
dans lequel une différence entre la longueur d'onde d'émission maximale de la lumière émise par la première couche d'émission et une longueur d'onde d'émission maximale de la lumière émise par la deuxième couche d'émission se situe dans une plage de 0 nm à 35 nm, **caractérisé en ce que** la première couche d'émission et la deuxième couche d'émission émettent chacune de la lumière bleue et **en ce que** le troisième composé est un composé organométallique contenant du platine.

2. Dispositif électroluminescent organique (10) selon la revendication 1, dans lequel :
(i) le rapport en poids du troisième composé au quatrième composé dans la couche d'émission se situe dans une plage de 100:1 à 1:100 ; et/ou
(ii) le premier composé est un hôte transporteur de trous, et
le deuxième composé est un hôte transporteur d'électrons.

3. Dispositif électroluminescent organique (10) selon la revendication 1 ou la revendication 2, dans lequel le premier composé comprend au moins un fragment représenté par l'une quelconque des formules 3-1 à 3-3 : 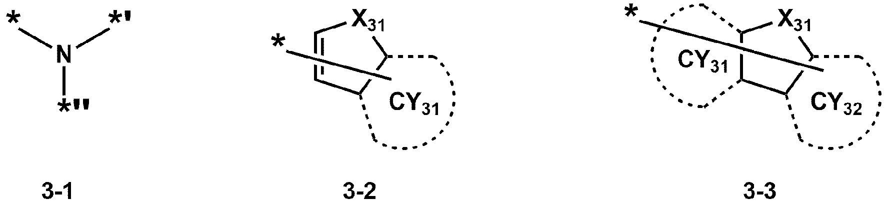
dans lequel, dans les formules 3-1 à 3-3,
X₃₁ est sélectionné parmi O, S, N-(L₃₃)ₐ₃₃-(R₃₃)_{b33}, C(R₃₃)(R₃₄), et Si(R₃₃)(R₃₄),
CY₃₁ et CY₃₂ sont chacun indépendamment un groupe cyclique riche en électrons π,
L₃₃ est sélectionné parmi une liaison simple, un groupe carbocyclique C₅-C₃₀ substitué ou non substitué, et un groupe hétérocyclique C₁-C₃₀ substitué ou non substitué,
a33 est un entier de 1 à 10,
R₃₃ et R₃₄ sont chacun indépendamment sélectionnés parmi l'hydrogène, le deutérium, un -F, - Cl, -Br, -I, un groupe hydroxyle, un groupe cyano, un groupe nitro, un groupe amidino, un groupe hydrazino, un groupe hydrazono, un groupe acide carboxylique ou un sel de celui-ci, un groupe d'acide sulfonique ou un sel de celui-ci, un groupe d'acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non-aromatique monovalent substitué ou non substitué, un groupe hétéropolycyclique condensé non-aromatique monovalent substitué ou non substitué, un -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂),
b33 est un entier compris entre 1 et 10, et
*, *', et *" indiquent chacun un site de liaison à un atome adjacent.

4. Dispositif électroluminescent organique (10) selon l'une quelconque des revendications 1 à 3, dans lequel le premier composé est sélectionné parmi les composés représentés par les formules 3-11 à 3-14 : 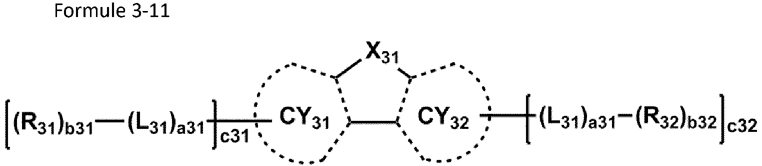 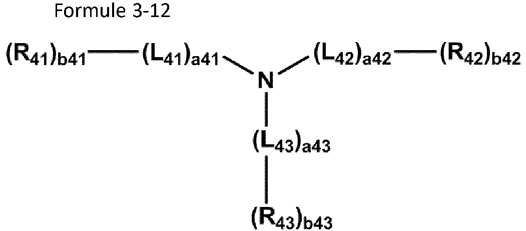 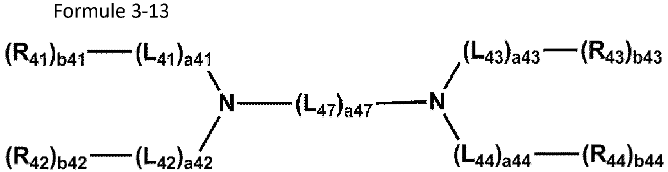 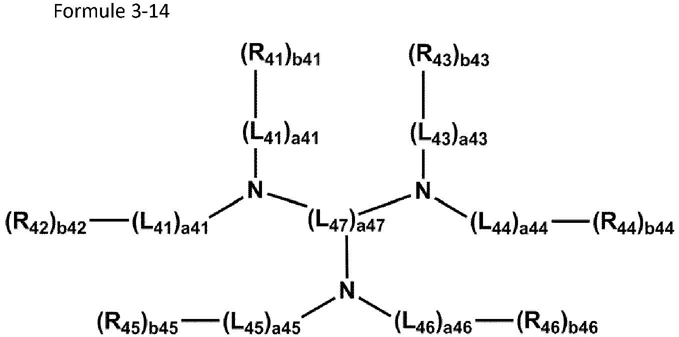
dans lequel, dans la formule 3-11,
CY₃₁ et CY₃₂ sont chacun indépendamment un groupe cyclique riche en électrons π présentant de 3 à 30 atomes de carbone,
X₃₁ est sélectionné parmi O, S, N-(L₃₃)ₐ₃₃-(R₃₃)_{b33}, C(R₃₃)(R₃₄), et Si(R₃₃)(R₃₄),
c31 et c32 sont chacun indépendamment un entier compris entre 0 et 3,
dans lequel, dans les formules 3-11 à 3-14,
L₃₁ à L₃₃ et L₄₁ à L₄₇ sont chacun sélectionnés indépendamment parmi une liaison simple, un groupe carbocyclique en C₅-C₃₀ substitué ou non substitué, et un groupe hétérocyclique en C₁-C₃₀ substitué ou non substitué,
a31 à a33 et a41 à a47 sont chacun indépendamment un entier de 1 à 10,
R₃₁ à R₃₄ et R₄₁ à R₄₆ sont chacun indépendamment sélectionnés parmi l'hydrogène, le deutérium, un -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non-aromatique monovalent, un groupe hétéropolycyclique condensé non-aromatique monovalent substitué ou non substitué, un - Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂),
b31 à b33 et b41 à b46 sont chacun indépendamment un entier de 1 à 10, et
au moins un substituant du groupe carbocyclique en C₅-C₃₀ substitué, du groupe hétérocyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent, et du groupe hétéropolycyclique condensé non-aromatique monovalent substitué est sélectionné parmi :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀ et un groupe alcynyle en C₂-C₆₀ ; et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun substitué par au moins un élément sélectionné parmi du deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, un -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique, chacun substitué par au moins un groupe choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé monovalent non aromatique, un groupe hétéropolycyclique condensé monovalent non aromatique, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou -P(=O)(Q₃₁)(Q₃₂),
dans lequel Q₁ à Q₃, Q₁₁ à Q₁₃, Q₂₁ à Q₂₃, et Q₃₁ à Q₃₃ sont chacun choisis indépendamment parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryle en C₆-C₆₀ substitué par un groupe alkyle en C₁-C₆₀, un groupe aryle en C₆-C₆₀ substitué par un groupe aryle en C₆-C₆₀, un groupe hétéroaryle en C₁-C₆₀, un groupe polycyclique condensé non aromatique monovalent, un groupe hétéropolycyclique condensé non-aromatique monovalent, un groupe biphényle et un groupe terphényle.

5. Dispositif électroluminescent organique (10) selon l'une quelconque des revendications 1 à 4, dans lequel le deuxième composé comprend un fragment de transport d'électrons comprenant au moins un groupe choisi parmi -F, un groupe cyano, un groupe alkyle en C₁-C₆₀ substitué par -F ou un groupe cyano, un groupe aryle en C₆-C₆₀ substitué par -F ou un groupe cyano, et un groupe cyclique contenant de l'azote appauvri en électrons π.

6. Dispositif électroluminescent organique (10) selon l'une quelconque des revendications 1 à 5, dans lequel le deuxième composé est un composé représenté par la formule 4-1 : 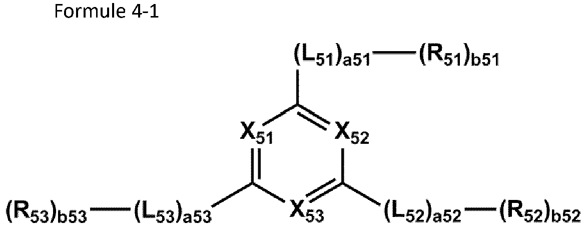
dans lequel, dans la formule 4-1,
X₅₁ est un N ou C[(L₅₄)ₐ₅₄-(R₅₄)_{b54}], X₅₂ est un N ou C[(L₅₅)ₐ₅₅-(R₅₅)_{b55}], et X₅₃ est un N ou C[(L₅₆)ₐ₅₆-(R₅₆)_{b56}],
L₅₁ à L₅₆ sont chacun indépendamment sélectionnés parmi une liaison simple, un groupe carbocyclique en C₅-C₃₀ substitué ou non substitué, et un groupe hétérocyclique en C₁-C₃₀ substitué ou non substitué,
a51 à a56 sont chacun indépendamment un entier compris entre 1 et 10,
R₅₁ et R₅₆ sont chacun indépendamment sélectionnés parmi l'hydrogène, le deutérium, un -F, - Cl, -Br, -I, un groupe hydroxyle, un groupe cyano, un groupe nitro, un groupe amidino, un groupe hydrazino, un groupe hydrazono, un groupe acide carboxylique ou un sel de celui-ci, un groupe d'acide sulfonique ou un sel de celui-ci, un groupe d'acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non-aromatique monovalent substitué ou non substitué, un groupe hétéropolycyclique condensé non-aromatique monovalent substitué ou non substitué, un -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂),
b51 à b56 sont chacun indépendamment un entier compris entre 1 et 10, et
au moins un substituant du groupe carbocyclique en C₅-C₃₀ substitué, du groupe hétérocyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent, et du groupe hétéropolycyclique condensé non-aromatique monovalent substitué est sélectionné parmi :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀ et un groupe alcynyle en C₂-C₆₀ ; et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun substitué par au moins un élément sélectionné parmi du deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, un -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique, chacun substitué par au moins un groupe choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé monovalent non aromatique, un groupe hétéropolycyclique condensé monovalent non aromatique, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou -P(=O)(Q₃₁)(Q₃₂),
dans lequel Q₁ à Q₃, Q₁₁ à Q₁₃, Q₂₁ à Q₂₃, et Q₃₁ à Q₃₃ sont chacun choisis indépendamment parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryle en C₆-C₆₀ substitué par un groupe alkyle en C₁-C₆₀, un groupe aryle en C₆-C₆₀ substitué par un groupe aryle en C₆-C₆₀, un groupe hétéroaryle en C₁-C₆₀, un groupe polycyclique condensé non aromatique monovalent, un groupe hétéropolycyclique condensé non-aromatique monovalent, un groupe biphényle et un groupe terphényle.

7. Dispositif électroluminescent organique (10) selon l'une quelconque des revendications 1 à 6, dans lequel le troisième composé et le quatrième composé sont chacun indépendamment un composé organométallique représenté par la formule 1 :
Formule 1 M(L₁)ₙ₁(L₂)ₙ₂ 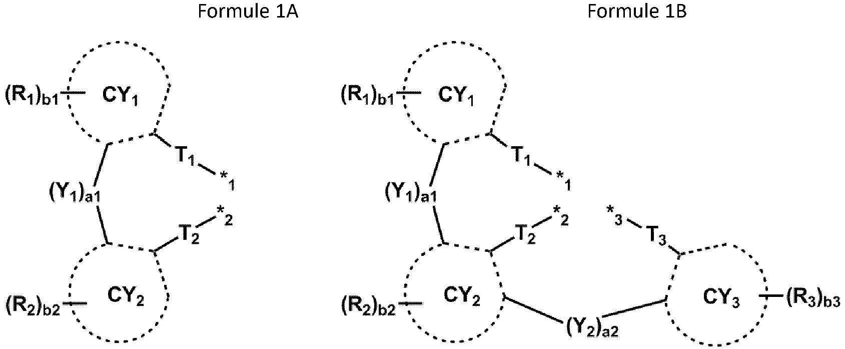 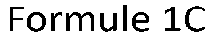 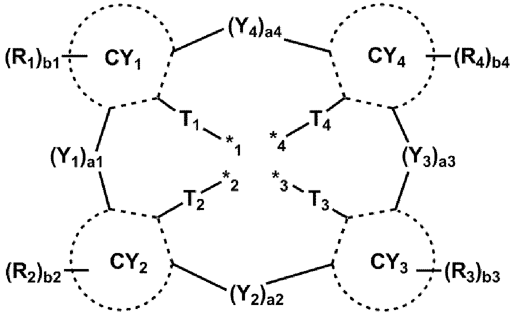
dans lequel, dans les formules 1 et 1A à 1C,
M est choisi parmi un métal de transition de la première période, un métal de transition de la deuxième période et un métal de transition de la troisième période, dans lequel M dans le troisième composé est le platine (Pt),
L₁ est sélectionné parmi un ligand représenté par la formule 1A, un ligand représenté par la formule 1B et un ligand représenté par la formule 1C,
L₂ est sélectionné parmi un ligand monodentate, un ligand bidentate et un ligand tridentate,
n1 est sélectionné parmi 1, 2 et 3,
n2 est sélectionné parmi 0, 1, 2, 3 et 4,
CY₁ à CY₄ sont chacun sélectionnés indépendamment parmi un groupe carbocyclique en C₅-C₃₀ et un groupe hétérocyclique en C₁-C₃₀,
Y₁ à Y₄ sont chacun sélectionnés indépendamment parmi une liaison simple, une liaison double, un groupe arylène en C₆-C₃₀ substitué ou non substitué, un groupe hétéroarylène en C₁-C₃₀ substitué ou non substitué, *-O-*', *-S-*', *-C(=O)-*', *-S(=O)-*', *-C(R₅)(R₆)-*', *-C(R₅)=C(R₆)-*', *-C(R₅)=*', *-Si(R₅)(R₆)-*', *-B(R₅)-*', *-N(R₅)-*', et *-P(R₅)-*',
Les valeurs a1 à a3 sont chacune sélectionnées indépendamment parmi 1, 2 et 3.
a4 est sélectionné parmi 0, 1, 2 et 3, et lorsque a4 vaut 0, CY₂ et CY₄ ne sont pas connectés l'un à l'autre,
T₁ à T₄ sont chacun sélectionnés indépendamment à partir d'une liaison chimique, *-O-*', *-S-*', *-B(R₇)-*', *-N(R₇)-*', *-P(R₇)-*', *-C(R₇)(R₈)-*', *-Si(R₇)(R₈)-*', *-Ge(R₇)(R₈)-*', *-C(=O)-*', et *-C(=S)-*',
*₁, *₂, *₃et *₄ sont chacun un site de liaison à M,
R₁ à R₈ sont chacun indépendamment sélectionnés parmi l'hydrogène, le deutérium, un -F, -Cl, -Br, -I, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non-aromatique monovalent substitué ou non substitué, un groupe hétéropolycyclique condensé non-aromatique monovalent substitué ou non substitué, un -C(Q₁)(Q₂)(Q₃), -Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), et -P(=S)(Q₁)(Q₂), dans lequel des groupes adjacents provenant de R₁ à R₈ sont éventuellement liés pour former un groupe carbocyclique en C₅-C₆₀ substitué ou non substitué ou un groupe hétérocyclique en C₁-C₆₀ substitué ou non substitué,
des groupes adjacents parmi R₁ à R₈ et Y₁ à Y₄ sont éventuellement liés pour former un groupe carbocyclique en C₅-C₆₀ substitué ou non substitué ou un groupe hétérocyclique en C₁-C₆₀ substitué ou non substitué,
b1 à b4 sont chacun indépendamment un entier compris entre 0 et 10, et
au moins un substituant du groupe arylène en C₆-C₃₀ substitué, du groupe hétéroarylène en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent substitué, du groupe hétéropolycyclique condensé non aromatique monovalent substitué, du groupe carbocyclique en C₅-C₆₀ substitué et du groupe hétérocyclique en C₁-C₆₀ est sélectionné parmi :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀ et un groupe alcynyle en C₂-C₆₀ ; et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun substitué par au moins un élément sélectionné parmi du deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, un -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique, chacun substitué par au moins un groupe choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé monovalent non aromatique, un groupe hétéropolycyclique condensé monovalent non aromatique, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou -P(=O)(Q₃₁)(Q₃₂),
dans lequel Q₁ à Q₃, Q₁₁ à Q₁₃, Q₂₁ à Q₂₃, et Q₃₁ à Q₃₃ sont chacun choisis indépendamment parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryle en C₆-C₆₀ substitué par un groupe alkyle en C₁-C₆₀, un groupe aryle en C₆-C₆₀ substitué par un groupe aryle en C₆-C₆₀, un groupe hétéroaryle en C₁-C₆₀, un groupe polycyclique condensé non aromatique monovalent, un groupe hétéropolycyclique condensé non-aromatique monovalent, un groupe biphényle et un groupe terphényle, et
* et *' indiquent chacun un site de liaison avec un atome adjacent.

8. Dispositif électroluminescent organique (10) selon la revendication 7, dans lequel le troisième composé et le quatrième composé sont chacun indépendamment sélectionnés parmi les composés représentés par les formules 1-1 et 1-2 : 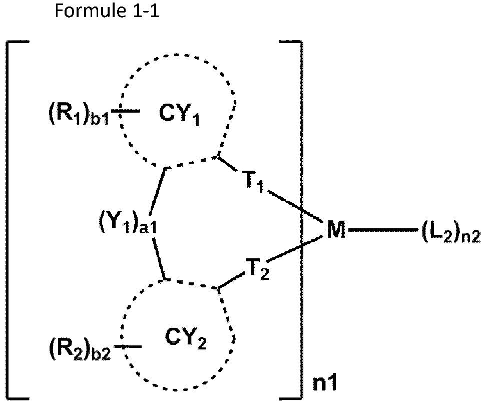 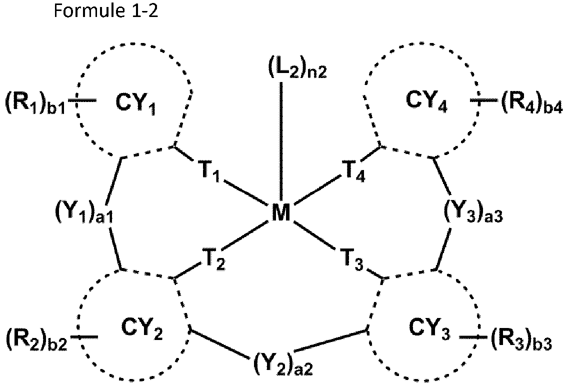
dans lequel, dans les formules 1-1 et 1-2,
M, L₂, n1, n2, CY₁ à CY₄, Y₁ à Y₃, a1 à a3, T₁ à T₄, R₁ à R₄, et b1 à b4 sont respectivement compris en se référant aux descriptions de M, L₂, n1, n2, CY₁ à CY₄, Y₁ à Y₃, a1 à a3, T₁ à T₄, R₁ à R₄, et b1 à b4 dans les formules 1 et 1A à 1C.

9. Dispositif électroluminescent organique (10) selon l'une quelconque des revendications 1 à 8, dans lequel le troisième composé est un composé représenté par la formule 2-1, et
le quatrième composé est un composé représenté par la formule 2-2 : 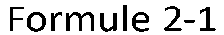 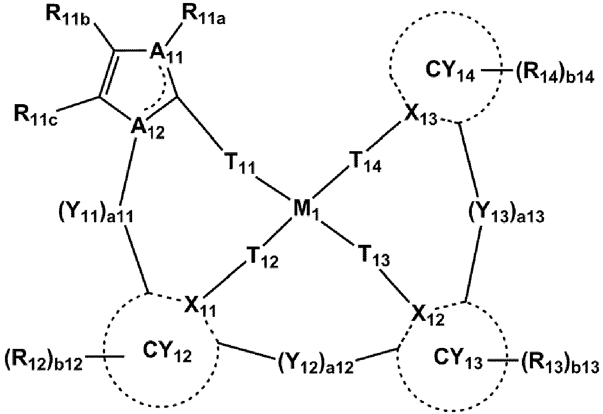 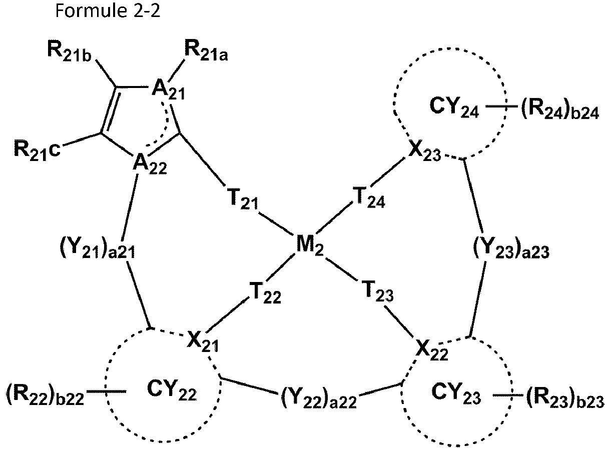
dans lequel, dans les formules 2-1 et 2-2,
M₁ est Pt,
M₂ est choisi parmi un métal de transition de la première période, un métal de transition de la deuxième période et un métal de transition de la troisième période,
CY₁₂ à CY₁₄ et CY₂₂ à CY₂₄ sont chacun sélectionnés indépendamment parmi un groupe carbocyclique en C₅-C₃₀ et un groupe hétérocyclique en C₁-C₃₀,
A₁₁, A₁₂, A₂₁, et A₂₂ sont chacun indépendamment N ou P,
X₁₁ à X₁₃ et X₂₁ à X₂₃ sont chacun indépendamment N ou C,
Y₁₁ à Y₁₃ sont chacun sélectionnés indépendamment parmi une liaison simple, une liaison double, un groupe arylène en C₆-C₃₀ substitué ou non substitué, un groupe hétéroarylène en C₁-C₃₀ substitué ou non substitué, *-O-*', *-S-*', *-C(=O)-*', *-S(=O)-*', *-C(R₁₅)(R₁₆)-*", *-C(R₁₅)=C(R₁₆)-*', *-C(R₁₅)=*', *-Si(R₁₅)(R₁₆)-*", *-B(R₁₅)-*', *-N(R₁₅)-*', et *-P(R₁₅)-*',
Y₂₁ à Y₂₃ sont chacun sélectionnés indépendamment parmi une liaison simple, une liaison double, un groupe arylène en C₆-C₃₀ substitué ou non substitué, un groupe hétéroarylène en C₁-C₃₀ substitué ou non substitué, *-O-*', *-S-*', *-C(=O)-*', *-S(=O)-*', *-C(R₂₅)(R₂₆)-*', *-C(R₂₅)=C(R₂₆)-*', *-C(R₂₅)=*', *-Si(R₂₅)(R₂₆)-*', *-B(R₂₅)-*', *-N(R₂₅)-*', et *-P(R₂₅)-*',
les valeurs a11 à a13 sont chacune sélectionnées indépendamment parmi 1, 2 et 3.
Les valeurs a21 à a23 sont chacune sélectionnées indépendamment parmi 1, 2 et 3.
T₁₁ à T₁₄ sont chacun sélectionnés indépendamment à partir d'une liaison chimique, *-O-*', *-S-*', *-B(R₁₇)-*', *-N(R₁₇)-*', *-P(R₁₇)-*', *-C(R₁₇)(R₁₈)-*', *-Si(R₁₇)(R₁₈)-*', *-Ge(R₁₇)(R₁₈)-*', *-C(=O)-*', et *-C(=S)-*',
T₂₁ à T₂₄ sont chacun sélectionnés indépendamment à partir d'une liaison chimique, *-O-*', *-S-*', *-B(R₂₇)-*', *-N(R₂₇)-*', *-P(R₂₇)-*', *-C(R₂₇)(R₂₈)-*', *-Si(R₂₇)(R₂₈)-*', *-Ge(R₂₇)(R₂₈)-*', *-C(=O)-*', et *-C(=S)-*',
R₁₁ₐ à R_{11c}, R₁₂ à R₁₈, R₂₁ₐ à R_{21c}, et R₂₂ à R₂₈ sont chacun indépendamment sélectionnés parmi l'hydrogène, le deutérium, -F, -Cl, -Br, -I, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non-aromatique monovalent substitué ou non substitué, un groupe hétéropolycyclique condensé non-aromatique monovalent substitué ou non substitué, un -C(Q₁)(Q₂)(Q₃), -Si(Q₁)(Q₂)(Q₃), -B(Q₁)(Q₂), - N(Q₁)(Q₂), -P(Q₁)(Q₂), -C(=O)(Q₁), -S(=O)(Q₁), -S(=O)₂(Q₁), -P(=O)(Q₁)(Q₂), et -P(=S)(Q₁)(Q₂), dans lequel des groupes adjacents parmi R₁₁ₐ à R_{11c} et R₁₂ à R₁₈ sont éventuellement liés pour former un groupe carbocyclique en C₅-C₆₀ substitué ou non substitué, un groupe hétérocyclique en C₁-C₆₀ substitué ou non substitué, et des groupes adjacents parmi R₂₁ₐ à R_{21c} et R₂₂ à R₂₈ sont éventuellement liés pour former un groupe carbocyclique en C₅-C₆₀ substitué ou non substitué ou un groupe hétérocyclique en C₁-C₆₀ substitué ou non substitué,
b12 à b14 et b22 à b24 sont chacun indépendamment un entier de 0 à 10, et
au moins un substituant du groupe arylène en C₆-C₃₀ substitué, du groupe hétéroarylène en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent substitué, du groupe hétéropolycyclique condensé non aromatique monovalent substitué, du groupe carbocyclique en C₅-C₆₀ substitué et du groupe hétérocyclique en C₁-C₆₀ est sélectionné parmi :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀ et un groupe alcynyle en C₂-C₆₀ ; et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun substitué par au moins un élément sélectionné parmi du deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, un -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₁-C₆₀, un groupe arylthio en C₆-C₆₀, un groupe hétéroaryle en C₁-C₆₀, un groupe polycyclique condensé monovalent non aromatique et un groupe hétéropolycyclique condensé monovalent non aromatique, chacun substitué par au moins un groupe choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé monovalent non aromatique, un groupe hétéropolycyclique condensé monovalent non aromatique, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), ou -P(=O)(Q₃₁)(Q₃₂),
dans lequel Q₁ à Q₃, Q₁₁ à Q₁₃, Q₂₁ à Q₂₃, et Q₃₁ à Q₃₃ sont chacun choisis indépendamment parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryle en C₆-C₆₀ substitué par un groupe alkyle en C₁-C₆₀, un groupe aryle en C₆-C₆₀ substitué par un groupe aryle en C₆-C₆₀, un groupe hétéroaryle en C₁-C₆₀, un groupe polycyclique condensé non aromatique monovalent, un groupe hétéropolycyclique condensé non-aromatique monovalent, un groupe biphényle et un groupe terphényle, et
* et *' indiquent chacun un site de liaison avec un atome adjacent.

10. Dispositif électroluminescent organique (10) selon la revendication 9, dans lequel, dans la formule 2-1, au moins un groupe choisi parmi R₁₁ₐ à R_{11c} et R₁₄ est un groupe donneur d'électrons, et
dans la formule 2-2, i) au moins un substituant choisi parmi R₂₂ et R₂₃ est autre qu'un hydrogène, ii) Y₂₃ est *-N(R₂₅)-*', et R₂₅ est un groupe aryle substitué en C₆-C₆₀, ou iii) au moins un substituant choisi parmi R₂₂ et R₂₃ est autre que l'hydrogène, Y₂₃ est *-N(R₂₅)-*', et R₂₅ est un groupe aryle C₆-C₆₀ substitué, dans lequel le groupe donneur d'électrons est éventuellement un substituant choisi parmi un groupe isopropyle, un groupe tert-butyle et des groupes représentés par les formules 10-1 à 10-61 : 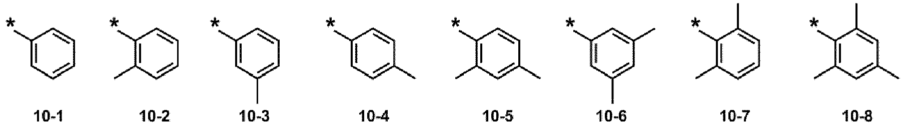 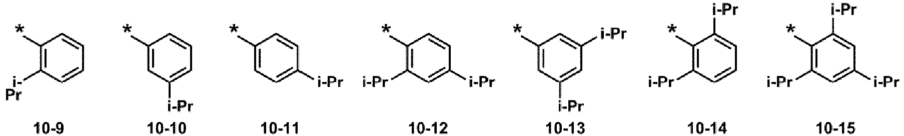 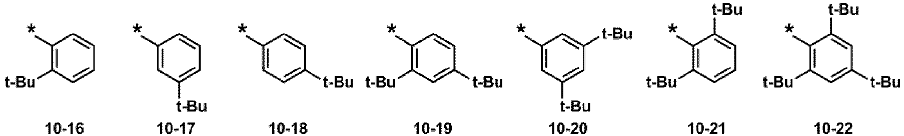 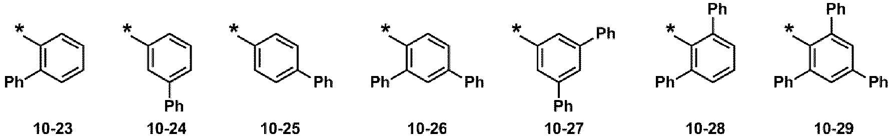 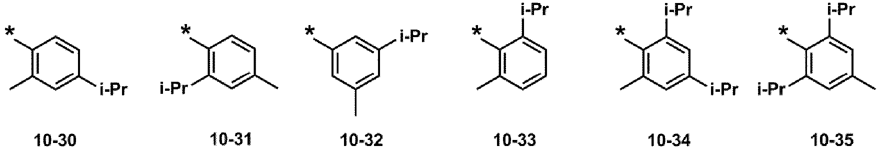 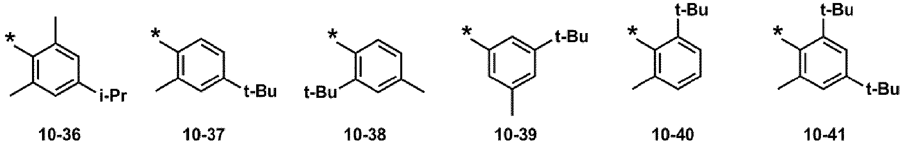 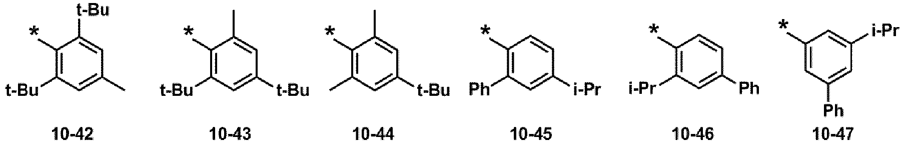 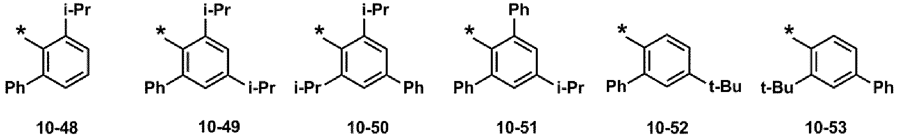 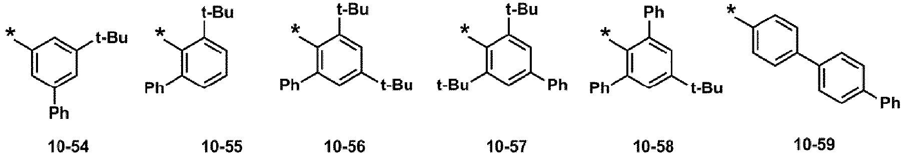 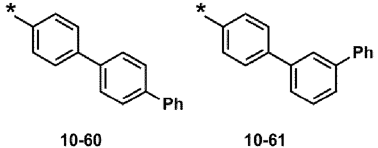
dans lequel, dans les formules 10-1 à 10-61,
« i-Pr » représente un groupe isopropyle, « t-Bu » représente un groupe tert-butyle,
« Ph » représente un groupe phényle, et
* indique un site de liaison avec un atome adjacent.

11. Dispositif électroluminescent organique (10) selon la revendication 9 ou la revendication 10, dans lequel le troisième composé est un composé organométallique représenté par la formule 2-1A ou la formule 2-1B, et
le quatrième composé est un composé organométallique représenté par la formule 2-2A : 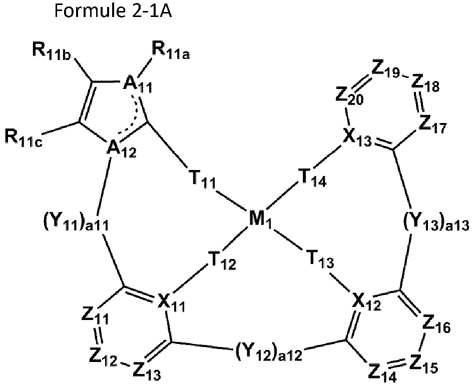 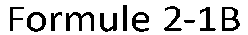 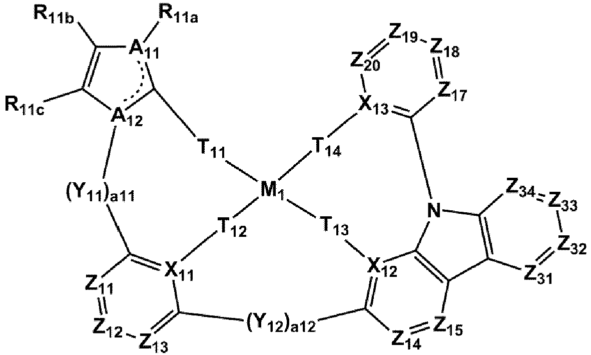 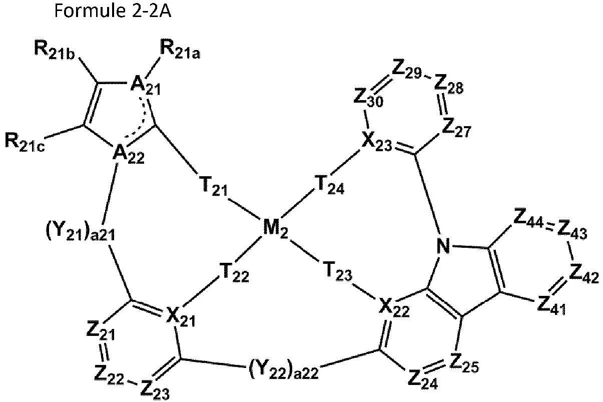
dans lequel, dans les formules 2-1A, 2-1B et 2-2A,
Z₁₁ est C(R₁₂ₐ) ou N, Z₁₂ est C(R_{12b}) ou N, Z₁₃ est C(R_{12c}) ou N, Z₁₄ est C(R₁₃ₐ) ou N, Z₁₅ est C(R_{13b}) ou N, Z₁₆ est C(R_{13c}) ou N, Z₁₇ est C(R₁₄ₐ) ou N, Z₁₈ est C(R_{14b}) ou N, Z₁₉ est C(R_{14c}) ou N, Z₂₀ est C(R_{14d}) ou N, Z₃₁ est C(R₁₅ₐ) ou N, Z₃₂ est C(R_{15b}) ou N, Z₃₃ est C(R_{15c}) ou N, et Z₃₄ est C(R_{15d}) ou N,
Z₂₁ est C(R₂₂ₐ) ou N, Z₂₂ est C(R_{22b}) ou N, Z₂₃ est C(R_{22c}) ou N, Z₂₄ est C(R₂₃ₐ) ou N, Z₂₅ est C(R_{23b}) ou N, Z₂₇ est C(R₂₄ₐ) ou N, Z₂₈ est C(R_{24b}) ou N, Z₂₉ est C(R_{24c}) ou N, Z₃₀ est C(R_{24d}) ou N, Z₄₁ est C(R₂₅ₐ) ou N, Z₄₂ est C(R_{25b}) ou N, Z₄₃ est C(R_{25c}) ou N, et Z₄₄ est C(R_{25d}) ou N,
R₁₂ₐ à R_{12c} sont chacun compris en se référant à la description de R₁₂ dans la formule 2-1,
R₁₃ₐ à R_{13c} sont chacun compris en se référant à la description de R₁₃ dans la formule 2-1,
R₁₄ₐ à R_{14d} sont chacun compris en se référant à la description de R₁₄ dans la formule 2-1,
R₁₃ₐ à R_{15d} sont chacun compris en se référant à la description de R₁₅ dans la formule 2-1,
R₂₂ₐ à R_{22c} sont chacun compris en se référant à la description de R₂₂ dans la formule 2-2,
R₂₃ₐ à R_{23c} sont chacun compris en se référant à la description de R₂₃ dans la formule 2-2,
R₂₄ₐ à R_{24d} sont chacun compris en se référant à la description de R₂₄ dans la formule 2-2,
R₂₅ₐ à R_{25d} sont chacun compris en se référant à la description de R₂₅ dans la formule 2-2, et
M₁, M₂, A₁₁, A₁₂, A₂₁, A₂₂, X₁₁ à X₁₃, X₂₁ à X₂₃, Y₁₁ à Y₁₃, Y₂₁ à Y₂₃, a11 à a13, a21 à a23, T₁₁ à T₁₄, T₂₁ à T₂₄, R₁₁ₐ à R_{11c}, et R₂₁ₐ à R_{21c} sont respectivement compris en se référant aux descriptions de M₁, M₂, A₁₁, A₁₂, A₂₁, A₂₂, X₁₁ à X₁₃, X₂₁à X₂₃, Y₁₁ à Y₁₃, Y₂₁ à Y₂₃, a11 à a13, a21 à a23, T₁₁ à T₁₄, T₂₁ à T₂₄, R₁₁ₐ à R_{11c}, et R₂₁ₐ à R_{21c} dans les Formules 2-1 et 2-2.

12. Dispositif électroluminescent organique selon l'une quelconque des revendications 1 à 11, dans lequel :
(i) la teneur totale du troisième composé et du quatrième composé est de l'ordre de 1 pour cent en volume (%vol) jusqu'à 50 % en volume, basé sur le volume total du premier composé et du deuxième composé dans la couche d'émission ; et/ou
(ii) le dispositif électroluminescent organique comprend en outre une couche de recouvrement (220) sur la deuxième électrode (190),
dans lequel la couche de recouvrement (220) présente un indice de réfraction de 1,6 ou plus à une longueur d'onde de 589 nanomètres (nm).

13. Dispositif électroluminescent organique (10) selon l'une quelconque des revendications 1 à 12, dans lequel la couche d'émission comprend une troisième couche d'émission,
la deuxième couche d'émission se situe entre la première électrode (110) et la troisième couche d'émission,
la troisième couche d'émission comprend le premier composé, le deuxième composé et un troisième dopant,
le premier dopant et le troisième dopant sont chacun sélectionnés parmi le troisième composé et le quatrième composé, et
le deuxième dopant est différent du premier et du troisième dopant, et le troisième dopant est l'autre composé sélectionné parmi le troisième et le quatrième composé.

14. Appareil électronique comprenant : un transistor à couche mince comprenant une électrode source, une électrode drain et une couche active ; et dispositif électroluminescent organique (10) selon l'une quelconque des revendications 1 à 13, dans lequel la première électrode (110) du dispositif électroluminescent organique (10) est couplée électriquement à l'une quelconque des électrodes sélectionnées parmi l'électrode source et l'électrode drain du transistor à couche mince.
